# EUROPÄISCHE PATENTANMELDUNG

(11) **EP 4 804 352 A2**
(43) Veröffentlichungstag der Anmeldung: **09.09.2026**
(21) Anmeldenummer: 26186151.2
(22) Anmeldetag: 16.02.2023
(51) Int. Cl.: H01S 5/42

(54) **MODUL ZUR ABGABE ELEKTROMAGNETISCHER STRAHLUNG, INSBESONDERE LASERLICHTMODUL**

(30) Priorität: 16.02.2022 DE 102022103693; 21.04.2022 DE 102022109681; 11.07.2022 DE 102022117262; 10.01.2023 DE 102023100436
(62) Dokumentnummer(n) der früheren Anmeldung(en) nach Art. 76 EPÜ: 23705546.2 / 4 479 769
(71) Anmelder: Elmos Semiconductor SE, 51379 Leverkusen (DE)
(72) Erfinder: FINKELDEY, Fabian, 44227 Dortmund (DE); DAGENBACH, Lucas, 44227 Dortmund (DE)
(74) Vertreter: dompatent

(57) **Zusammenfassung**

Der Vorschlag betrifft ein Lichtmodul mit einem VCSEL-Laser-Array-Die (VCSELA) zur Aussendung von Laser-Pulsen für LIDAR Anwendungen, wobei die parasitären Induktivitäten durch eine besondere Aufbau- und Verbindungstechnik gering sind und so eine hohe Schaltgeschwindigkeit erreicht wird. Das VCSEL-Laser-Array-Die (VCSELA) und ein Kondensator-Array (CAP) sind hierfür in einer Stacked-Die-Anordnung auf einem Träger montiert.

## Beschreibung

Die vorliegende PCT-Anmeldung nimmt die Prioritäten der nationalen deutschen Patentanmeldungen 10 2022 103 693.6 vom 16. Februar 2022, 10 2022 109 681.5 vom 21. April 2022, 10 2022 117 262.7 vom 11. Juli 2022 und 10 2023 100 436.0 vom 10. Januar 2023 in Anspruch, deren Inhalte hiermit durch Bezugnahme zum Gegenstand der vorliegenden Anmeldung gehören.

### Gebiet der Erfindung

Die Erfindung betrifft ein Modul zur Abgabe elektromagnetischer Strahlung, insbesondere Laserlichtmodul, insbesondere für LIDAR-Anwendungen, mit VCSEL-Lasern in einem VCSEL-Laser-Array und mit geringen parasitären Induktivitäten und kompakter Bauweise.

### Allgemeine Einleitung

Aus der WO-A-2021/140160 sind ein Lichtmodul und eine LIDAR-Vorrichtung für die Verwendung in automobilen Anwendungen bekannt. Die technische Lehre der WO-A-2021/140160 beschreibt ein Lasermodul mit einem Kondensator-Array und einem anreihbaren Treiber-IC, die eine Mehrzahl von Lasern für ein Lidar-System ansteuern. Die dabei mit Vorteil vorgesehenen Laser emittieren Licht an der Stirnseite der Kristalle der Laserdioden (Kantenemitter) des Lichtmoduls. Hierdurch ist die Emissionsfläche der dort vorgeschlagenen Laser in der Vertikalen in der Größenordnung der PN-Sperrschichtdicke, was zu einer Aufweitung des Laser-Strahls in der Vertikalen.

Im Stand der Technik sind jedoch VCSEL-Laser (Oberflächenemitter bzw. vertical cavity surface) verfügbar, die über die Kristalloberfläche der VCSEL-Laser-Dies VCSELA, also mit einem Pointing-Vektor senkrecht zur Oberseite des VCSEL-Laser-Dies VCSELA Licht emittieren (im Gegensatz zu Kantenemittern).

Daher entstand der Wunsch nach einer zur technischen Lehre der WO-A-2021/140160 äquivalenten technischen Lösung zu suchen, die die Vorteile der technischen Lehre der WO-A-2021/140160 bietet und gleichzeitig die Nutzung der Vorteile der Verwendung von VCSEL-Lasern ermöglicht. Dies ist jedoch nicht ohne weiteres möglich.

Aus der US-A-2020/0326425 ist beispielsweise ein Festkörper-LIDAR-Sender mit einer matrixadressierbaren Laser-Treiberschaltung bekannt. Das VCSEl-Array der Vorrichtung nach US-A-2020/0326425 umfasst einen ersten Bus, der ein erstes Spannungspotenzial an Spalten der matrixadressierbaren Laser-Treiberschaltung liefert, und einen zweiten Bus, der ein zweites Spannungspotenzial an Zeilen der matrixadressierbaren Laser-Treiberschaltung liefert. Eine Vielzahl von Spaltenschaltern verbindet bei der bekannten Vorrichtung die Vielzahl von Spalten mit dem ersten Bus. Ferner verbindet eine Vielzahl von Zeilenschaltern die Vielzahl von Zeilen mit dem zweiten elektrischen Bus. Der Sender der Vorrichtung der US-A-2020/0326425 enthält eine Vielzahl von in Reihe geschalteten Dioden, die eine Laserdiode in Reihe mit einer anderen Diode umfassen, wobei eine jeweilige Diode aus der Vielzahl der in Reihe geschalteten Dioden elektrisch zwischen einer jeweiligen Spalte und Zeile der matrixadressierbaren Lasertreiberschaltung angeschlossen ist, um den LIDAR-Sender zu bilden. Mindestens einige der zweiten Dioden erhöhen in der Vorrichtung der US-A-2020/0326425 die Gesamt-Sperrdurchbruchspannung der in Reihe geschalteten Dioden.

Ein Nachteil des VCSELA-Arrays der US-A-2020/0326425 ist, dass über eine Zeile von VCSELA-Lasern ein Spannungsabfall auftritt.

DE-A-10 2018 106 860 beschreibt ein Laserdiodenmodul, das ein erstes Halbleiter-Die, welches einen elektronischen Schalter enthält, und ein zweites Halbleiter-Die, welches eine Laserdiode enthält, aufweist. Das zweite Halbleiter-Die ist unter Verwendung einer Chip-auf-Chip-Verbindungstechnologie auf das erste Halbleiter-Die gebondet, um eine elektrische Verbindung zwischen dem elektronischen Schalter und der Laserdiode bereitzustellen.

Aus EP-B-2 002 519 ist eine Schaltungsanordnung zum Erzeugen schneller Laserimpulse mit einer Leiterplatte bekannt, wobei ein Halbleiterchip mit einem integrierten Lasertreiber zum Schalten einer Laserdiode montiert ist, die auf dem Halbleiterchip angeordnet und mit diesem elektrisch verbunden ist. Diese bekannte Vorrichtung umfasst des Weiteren einen an der Leiterplatte montierten Kondensator, der elektrisch mit dem Halbleiterchip verbunden ist. Der Kondensator der Vorrichtung der EP-B-2 002 519 gibt beim Schalten der Laserdiode zusätzliche Energie an den Lasertreiber ab und ist an einer Seite der Leiterplatte angeordnet, wobei der Halbleiterchip und die Laserdiode an einer anderen Seite der Leiterplatte angeordnet sind. Die Leiterplatte weist Leiterbahnen auf, die an der einen Seite der Leiterplatte mit dem wenigstens einen Kondensator und an der anderen Seite über Lötkugeln oder elektrisch leitfähige, vorzugsweise kugelförmige Elemente mit dem Halbleiterchip der in EP-B-2 002 519 beschriebenen Vorrichtung und der auf dem Halbleiterchip angeordneten Laserdiode verbunden sind.

Aus US-A-2020/0278426 ist ein Beleuchtungsmodul für 3D-Sensoranwendungen bekannt. Das Beleuchtungsmodul nach US-A-2020/0278426 umfasst eine Anordnung von oberflächenemittierenden Lasern mit vertikaler Kavität (VCSELs), die Licht emittieren, einen Treiber, der so konfiguriert ist, dass er die Anordnung von VCSELs mit Strom versorgt, und ein optisches Element, das so konfiguriert ist, dass es das von der Anordnung von VCSELs emittierte Licht empfängt und ein Lichtmuster vom Beleuchtungsmodul ausgibt.

Aus DE-T-11 2020 001 131 ist eine optische Komponente für ein LIDAR-Sensorsystem bekannt. Die optische Komponente gemäß DE-T-11 2020 001 131 umfasst eine erste Fotodiode, die ein LIDAR-Sensorpixel in einer ersten Halbleiterstruktur implementiert und so konfiguriert ist, dass sie empfangenes Licht in einem ersten Wellenlängenbereich absorbiert, eine zweite Fotodiode (5120), die ein Kamerasensorpixel in einer zweiten Halbleiterstruktur über der ersten Halbleiterstruktur implementiert und so konfiguriert ist, dass sie empfangenes Licht in einem zweiten Wellenlängenbereich absorbiert, und eine Verbindungsschicht, die eine elektrisch leitende Struktur enthält, die so konfiguriert ist, dass sie die zweite Fotodiode gemäß DE-T-11 2020 001 131 elektrisch kontaktiert. Das empfangene Licht des zweiten Wellenlängenbereichs weist gemäß der technischen Lehre der DE-T-11 2020 001 131 eine kürzere Wellenlänge als das empfangene Licht des ersten Wellenlängenbereichs auf.

Bei einem VCSEL-Laser-Die VCSELA mit einem VCSEL Array mit n Laserdioden sind die 2xn Laser-Kontaktflächen (Englisch Bond-Pads) LA1 bis LAn und RA1 bis RAn zum elektrischen Anschluss der mehreren (z.B. n) Reihen von n Laserdioden typischerweise mit einem Minimalabstand PTLa von beispielhaft ca. 50µm zueinander angeordnet. Jede Reihe von Laserdioden oder mehrere benachbarte Reihen von Laserdioden bildet dabei einen VCSEL-Laser L1 bis Ln, der nach Art eines Streifens ausgebildet ist. Der Minimalabstand der VCSEL-Laser L1 bis Ln untereinander wird im Folgenden als Laser-Die-Pitch PTLa bezeichnet. Die Laser L1 bis Ln sind auf dem VCSEL-Laser-Die VCSELA, bezogen auf ihre Aufeinanderfolge, typischerweise mit diesem Laser-Die-Pitch angeordnet. Das VCSEL-Laser-Die VCSELA kann beispielsweise eine Größe von 5mm x 5mm und 10 bis 100 oder mehr VCSEL-Laser L1 bis Ln aufweisen, die bevorzugt streifenförmig ausgebildet sind und jeweils von links nach rechts oder von oben nach unten mehrere VCSEL-Laserdioden auf dem VCSEL-Laser-Die VCSELA nebeneinander aufweisen.

Die Laser-Kontaktflächen LA1 bis LAn und RA1 bis RAn der elektrischen Kontakte auf dem VCSEL-Laser-Die VCSELA sind sämtlich auf der Oberseite des VCSEL-Laser-Dies VCSELA angeordnet. Die Laserdioden strahlen bei Versorgung mit elektrischer Energie ihr Licht senkrecht zu dieser Oberseite des VCSEL-Laser-Dies VCSELA ab.

Das VCSEL-Laser-Die VCSELA besitzt eine der Oberseite gegenüberliegende Unterseite. Das beispielhafte VCSEL-Laser-Die VCSELA weist bevorzugt einen gemeinsamen elektrischen Kathodenkontakt C für die Kathode sämtlicher Laser des VCSEL-Laser-Dies VCSELA auf. Dieser Kathodenkontakt C ist mit einer gemeinsamen elektrischen Kathodenelektrode C eines Schaltungsträgers PCB elektrisch und thermisch verbunden und befindet sich auf der Unterseite des VCSEL-Laser-Dies VCSELA. Für die weitere Beschreibung sei angenommen, dass das VCSEL-Laser-Die VCSELA n VCSEL-Laser L1 bis Ln umfasst.

Wie aus WO-A-2021/140160 bekannt, weist die hier vorgestellte Vorrichtung ein Kondensator-Array CAP auf. Das Kondensator-Array CAP speichert die elektrische Energie für die pulsförmige Energieversorgung der Laser. Bevorzugt ist das Kondensator-Array CAP monolithisch ausgeführt. Eine einzelne, beispielhafte diskrete Kapazität hätte demgegenüber einem Platzbedarf (Englisch Pitch) von 300µm x 300µm.

Damit stellt sich das Problem, dass zwischen dem 300µm Pitch der Kapazitäten des Kapazitätsarrays CAP und dem 50µm Pitch der Laser-Kontaktflächen LA1 bis LAn und RA1 bis RAn der Anschlüsse der VCSEL-Laser ein extremer Größenunterschied besteht. Das VCSEL-Laser-Die VCSELA ist typischerweise auch größer als eine Mehrzahl von Lasern, die über die Seitenfläche abstrahlen, wie es in WO-A-2021/140160 beschrieben ist.

Hinsichtlich der Ansteuerung sei auf die technische Lehre der WO-A-2021/140160 verwiesen, deren technischer Inhalt vollumfänglich zum Gegenstand der vorliegenden Anmeldung gehört.

### Aufgabe

Die Erfindung stellt sich die Aufgabe, einen Aufbau einer VCSEL-Laser-Ansteuerung eines VCSEL-Arrays mit wertemäßig möglichst kleinen parasitären Induktivitäten anzugeben.

Gemäß einer ersten Variante der Erfindung schlägt diese ein Modul zur Abgabe elektromagnetischer Strahlung, insbesondere Laserlichtmodul, vor, das versehen ist mit
- einem VCSEL-Laser-Array-Die VCSELA, das eine Vielzahl von streifenförmig und zueinander parallel verlaufenden VCSEL-Lasern L1 bis Ln mit jeweils in einer Reihe oder in mehreren parallelen Reihen angeordneten VCSEL-Laserdioden mit jeweils einer Anode und einer Kathode aufweist,
- wobei jeder VCSEL-Laser L1 bis Ln an beiden in Längserstreckung seines Streifens liegenden Streifenenden eine erste Laser-Kontaktfläche LA1 bis LAn und eine zweite Laser-Kontaktfläche RA1 bis RAn aufweist, mit denen die Anoden sämtlicher VCSEL-Laserdioden des betreffenden VCSEL-Lasers L1 bis Ln elektrisch verbunden sind,
- einem Kondensator-Array CAP, das ein elektrisch isolierendes Substrat SUB aufweist, auf dessen Oberseite sich parallel zueinander verlaufende Aufeinanderfolgen von ersten Kondensator-Kontaktflächen LCA1 bis LCAn und von zweiten Kondensator-Kontaktflächen RCA1 bis RCAn befinden,
- wobei das Kondensator-Array CAP eine 2D-Anordnung von Kondensatoren C1 bis Cn aufweist, die den VCSEL-Lasern L1 bis Ln jeweils als Energiespeicher zugeordnet sind,
- wobei die Kondensatoren C1 bis Cn des Kondensator-Arrays CAP obere Kondensatorelektroden te, die sämtlich in 2D-Anordnung innerhalb des Substrats SUB ausgebildet sind, und eine sämtlichen Kondensatoren C1 bis Cn gemeinsame, mit Abstand zu den oberen Kondensatorelektroden te angeordnete untere Kondensatorelektrode be aufweist,
- wobei jede obere Kondensatorelektrode te einer Zeile oder einer Spalte von Kondensatoren C1 bis Cn des Kondensator-Arrays CAP mittels in dem Substrat SUB ausgebildeter, parallel zueinander angeordneter und oberhalb der oberen Kondensatorelektroden te verlaufender Anschlussleitungen ICL elektrisch sowohl mit den ersten Kondensator-Kontaktflächen LCA1 bis LCAn als auch mit den zweiten Kondensator-Kontaktflächen RCA1 bis RCAn verbunden ist,
- wobei jede Anschlussleitung ICL mittels einer innerhalb des Substrats SUB des Kondensator-Arrays CAP ausgebildeten Durchkontaktierung DK an die obere Kondensatorelektrode te des betreffenden Kondensators C1 bis Cn und mittels zweier weiterer innerhalb des Substrats SUB des Kondensator-Arrays CAP ausgebildeter Durchkontaktierungen DK an die betreffende erste Kondensator-Kontaktfläche LCA1 bis LCAn und an die betreffende zweite Kondensator-Kontaktfläche RCA1 bis RCAn angeschlossen ist und
- wobei die ersten Laser-Kontaktflächen LA1 bis LAn der VCSEL-Laser L1 bis Ln des VCSEL-Laser-Array-Dies VCSELA sowie die ersten Kondensator-Kontaktflächen LAC1 bis LACn des Kondensator-Arrays CAP einerseits und die zweiten Laser-Kontaktflächen RA1 bis RAn der VCSEL-Laser L1 bis Ln des VCSEL-Laser-Array-Dies VCSELA sowie die zweiten Kondensator-Kontaktflächen RAC1 bis RACn des Kondensator-Arrays CAP andererseits jeweils in Verlängerung der Erstreckung der streifenförmigen VCSEL-Laser L1 bis Ln miteinander fluchtend und benachbart nebeneinander liegen und jeweils untereinander die gleichen Mittenabstände und gegebenenfalls zusätzlich in Richtung ihrer jeweiligen Aufeinanderfolgen gleiche Abmessungen aufweisen, und
- im Wesentlichen gleich langen Bonddrähte, die jeweils eine der ersten Laser-Kontaktflächen LA1 bis LAn der VCSEL-Laser L1 bis Ln des VCSEL-Laser-Array-Dies VCSELA mit dem jeweils benachbarten ersten Kondensator-Kontaktfeld LAC1 bis LACn des Kondensator-Arrays CAP und jeweils eine der zweiten Laser-Kontaktflächen RA1 bis RAn der VCSEL-Laser L1 bis Ln des VCSEL-Laser-Array-Dies VCSELA mit dem jeweils benachbarten zweiten Kondensator-Kontaktfeld RAC1 bis RACn des Kondensator-Arrays CAP elektrisch verbinden.

Nach der Erfindung gemäß dieser ersten Variante ist also vorgesehen, die Kondensatoren, die für jeden VCSEL-Laser die für dessen Pulsbetrieb benötigte Ladung speichern, unterhalb des VCSEL-Laser-Array-Dies anzuordnen. Die Anordnung dieser Kondensatoren C1 bis Cn erfolgt in 2D-Arrayform mit in Spalten und Zeilen, also matrixförmig, angeordneten oberen Elektroden te und einer allen Kondensatoren gemeinsamen unteren Elektrode be. Die VCSEL-Laserstreifen liegen Streifen an Streifen in zueinander paralleler Ausrichtung neben- bzw. untereinander. Jedem dieser VCSEL-Laserstreifen ist ein Kondensator zugeordnet, der sich unterhalb des betreffenden VCSEL-Laserstreifens befindet. Die Abmessungen der oberen Kondensatorelektroden te sind zweckmäßigerweise an die Anzahl von oberhalb der oberen Kondensatorelektroden te angeordneten VCSEL-Laserstreifen angepasst. Beispielsweise fluchtet eine Gruppe von m VCSEL-Laserstreifen mit einer Reihe von m Kondensatoren unterhalb dieser Gruppe von m VCSEL-Laserstreifen. Die Reihe von Kondensatoren weist dann m Kondensatoren auf. Jeder dieser m Kondensatoren ist nun über eine von ebenfalls m Anschlussleitungen mit den ersten und zweiten Kondensator-Kontaktfeldern elektrisch verbunden. Die Fläche, die für diese ersten und zweiten Kondensator-Kontaktfelder in der Dimension der Aufeinanderfolge von VCSEL-Laserstreifen benötigt wird, stimmt damit überein mit der Erstreckung des Bereichs, den die ersten und zweiten Kontaktflächen der VCSEL-Laserstreifen wiederum in der Dimension der Aufeinanderfolge von VCSEL-Laserstreifen benötigen. Somit fluchten also die ersten und zweiten Kontaktflächen der VCSEL-Laser L1 bis Ln mit den ersten und zweiten Kondensator-Kontaktfeldern des Kondensator-Arrays CAP. Die ersten Laser-Kontaktflächen LA1 bis LAn der VCSEL-Laser L1 bis Ln liegen somit auf einer Höhe neben den ersten Kondensator-Kontaktflächen LAC1 bis LACn, was entsprechend auch für die zweiten Laser-Kontaktflächen RA1 bis Ran und die zweiten Kondensator-Kontaktflächen RAC1 bis RACn gilt. Damit wiederum ist es möglich, dass die Bonddrähte, die die jeweiligen Paare von ersten und zweiten Kontaktflächen des VCSEL-Laser-Arrays-Dies VCSELA und des Kondensator-Arrays CAP miteinander verbinden, sehr kurz und gleich lang sind. Das wiederum hat Vorteile hinsichtlich einer Reduzierung und Symmetrierung von parasitären Induktivitäten, die durch die mehr oder weniger freiliegenden Bonddrähte erzeugt werden. Außerdem ist es von Vorteil, wenn die einzelnen VCSEL-Laserstreifen von zwei Seiten bestromt werden. Der Ladestrom wird demnach hälftig von beiden Enden in einen Laserstreifen eingespeist, womit sich die entstehenden elektromagnetischen Felder bei Betrachtung im Abstand zum Modul aufheben.

Die Laserkontaktflächen des VCSEL-Laser-Array-Dies VCSELA sind typischerweise frei zugänglich an dessen Oberseite ausgebildet. Sie können bei der Montage in üblicher Weise mit Bonddrähten kontaktiert werden, die die Verbindung der Kondensator-Kontaktflächen LCA1 bis LCan und RCA1 bis RCAn zu den Lasern L1 bis Ln herstellen. Die Strahlung kann über diese Oberseite des VCSEL-Laser-Array-Dies VCSELA emittiert werden. Bei Ausgestaltung der Montage in Flip-Chip-Technologie können statt der Bonddrähte Lötkugeln verwendet werden, wobei dann vorgesehen ist, dass die Strahlung über die Unterseite des VCSEL-Laser-Array-Dies VCSELA emittiert wird.

Auf die Flip-Chip-Montagetechnologie wird im Zusammenhang mit der zweiten Variante der Erfindung weiter unten noch eingegangen werden.

Das erfindungsgemäß Modul gemäß der ersten Variante zeichnet sich durch eine hohe Kompaktheit und Bauteildichte aus, was den gegenüber Kantenemitter-Laserdioden größeren Flächenbedarf von Oberflächenemitter-Dioden (VCSEL-Laserdioden) kompensiert. Die Effektivität von VCSEL-Laserdioden ist höher als von Kantenemitter-Laserdioden, weshalb insoweit VCSEL-Laserdioden die Dioden der Wahl sind.

In zweckmäßiger Weiterbildung der Erfindung ist vorgesehen, dass die oberen Kondensatorelektroden te der Kondensatoren C1 bis Cn des Kondensator-Arrays CAP innerhalb einer ersten Metalllage M1 des Substrats SUB, die Anschlussleitungen ICL in einer oberhalb der ersten Metalllage M1 angeordneten zweiten Metalllage M2 des Substrats SUB und die ersten Kondensator-Kontaktfelder LAC1 bis LACn sowie die zweiten Kondensator-Kontaktfelder RAC1 bis RACn in einer oberhalb der zweiten Metalllage M2 angeordneten dritten Metalllage M3 des Substrats (SUB) ausgebildet sind.

In weiterer vorteilhafter Ausgestaltung der Erfindung kann vorgesehen sein, dass die sämtlichen Kondensatoren C1 bis Cn gemeinsame untere Kondensatorelektrode be in einer unterhalb der ersten Metalllage M1 angeordneten weiteren Metalllage des Substrats (SUB) des Kondensator-Arrays CAP angeordnet ist.

Typischerweise ist das VCSEL-Laser-Array-Die VCSELA mit einer unterseitigen Kathodenkontaktfläche KKF versehen, mit der die Kathoden der VCSEL-Laserdioden sämtlicher VCSEL-Laser L1 bis Ln elektrisch verbunden sind, und dass das Kondensator-Array CAP auf seiner Oberseite zwischen den beiden Aufeinanderfolgen von ersten Kondensator-Kontaktflächen LCA1 bis LCAn und von zweiten Kondensator-Kontaktflächen RCA1 bis RCAn eine Kathodenelektrode C für den Kontakt zur unterseitigen Kathoden-Kontaktfläche KKF des VCSEL-Laser-Array Dies VCSELA aufweist.

Die zuvor genannte Kathodenelektrode C des Kathoden-Arrays CAP ist vorteilhafterweise in der dritten Metalllage M3 angeordnet, und zwar vorzugsweise zwischen den Kondensator-Kontaktflächen LCA1 bis LCAn.

Das erfindungsgemäße Modul gemäß der ersten Variante kann ferner vorteilhafterweise versehen sein mit einer Steuerschaltung IC und einer elektronische Entladestruktur T_{DIS} zum Entladen von in einem der Kondensatoren C1 bis Cn gespeicherten Ladung zur Abgabe eines Strahlungspulses durch den dem zu entladenden Kondensator C1 bis Cn zugeordneten VCSEL-Laser L1 bis Ln, wobei die Entladestruktur T_{DIS} mit der Kathodenkontaktfläche KKF verbunden und nach Masse geschaltet sowie von der Steuerschaltung IC leitend oder sperrend schaltbar ist. Die Entladestruktur ist zweckmäßigerweise als "aufgeteilter" Entladetransistor ausgebildet, der eine Vielzahl von einzeln nebeneinanderliegenden Entladetransistorzellen aufweist, die jeweils einen eigenen Gate-Treiber und dergleichen weitere Schaltungskomponenten, die zum Betreiben eines Transistors erforderlich sind, aufweisen.

Das erfindungsgemäße Modul gemäß der ersten Variante kann ferner vorteilhafterweise versehen sein mit einer Ladeschaltung SUPL zum Aufladen der Kondensatoren C1 bis Cn des Kondensator-Arrays CAP, die eine Anordnung von von der Steuerschaltung IC steuerbaren elektronischen Schaltern S1 bis Sn zum selektiven Aufladen eines einzelnen der Kondensatoren C1 bis Cn oder einiger weniger der Kondensatoren C1 bis Cn des Kondensator-Arrays CAP aufweist.

Ferner kann das erfindungsgemäße Modul gemäß der ersten Variante versehen sein mit einem Träger, auf dem oder an dem das Kondensator-Array CAP mit auf diesem befindlichen VCSEL-Laser-Array-Die VCSELA und gegebenenfalls die Steuerschaltung IC sowie die Entladestruktur T_{DIS} und/oder die Ladeschaltung SUPL angeordnet ist bzw. sind.

In vorteilhafter Ausgestaltung der Erfindung kann vorgesehen sein, dass der Träger einen Kühlkörper HS oder eine Platine PCB mit oder ohne Kühlkörper HS aufweist.

Gemäß einer zweiten Variante der Erfindung ist zur Lösung der oben genannten Aufgabe ein Modul zur Abgabe elektromagnetischer Strahlung, insbesondere Laserlichtmodul, vorgesehen, das versehen ist mit
- einem VCSEL-Laser-Array-Die VCSELA, das eine Vielzahl von streifenförmig und zueinander parallel verlaufenden VCSEL-Lasern L1 bis Ln mit jeweils in einer Reihe oder in mehreren parallelen Reihen angeordneten VCSEL-Laserdioden mit jeweils einer Anode und einer Kathode aufweist,
- wobei jeder VCSEL-Laser L1 bis Ln an beiden in Längserstreckung seines Streifens liegenden Streifenenden eine erste Laser-Kontaktfläche LA1 bis LAn und eine zweite Laser-Kontaktfläche RA1 bis RAn aufweist, mit denen die Anoden sämtlicher VCSEL-Laserdioden des betreffenden VCSEL-Lasers L1 bis Ln elektrisch verbunden sind,
- einem Kondensator-Array CAP, das ein elektrisch isolierendes Substrat SUB aufweist, auf dessen Oberseite sich parallel zueinander ausgerichtete Aufeinanderfolgen von ersten Kondensator-Kontaktflächen LCA1 bis LCAn und von zweiten Kondensator-Kontaktflächen RCA1 bis RCAn befinden,
- wobei das Kondensator-Array CAP eine 2D-Anordnung von Kondensatoren C1 bis Cn aufweist, die den VCSEL-Lasern L1 bis Ln jeweils als Energiespeicher zugeordnet sind,
- wobei die Kondensatoren C1 bis Cn des Kondensator-Arrays CAP obere Kondensatorelektroden te, die sämtlich in 2D-Anordnung innerhalb des Substrats SUB ausgebildet sind, und eine sämtlichen Kondensatoren C1 bis Cn gemeinsame, mit Abstand zu den oberen Kondensatorelektroden te angeordnete untere Kondensatorelektrode be aufweist,
- wobei jede obere Kondensatorelektrode te einer Zeile oder einer Spalte von Kondensatoren C1 bis Cn des Kondensator-Arrays CAP mittels in dem Substrat SUB ausgebildeter, parallel zueinander angeordneter und oberhalb der oberen Kondensatorelektroden te verlaufender Anschlussleitungen ICL elektrisch sowohl mit den ersten Kondensator-Kontaktflächen LCA1 bis LCAn als auch mit den zweiten Kondensator-Kontaktflächen RCA1 bis RCAn verbunden ist,
- wobei jede Anschlussleitung ICL mittels einer innerhalb des Substrats SUB des Kondensator-Arrays CAP ausgebildeten Durchkontaktierung DK an die obere Kondensatorelektrode te des betreffenden Kondensators C1 bis Cn und mittels jeweils zweier weiterer innerhalb des Substrats SUB des Kondensator-Arrays CAP ausgebildeter Durchkontaktierungen DK an die betreffende erste Kondensator-Kontaktfläche LCA1 bis LCAn und an die betreffende zweite Kondensator-Kontaktfläche RCA1 bis RCAn angeschlossen ist,
- wobei die ersten Laser-Kontaktflächen LA1 bis LAn der VCSEL-Laser L1 bis Ln des VCSEL-Laser-Array-Dies VCSELA sowie die ersten Kondensator-Kontaktflächen LAC1 bis LACn des Kondensator-Arrays CAP einerseits und die zweiten Laser-Kontaktflächen RA1 bis RAn der VCSEL-Laser L1 bis Ln des VCSEL-Laser-Array-Dies VCSELA sowie die zweiten Kondensator-Kontaktflächen RAC1 bis RACn des Kondensator-Arrays CAP andererseits jeweils untereinander im Wesentlichen die gleichen Mittenabstände aufweisen und gegebenenfalls zusätzlich, in Richtung ihrer jeweiligen Aufeinanderfolgen betrachtet, die gleichen Abmessungen aufweisen und
- wobei das VCSEL-Laser-Array-Die VCSELA mit den Laser-Kontaktflächen LA1 bis LAn, RA1 bis Ran seiner VCSEL-Laser L1 bis Ln den Kondensator-Kontaktfeldern LAC1 bis LACn, RAC1 bis RACn des Kondensator-Arrays CAP zugewandt ausgerichtet ist, und
- Lötkugeln SB zur elektrischen Verbindung jeweils der ersten Laser-Kontaktfläche LA1 bis LAn eines jeden VCSEL-Lasers L1 bis Ln des VCSEL-Laser-Array-Dies VCSELA mit dem mit einer der oberen Kondensatorelektroden te verbundenen ersten Kondensator-Kontaktfläche LAC1 bis LACn des Kondensator-Arrays CAP und jeweils der zweiten Laser-Kontaktfläche RAC1 bis RACn des betreffenden VCSEL-Lasers L1 bis Ln des VCSEL-Laser-Array-Dies (VCSELA) mit dem mit der betreffenden oberen Kondensatorelektrode te verbundenen zweiten Kondensator-Kontaktfläche RAC1 bis RACn des Kondensator-Arrays CAP.

Diese Variante der Erfindung dient der Möglichkeit der Flip-Chip-Montage des Die-Stacks aus Kondensator-Array und VCSEL-Laser-Array-Die, das nun mit seiner die Laser-Kontaktflächen LA1 bis LAn und RA1 bis RAn aufweisenden Oberseite von oben auf der Oberseite des Kondensator-Arrays mit dessen Kondensator-Kontaktfläche LAC1 bis LACn und RAC1 bis RACn aufgesetzt ist. Die Verbindung zwischen den jeweiligen Paaren aus Laser- und Kondensator-Kontaktflächen erfolgt bei dieser Variante durch Lötkugeln. Die Unterseite des VCSEL-Laser-Array-Dies VCSELA dient als Strahlungsemissionsseite.

Für den typischerweise anzutreffenden Fall, dass das VCSEL-Laser-Array-Die VCSELA eine unterseitige Kathodenkontaktfläche KKF aufweist, mit der die Kathoden der VCSEL-Laserdioden sämtlicher VCSEL-Laser L1 bis Ln elektrisch verbunden sind, weist das VCSEL-Laser-Array-Die VCSELA an der seiner Unterseite abgewandten Oberseite die Laser-Kontaktflächen LA1 bis LAn, RA1 bis RAn auf, wobei das VCSEL-Laser-Array-Die VCSELA über seine Unterseite Strahlung emittiert und wobei seine Kathodenkontaktfläche entweder nur in einem Bereich der Unterseite des VCSEL-Laser-Array-Dies VCSELA ausgebildet ist, in dem keine Strahlung austritt, und/oder für die elektromagnetische Strahlung transparent ist. Mit Unterseite und Oberseite des VCSEL-Laser-Array-Dies VCSELA gemäß dieser Beschreibung ist die Situation bei Ausrichtung des VCSEL-Laser-Array-Dies VCSELA vor der Flip-Chip-Montage gemeint.

In vorteilhafter Ausgestaltung der Erfindung ist vorgesehen, dass die oberen Kondensatorelektroden te der Kondensatoren C1 bis Cn des Kondensator-Arrays CAP innerhalb einer ersten Metalllage M1 des Substrats SUB, die Anschlussleitungen ICL in einer oberhalb der ersten Metalllage M1 angeordneten zweiten Metalllage M2 des Substrats SUB und die ersten Kondensator-Kontaktfelder LAC1 bis LACn sowie die zweiten Kondensator-Kontaktfelder RAC1 bis RACn in einer oberhalb der zweiten Metalllage M2 angeordneten dritten Metalllage M3 des Substrats SUB ausgebildet sind.

In weiterer vorteilhafter Ausgestaltung der Erfindung ist vorgesehen, dass die sämtlichen Kondensatoren C1 bis Cn gemeinsame untere Kondensatorelektrode be in einer unterhalb der ersten Metalllage M1 angeordneten weiteren Metalllage des Substrats (SUB) des Kondensator-Arrays CAP angeordnet ist.

Das erfindungsgemäße Modul gemäß der zweiten Variante kann vorteilhafterweise versehen sein mit einer Steuerschaltung IC und einer elektronische Entladestruktur T_{DIS} zum Entladen von in einem der Kondensatoren C1 bis Cn gespeicherten Ladung zur Abgabe eines Strahlungspulses durch den dem zu entladenden Kondensator C1 bis Cn zugeordneten VCSEL-Laser L1 bis Ln, wobei die Entladestruktur T_{DIS} mit der Kathodenkontaktfläche KKF verbunden und nach Masse geschaltet sowie von der Steuerschaltung IC leitend oder sperrend schaltbar ist.

Das erfindungsgemäße Modul gemäß der zweiten Variante kann ferner vorteilhafterweise versehen sein mit einer Ladeschaltung SUPL zum Aufladen der Kondensatoren C1 bis Cn des Kondensator-Arrays CAP, die eine Anordnung von von der Steuerschaltung IC steuerbaren elektronischen Schaltern S1 bis Sn zum selektiven Aufladen eines einzelnen der oder einiger weniger der Kondensatoren C1 bis Cn des Kondensator-Arrays CAP aufweist.

Das erfindungsgemäße Modul gemäß der zweiten Variante kann ferner vorteilhafterweise versehen sein mit einem Träger, auf dem oder an dem das Kondensator-Array CAP mit auf diesem befindlichen VCSEL-Laser-Array-Die VCSELA und gegebenenfalls die Steuerschaltung IC sowie die Entladestruktur T_{DIS} und/oder die Ladeschaltung SUPL angeordnet ist bzw. sind.

Gemäß einer vorteilhaften Ausgestaltung der Erfindung kann vorgesehen sein, dass der Träger einen Kühlkörper HS oder eine Platine PCB mit oder ohne Kühlkörper HS aufweist.

Gemäß einer dritten Variante der Erfindung wird die oben genannte Aufgabe gelöst durch ein Modul zur Abgabe elektromagnetischer Strahlung, insbesondere Laserlichtmodul, das versehen ist mit
- einem VCSEL-Laser-Array-Die VCSELA, das eine Vielzahl von streifenförmig und zueinander parallel verlaufenden VCSEL-Lasern L1 bis Ln mit jeweils in einer Reihe oder in mehreren parallelen Reihen angeordneten VCSEL-Laserdioden mit jeweils einer Anode und einer Kathode aufweist, wobei jede Reihe eine vorgegebene Breite quer zur Längserstreckung des VCSEL-Lasers L1 bis Ln aufweist,
- wobei jeder VCSEL-Laser L1 bis Ln an einem seiner in Längserstreckung seines Streifens liegenden Streifenenden eine Laser-Kontaktfläche VBP1 bis VBPn aufweist, mit denen die Anoden sämtlicher VCSEL-Laserdioden des betreffenden VCSEL-Lasers L1 bis Ln elektrisch verbunden sind, und
- wobei die Laser-Kontaktflächen VBP1 bis VBPn in Richtung der Aufeinanderfolge der VCSEL-Laser L1 bis Ln untereinander einen Mittenabstand aufweisen,
- einem ersten Energiespeichermodul C_{L} mit einer Vielzahl von in Richtung der Aufeinanderfolge der VCSEL-Laser L1 bis Ln des VCSEL-Laser-Array-Dies VCSELA nebeneinander angeordneten Kondensatoren C1 bis Cn, die untereinander einen Mittenabstand aufweisen, der gleich dem Mittenabstand der Laser-Kontaktfläche VBP1 bis VBPn ist und
- Bonddrähten zur elektrischen Verbindung jeweils einer Laser-Kontaktfläche VBP1 bis VBPn und eines Kondensators C1 bis Cn.

Bei dieser Variante der Erfindung befindet sich neben dem VCSEL-Laser-Array-Die VCSELA mindestens ein Energiespeichermodul C_{L}, C_{R} mit mehreren längs einer Reihe bzw. geraden Linie angeordneten Kondensatoren C1 bis Cn. Diese Kondensatoren weisen in Richtung ihrer Aufeinanderfolge jeweils eine vorgegebene Abmessung bzw. einen Mittenabstand auf. Neben jedem der Kondensatoren C1 bis Cn befindet sich nun einer der streifenförmigen VCSEL-Laser. Um nun die Erstreckung eines jeden Kondensators in Richtung der Aneinanderreihung der Kondensatoren C1 bis Cn mit Laserdioden "auszufüllen", ist nach dieser dritten Variante der Erfindung vorgesehen, dass jeder streifenförmige VCSEL-Laser L1 bis Ln mehrere zueinander parallele und aneinanderliegende Reihen von Laserdioden aufweist. Dabei umfasst jede Reihe von Laserdioden so viele Laserdioden, dass die Gesamtheit sämtlicher Laserdioden eines streifenförmigen VCSEL-Lasers im Pulsbetrieb mit ausreichender Energie durch den zugeordneten Kondensator versorgt werden kann.

Die Konzeption gemäß dritter Variante der Erfindung sieht also vor, dass der Mittenabstand der Kondensatoren des mindestens einen Energiespeichermoduls gleich dem Mittenabstand der streifenförmigen VCSEL-Laser ist. Auch damit kann eine kompakte Bauweise realisiert werden mit dem entscheidenden Vorteil, dass die Bonddrahtverbindungen zwischen den Kontaktflächen des Energiespeichermoduls für dessen Kondensatoren mit den Laserkontaktflächen im Wesentlichen gleich lang sind.

Entsprechend dem zuvor genannten Konzept ist die Anzahl der Reihen von VCSEL-Laserdioden, die durch dieselbe Laser-Kontaktfläche VBP1 bis VBPn kontaktiert sind, typischerweise definiert entweder als der ganzzahlige Teil des Ergebnisses der Division aus dem Mittenabstand der Laser-Kontaktflächen VBP1 bis VBPn und der Breite einer Reihe von VCSEL-Laserdioden oder als der ganzzahlige Teil des Ergebnisses der Division aus der in Richtung der Aufeinanderfolge der Laser-Kontaktflächen VBP1 bis VBPn betrachteten Erstreckung einer Laser-Kontaktfläche VBP1 bis VBPn und der Breite einer Reihe von VCSEL-Laserdioden.

In vorteilhafter Ausgestaltung der Erfindung kann vorgesehen sein, dass die Laser-Kontaktflächen VBP1 bis VBPn sämtlicher VCSEL-Laser L1 bis Ln nebeneinander und somit an dem gleichen Ende der Streifen der VCSEL-Laser L1 bis Ln liegen.

Bei dem zuvor genannten Ausführungsbeispiel der dritten Variante der Erfindung sind die Kondensatoren C1 bis Cn in einer Reihe liegend aufeinanderfolgend angeordnet.

Alternativ zum zuvor Gesagten kann vorgesehen sein, dass die Kondensatoren C1 bis Cn in zwei Reihen mit jeweils gleichen Mittenabständen angeordnet sind, wobei die Kondensatoren C1 bis Cn der einen Reihe um den halben Mittenabstand versetzt neben den Kondensatoren C1 bis Cn der anderen Reihe angeordnet sind, und dass die Mittenabstände der Kondensatoren gleich dem doppelten Mittenabstand der Laser-Kontaktflächen VBP1 bis VBPn ist.

Durch die Anordnung zweier nebeneinanderliegender Reihen von aufeinanderfolgenden Kondensatoren, die versetzt zueinander angeordnet sind (auf Lücke zueinander liegen), kann der erforderliche Bauraum für größere Kondensatoren genutzt werden.

In alternativer Ausgestaltung kann vorgesehen sein, dass die Laser-Kontaktflächen VBP1 bis VBPn benachbarter VCSEL-Laser L1 bis Ln wechselweise einander gegenüberliegen und dass dem ersten Energiespeichermodul C_{L} gegenüberliegend ein zweites Energiespeichermodul C_{R} mit ebenfalls einer Vielzahl von Kondensatoren C1 bis Cn angeordnet ist, wobei sich das VCSEL-Laser-Array-Die VCSELA zwischen den beiden Energiespeichermodulen befindet.

Auch bei dieser Ausgestaltung der Erfindung kann mit Vorteil vorgesehen sein, dass die Kondensatoren C1 bis Cn beider Energiespeichermodule jeweils in einer Reihe aufeinanderfolgend angeordnet sind und dass der Mittenabstand der Kondensatoren C1 bis Cn gleich dem doppelten Mittenabstand der wechselweise aufeinanderfolgenden Laser-Kontaktflächen VBP1 bis VBPn ist. Auch hier kann der Bauraum mit größerflächigeren Kondensatoren versehen werden, was zur Folge hat, dass die Zuleitungen (Bonddrähte) von den Kondensatoren zu den einzelnen VCSEL-Lasern L1 bis Ln zwei verschiedene Längen aufweisen.

In weiterer alternativer Ausgestaltung dieser Variante der Erfindung ist vorgesehen, dass die Kondensatoren C1 bis Cn beider Energiespeichermodule C_{L}, C_{R})jeweils in zwei Reihen mit gleichem Mittenabstand angeordnet sind, wobei die Kondensatoren C1 bis Cn der einen Reihe um den halben Mittenabstand versetzt neben den Kondensatoren C1 bis Cn der anderen Reihe angeordnet sind, und dass der Mittenabstand der Kondensatoren C1 bis Cn gleich dem Vierfachen des Mittenabstands der wechselweise aufeinanderfolgenden Laser-Kontaktflächen VBP1 bis VBPn ist. Bei dieser Ausgestaltung der Erfindung kann der Bauraum für maximal große Kondensatoren genutzt werden, mit der Folge, dass die Zuleitungen (Bonddrähte) von den Kondensatoren zu den einzelnen VCSEL-Lasern L1 bis Ln zwei verschiedene Längen aufweisen.

Das erfindungsgemäße Modul gemäß der dritten Variante kann ferner vorteilhafterweise versehen sein mit
- einem IC-Die IC mit einer integrierten Schaltung zur Ansteuerung der VCSEL-Laser L1 bis Ln des VCSEL-Laser-Array-Dies VCSELA und zum Aufladen sowie Entladen der Kondensatoren C1 bis Cn des ersten Energiespeichermoduls C_{L},
- wobei das erste Energiespeichermodul C_{L} als ein Kondensator-Modul ausgebildet ist und
- wobei das VCSEL-Laser-Array-Die VCSELA und das Kondensator-Modul auf dem IC-Die IC angeordnet sind.

In vorteilhafter Ausgestaltung der Erfindung kann vorgesehen sein, dass das IC-Die IC eine integrierte Entladestruktur Tdis aufweist, wobei das VCSEL-Laser-Array-Die VCSELA eine unterseitige Kathodenkontaktfläche aufweist, mit der die Kathoden der VCSEL-Laserdioden sämtlicher VCSEL-Laser L1 bis Ln elektrisch verbunden sind und die die Entladestruktur Tdis des IC-Dies IC elektrisch kontaktiert.

In weiterer vorteilhafter Ausgestaltung der Erfindung kann vorgesehen sein, dass bei Vorhandensein des zweiten Energiespeichermoduls C_{R} auch dieses auf dem IC-Die IC angeordnet ist.

In vorteilhafter Ausgestaltung der Erfindung kann ferner vorgesehen sein, dass das IC-Die IC eine Ladeschaltung zum Aufladen der Kondensatoren des ersten Energiespeichermoduls C_{L} oder jedes Energiespeichermoduls C_{L}, C_{R} mit einem Verbindungsknoten zu dem ersten Energiespeichermodul C_{L} oder mit Verbindungsknoten zu jedem der Energiespeichermodule C_{L}, C_{R} aufweist, dass das erste Energiespeichermodul C_{L} oder jedes Energiespeichermodul C_{L}, C_{R} eine unterseitige, sämtlichen Kondensatoren C1 bis Cn des betreffenden Energiespeichermoduls C_{L}, C_{R} gemeinsame untere Kondensatorelektrode sowie einzelne voneinander getrennte obere Kondensatorelektroden aufweist und dass die unterseitige bzw. die unterseitigen gemeinsamen Kondensatorelektroden einen Knoten der Aufladeschaltung des IC-Dies IC kontaktiert bzw. kontaktieren.

In weiterer vorteilhafter Ausgestaltung der Erfindung kann vorgesehen sein, dass das IC-Die IC den Kondensatoren C1 bis Cn des ersten Energiespeichermoduls C_{L} oder jedes Energiespeichermoduls C_{L}, C_{R} zugeordnete Kontaktflächen aufweist, die mittels Bonddrähten elektrisch mit den oberen Elektroden der Kondensatoren C1 bis Cn des betreffenden Energiespeichermoduls C_{L}, C_{R} zugeordneten Kontaktflächen verbunden sind, und dass diese Kontaktflächen der Kondensatoren C1 bis Cn des betreffenden Energiespeichermoduls C_{L}, C_{R} ihrerseits mittels weiterer Bonddrähte mit den Laser-Kontaktflächen VBP1 bis VBPn der jeweiligen ihnen zugeordneten VCSEL-Laser L1 bis Ln des VCSEL-Laser-Array-Dies VCSELA verbunden sind.

Die Erfindung wird nachfolgend anhand mehrerer Ausführungsbeispiele und unter Bezugnahme auf die Zeichnung erläutert:
- Fig. 1: zeigt eine mögliche, sub-optimale Anordnung.
- Fig. 2: zeigt die dem erfindungsgemäßen Lichtmodul zugrundeliegende Verschaltung.
- Fig. 3: zeigt das Grundprinzip der schaltungstechnischen Anordnung und des Hardware-Aufbaus eines ersten Ausführungsbeispiels in der Aufsicht.
- Fig. 4: zeigt eine Schnittansicht durch die Konstruktion der Fig. 3.
- Fig. 5: verdeutlicht die EMV-Optimierung und die Induktivitätsminimierung durch antiparallele Entladeströme.
- Fig. 6: entspricht der Fig. 3 mit einer Leiterplatine.
- Fig. 7: zeigt die Massefläche GNDP statt auf einer gedruckten Schaltung PCB an einem Kühlkörper HS vorzusehen.
- Fig. 8: zeigt die Massefläche GNDP statt auf einer gedruckten Schaltung PCB an einem Kühlkörper HS vorzusehen und die gedruckte Schaltung PCB neben der Treiberschaltung IC auf dem Kühlkörper HS beispielsweise mit Schrauben SC elektrisch isoliert von dem Kühlkörper HS zu befestigen.
- Fig. 9: zeigt die Verwendung eines VCSEL-Laser-Array-Dies VCSELA mit Lichtemission, das über die Rückseite und elektrischer Verbindung zu dem Kondensator-Array CAP nicht mit Bonddrähten, wie in den Fign. 1 bis 8, sondern mittels Flip-Chip-Technik und damit Bondkugeln, was die Induktivitäten weiter senkt.
- Fig. 10: zeigt die Aufsicht auf das in Fig. 9 in Querschnittsansicht wiedergegebene Lasermodul.
- Fig. 11: zeigt schematisch eine beispielhafte Konstruktion eines Kondensator-Arrays CAP im Querschnitt, wie es für die beiden Ausführungsbeispiele genutzt wird.
- Fig. 12: zeigt einen beispielhaften, vereinfachten nicht maßstabsgerechten Querschnitt durch das Kondensator-Array CAP zur Verdeutlichung der verschiedenen Lagen der Verdrahtungsebenen des Kondensator-Arrays CAP.
- Fig. 13: zeigt eine erfindungsgemäße Vorrichtung VGV mit einer typischen Verschaltung einer LIDAR-Laser Anordnung einer oder mehrerer, beispielweise n zeilen- bzw. streifenförmige VCSEL-Laser L1 bis Ln, mit n als positiver ganzer Zahl größer 0.
- Fig. 14: zeigt eine im Stand der Technik übliche Anordnung von n VCSEL-Laserzeilen.
- Fig. 15: verdeutlicht ein weiteres Problem aus dem Stand der Technik, bei dem die VCSEL-Laserzeilen zur Verbesserung ihrer Anschlüsse nicht einseitig mit einem VCSEL-Bondpad, sondern mit zwei VCSEL-Bondpads angeschlossen werden.
- Fig. 16: verdeutlicht das Problem der unterschiedlichen Lichtpulsintensität und - steilheit am vereinfachten Beispiel der Einspeisung des Stromes zum Betrieb einer VCSEL-Laserzeile mit fünf VCSEL-Lasern.
- Fig. 17: stellt die Änderung des Stromes durch einen VCSEL-Laser in Abhängigkeit von dessen Entfernung von dem Stromeinspeisepunkt dar.
- Fig. 18: zeigt einen Teil des Lösungsvorschlags der Erfindung, bei dem der Pitch pc der Energiespeicher C1 bis Cn und der Pitch pd der VCSEL-Laserzeilen aufeinander abgestimmt sind.
- Fig. 19: stellt ein alternatives Prinzip der Anordnung verschiedener VCSEL-Laserzeilen und ihrer elektrischen Verbindung mit Energiespeichern dar.
- Fig. 20: stellt eine erfindungsgemäße Vorrichtung VGV dar, bei der sich in der Mitte zwischen den Energiespeichersubstraten mit den Energiespeichern das VCSEL-Array der n VCSEL-Laser L1 bis Ln befindet.
- Fig. 21: zeigt ein Gehäuse Ge für ein Modul der Fig. 20.
- Fig. 22: entspricht weitestgehend der Fig. 21 mit dem Unterschied, dass die Exposed Die-Pads der Bezugspotenzialleitung GNDP nun soweit vergrößert sind, als sie auch an den Längsseiten des Gehäuses einen Meniskus bei einer Lötung ausbilden können und daher nun besonders gut optisch inspizierbar sind.
- Fig. 23: zeigt das VCSEL-Laser-Modul der Fign. 20 bis 22, wobei nun dargestellt ist, wie der Entladeschalter Tdis (siehe Fig. 13) in mehrere parallel geschaltete Treiberzellen DRC1 bis DRCr mit diesen zugeordneten Bondpad-Anschlüsse DRP1 bis DRPr unterteilt ist, die miteinander parallel geschaltet sind.
- Fig. 24: zeigt eine beispielhafte Verschaltung der Treiberzellen DRC1 bis DRCr.
- Fig. 25: zeigt ein vereinfachtes und schematisches Blockschaltbild einer beispielhaften Treiber-Schaltung IC für eine erfindungsgemäße Vorrichtung VGV.

### Erster sub-optimaler Ansatz für eine nicht erfindungsgemäße Lösung

Die Kapazitäten LC1 bis LCn des linken Kondensator-Arrays CAPL müssen mit geringem Abstand zu den Laser-Kontaktflächen LA1 bis LAn der Anschlüsse der VCSEL-Laser L1 bis Ln des VCSEL-Laser-Array-Dies VCSELA platziert sein, während die Kapazitäten RC1 bis RCn des rechten Kondensator-Arrays CAPR mit geringem Abstand zu den Laser-Kontaktflächen RA1 bis RAn der Anschlüsse der VCSEL-Laser L1 bis Ln des VCSEL-Laser-Array-Dies VCSELA platziert sein müssen. Dies hat den Zweck, dass die Länge der Bondleitungen BdL1 bis BdLn und BdR1 bis BdRn minimiert ist. Die Bond-Drähte BdL1 bis BdLn und BdR1 bis BdRn verbinden dabei die Laser-Kontaktflächen LA1 bis LAn und RA1 bis RAn der Anschlüsse der VCSEL-Laser mit korrespondierenden Kontaktflächen LCA1 bis LCAn und RCA1 bis RCAn der Kapazitäten LC1 bis LCn und RC1 bis RCn des Kondensator-Arrays CAP. Die Rückseite des Kondensator-Arrays CAP weist bevorzugt einen Rückseitenkontakt auf, der einen gemeinsamen elektrischen Knoten darstellt, der bevorzugt den anderen elektrischen Kontakt sämtlicher Kapazitäten LC1 bis LCn und RC1 bis RCn des Kondensator-Arrays CAP bildet. Dies ermöglicht es, mit Vorteil mittels der VCSEL-Laser L1 bis Ln kurze Lichtpulse erzeugen zu können.

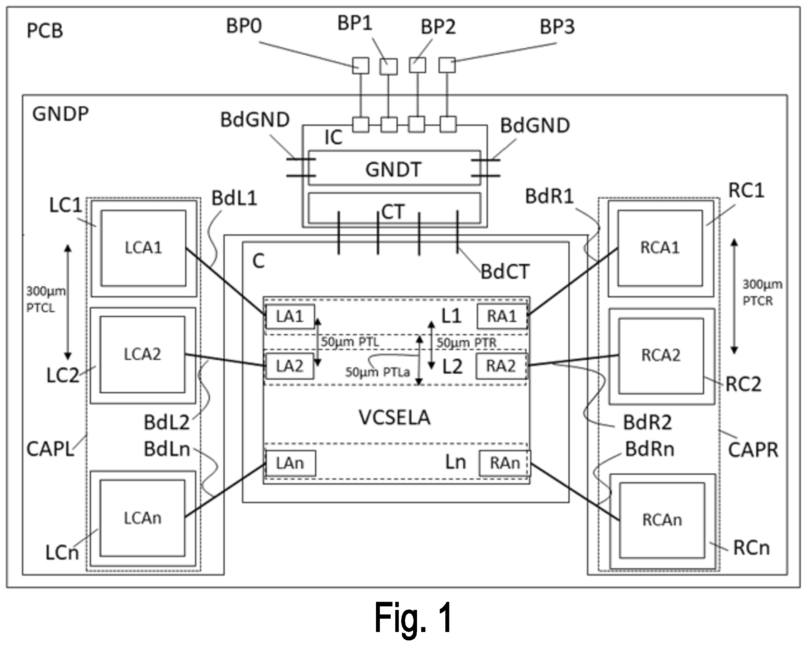

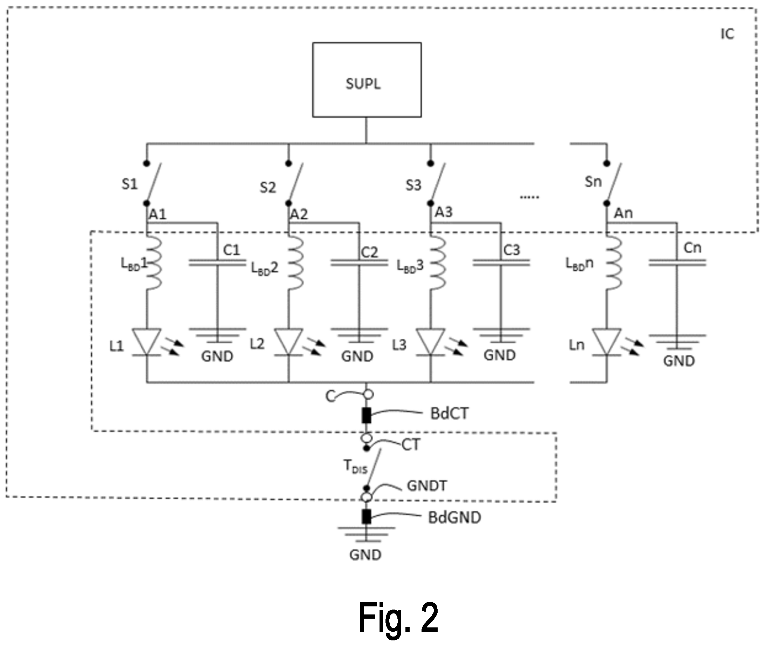

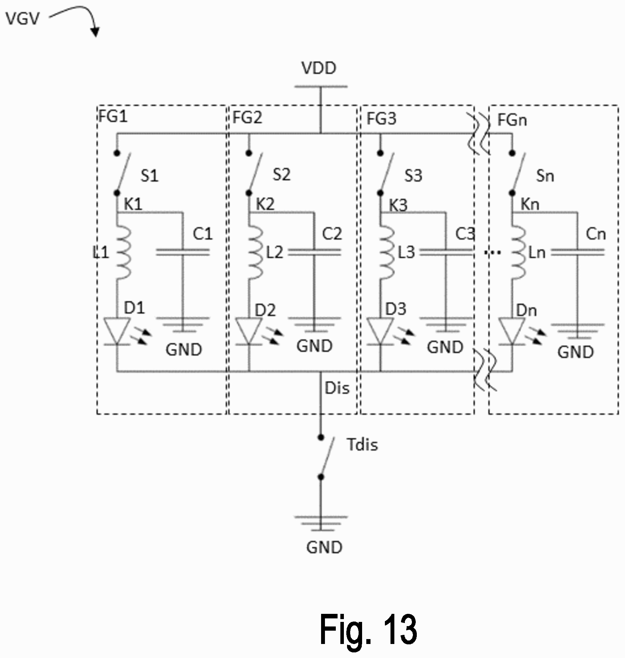

Das der Erfindung zu Grunde liegende Optimierungsproblem sei anhand der Fign. 1 und 2 erläutert. In diesem Zusammenhang sei auf die Fign. 13 bis 18 (linke Seite) mit zugehöriger Beschreibung verwiesen, in der die grundsätzlichen Probleme ebenfalls beschrieben und zeichnerisch verdeutlich sind.

Fig. 1 zeigt schematisch und vereinfacht eine noch nicht ganz optimale Anordnung einer Vorrichtung für ein Laser-Modul für ein LIDAR-System mit einem VCSEL-Laser-Die VCSELA in der Draufsicht, wobei im Folgenden auch Bezug genommen wird auf Fig. 2.

Das VCSEL-Laser-Die VCSELA ist mit einem Kathodenkontakt, der für sämtliche VCSEL-Laser L1 bis Ln elektrisch und thermisch leitend auf einer allen VCSEL-Lasern L1 bis Ln des VCSEL-Laser-Dies VCSELA gemeinsamen Kathodenelektrode C aufgebracht.

Jeder der VCSEL-Laser L1 bis Ln des VCSEL-Laser-Dies VCSELA ist an der linken Seite über einen seiner linken Laser-Kontaktfläche LA1 bis LAn mittels eines jeweiligen relativ langen Bonddrahts BdL1 bis BdLn mit dem jeweiligen Oberseitenkontakt LCA1 bis LCAn eines jeweiligen linken Kondensators LC1 bis LCn verbunden.

Jeder der VCSEL-Laser L1 bis Ln des VCSEL-Laser-Dies VCSELA ist an der rechten Seite über einen seiner rechten Kontaktflächen RA1 bis RAn mittels eines jeweiligen relativ langen Bonddrahts BdR1 bis BdRn mit dem jeweiligen Oberseitenkontakt RCA1 bis RCAn eines jeweiligen rechten Kondensators RC1 bis RCn verbunden.

Der Unterseitenkontakt jedes Kondensators LC1 bis LCn und RC1 bis RCn ist als zweiter elektrischer Kontakt dieser Kondensatoren LC1 bis LCn und RC1 bis RCn mit einer gemeinsamen Massefläche GNDP elektrisch und thermisch verbunden. Hierdurch sind die Unterseitenkontakte der Kondensatoren LC1 bis LCn und RC1 bis RCn zu einem Sternpunkt elektrisch zusammengeschaltet. Dieser Sternpunkt ist der Masseknoten GND.

Die Treiberschaltung IC ist auf die Massefläche GNDP ebenfalls aufgesetzt. Die Treiberschaltung IC umfasst den Entladetransistor T_{DIS}. (siehe Fig. 2), der einen ersten Anschluss GNDT aufweist, welcher mittels Down-Bond über Bonddrähte BdGND mit der Massefläche GNDP elektrisch verbunden ist. Der Treibertransistor T_{DIS} der Treiberschaltung IC (siehe Fig. 2) weist einen zweiten Anschluss CT auf, der über Bonddrähte BdCT mit der Kathodenelektrode C und damit mit dem Kathodenkontakt der VCSEL-Laser L1 bis Ln des VCSEL-Laser-Array-Dies VCSELA elektrisch verbunden ist. Typischerweise umfasst die Treiberschaltung IC auch die Ladeschaltung SUPL. Diese Ladeschaltung SUPL ist in Fig. 1 zur besseren Übersicht nicht eingezeichnet. Es sei im Übrigen nochmals verwiesen auf die technische Lehre der bereits erwähnten WO-A-2021/140160.

Gemäß Fig. 1 versorgen im Entladefall je zwei Kondensatoren, und zwar ein linker Kondensator LC1 bis LCn und ein rechter Kondensator RC1 bis RCn durch Einschalten des Entladetransistors T_{DIS} der Treiberschaltung IC, je einen Laser der VCSEL-Laser L1 bis Ln in Form eines Laser-Streifens des VCSEL-Laser-Array-Dies VCSELA mit elektrischer Energie. Welcher der Laser der VCSEL-Laser L1 bis Ln des VCSEL-Laser-Array-Dies VCSELA Licht abstrahlt, bestimmt der Ladezustand der dem betreffenden Laser zugeordneten Kondensatoren LC1 bis LCn und RC1 bis RCn zum Zeitpunkt des Schließens des Entladetransistors T_{DIS} der Treiberschaltung IC.

In dem Beispiel der Fig. 1 versorgt stets ein linker Kondensator LC1 bis LCn den betreffenden Laser von links her mit elektrischer Energie, während ein rechter Kondensator RC1 bis RCn betreffenden Laser von rechts her mit elektrischer Energie versorgt. Hierdurch verkürzt sich die Zeit zum Einschalten des jeweiligen Lasers.

Fig. 2 zeigt eine beispielhafte, zugehörige Verschaltung. Die Ladeschaltung SUPL versorgt die Schaltung mit einem Ladestrom. Die Ladeschaltung SUPL ist bevorzugt Teil der Treiberschaltung IC.

Jedem VCSEL-Laser L1 bis Ln ist ein Ladeschalter S1 bis Sn zugeordnet.

Die Treiberschaltung IC steuert auch die Ladeschalter S1 bis Sn an und schließt in einer zeitlich vorausgehenden Ladephase denjenigen Ladeschalter, dessen Laser der L1 bis Ln als nächstes einen Lichtpuls abstrahlen soll. Währenddessen ist der Entladeschalter T_{DIS} der Treiberschaltung IC typischerweise geöffnet. Die Ladeschaltung SUPL der Treiberschaltung IC lädt in dieser Ladephase den mit der Ladeschaltung SUPL elektrisch verbundenen Kondensator C1 bis C1 mit dem Ladestrom der Ladeschaltung SUPL. Die Kondensatoren C1 bis Cn sind dabei bezogen auf die Fig. 1 Parallelschaltungen aus jeweils einem der linken Kondensatoren LC1 bis LCn und einem der rechten Kondensatoren RC1 bis RCn. Zur Vereinfachung zeigt die Fig. 2 diese Paare aus jeweils einem linken Kondensator LC1 bis LCn und einem rechten Kondensator RC1 bis RCn als einen gemeinsamen Kondensator der Kondensatoren C1 bis C1. Diese Kondensatoren C1 bis C1 sind jeweils mit einem ersten Anschluss mit der gemeinsamen Masse GND verbunden. Die jeweiligen Kontaktflächen RCA1 bis RCAn und LCA1 bis LCAn der jeweiligen Kondensatoren LC1 bis LCn und RC1 bis RCn jedes Kondensatorpaars der Fig. 1 bilden den zweiten Anschluss des betreffenden Kondensators C1 bis C1 und die jeweiligen Knoten A1 bis An der Fig. 2. Nach dem Aufladen des Kondensators initiiert die Treiberschaltung IC die Entladung des Kondensators und damit die Lichtabgabe des betreffenden Lasers. Für die Entladung eines Kondensators C1 bis C1 wird der zugehörige Ladeschalter S1 bis Sn geöffnet, wenn er nach dem Laden des Kondensators noch geschlossen sein sollten. Wenn der Entladetransistor T_{DIS} geschlossen wird, entlädt sich der zuvor elektrisch geladene Kondensator C1 bis Cn über den Entladeschalter T_{DIS}, über und die parasitäre Bonddrahtinduktivität L_{BD}1 bis L_{BD}n aufweisenden Bonddrähte BdL1 bis BdLn und BdR1 bis BdRn, über den jeweiligen VCSEL-Laser L1 bis Ln und über den Kathodenkontakt C sowie über die Induktivitäten aufweisenden Bonddrähte BdCT und BdGND, womit der jeweilige VCSEL-Laser L1 bis Ln Laserstrahlung emittiert.

Der Stromtransport zwischen den jeweiligen Ladeschaltern S1 bis Sn für die jeweilige elektrische Vorladung eines jeweiligen, zugeordneten Kondensators der Kondensatoren C1 bis Cn aus der Ladeschaltung SUPL erfolgt in der Fig. 1 über einen jeweiligen, relativ langen Bonddraht, dessen Induktivität für die zeitliche Dynamik der Entladung des betreffenden jeweiligen Kondensators aber unerheblich ist. Dies ist somit an sich kein Problem. Im Gegenteil ist dies eher positiv, weil die hierdurch auftretende parasitäre Induktivität die Ladeschaltung SUPL dynamisch während der Pulserzeugung gut von der jeweils in Entladung begriffenen Kapazität der Kondensatoren C1 bis Cn isoliert.

Ein Problem sind bei dieser Lösung jedoch die relativ langen und zudem unterschiedlich langen sowie unterschiedlich geführten Bonddrähte BdL1 bis BdLn und BdR1 bis BdRn zwischen den Laser-Kontaktflächen LA1 bis LAn und RA1 bis RAn (nachfolgend auch als Anschlüsse bezeichnet) der VCSEL-Laser L1 bis Ln des VCSEL-Laser-Array-Dies VCSELA und den Kondensator-Kontaktflächen LCA1 bis LCAn und RCA1 bis RCAn der Kondensatoren C1 bis Cn, die zu einer massiven Verschlechterung der Eigenschaften des Lasermoduls führen, da deren parasitäre Induktivität sehr hoch.

### Verbesserte Lösung der Aufgabe

Der hier vorgestellte Lösungsvorschlag ist nun, ein gemeinsames Kondensator-Array CAP unter dem VCSEL-Laser-Array-Die VCSELA ein Kondensator-Array CAP zu platzieren, statt die Kondensatoren zu beiden Seiten des Lasers L1 bis Ln anzuordnen. Mit der Erfindung wird also eine Stacked-Die-Montage eines VCSEL-Laser-Array-Dies VCSELA mit einem Kondensator-Array CAP vorgeschlagen, das die einzelnen den Lasern zugeordneten Kondensatoren in Form eines 2D-Array aufweist.

Wie oben beschrieben, weist typischerweise das VCSEL-Laser-Array-Die VCSELA an seiner Oberfläche (Ober- oder Unterseite) zwei Reihen von Laser-Kontaktflächen LA1 bis LAn (nachfolgend auch mit Anschlüssen bezeichnet) auf. Senkrecht zu dieser Oberfläche des VCSEL-Laser-Array-Dies VCSELA strahlen die VCSEL-Laser L1 bis Ln des VCSEL-Laser-Array-Dies VCSELA ihre Lichtpulse ab.

Bevorzugt kontaktieren jeweils ein linker Anschluss der linken Reihe von Anschlüssen LA1 bis LAn und jeweils ein zugehöriger rechter Anschluss der rechten Reiche von Anschlüssen RA1 bis RAn den jeweiligen typischerweise genau einen internen Oberseitenkontakt genau eines jeweiligen diesen zugehörigen VCSEL-Lasers der VCSEL-Laser L1 bis Ln des VCSEL-Laser-Array-Dies VCSELA. Die VCSEL-Laser L1 bis Ln weisen bevorzugt einen gemeinsamen Unterseitenkontakt in Form der gemeinsamen Kathode auf die mit einer gemeinsamen Kathodenelektrode C elektrisch und bevorzugt thermisch verbunden ist.

Auf dem Kondensator-Array CAP ist elektrisch isoliert eine Metallisierungsfläche in der beispielsweise dritten Metallisierungsebene aufgebracht, die mit der der gemeinsamen Kathodenelektrode C elektrisch und thermisch verbunden ist und von den anderen elektrisch leitenden Teilen des Kondensator-Arrays CAP elektrisch getrennt (isoliert) ist aber nicht thermisch getrennt (isoliert) ist.

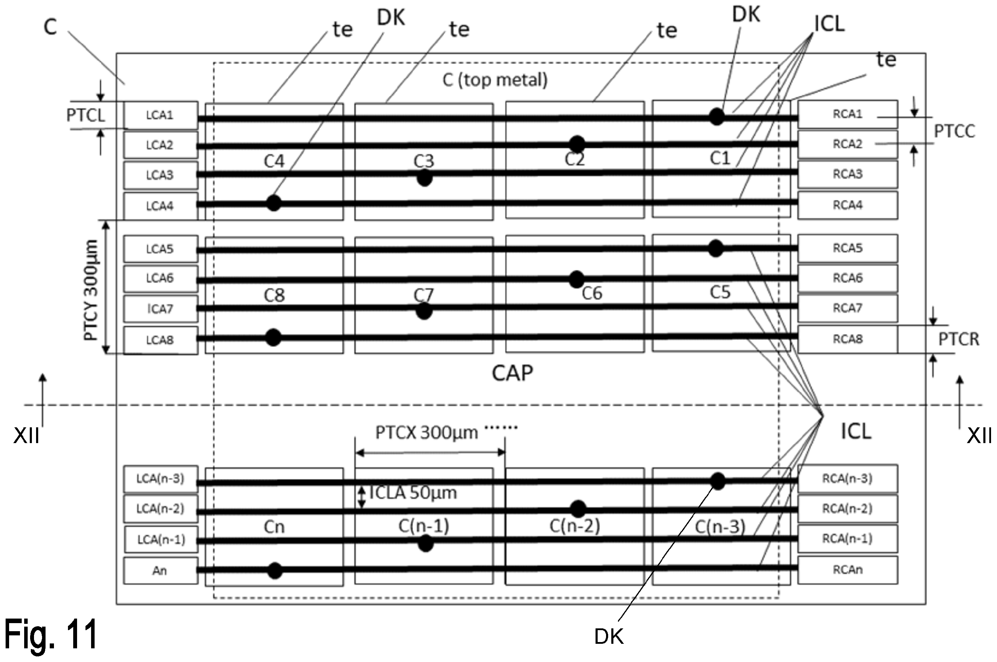

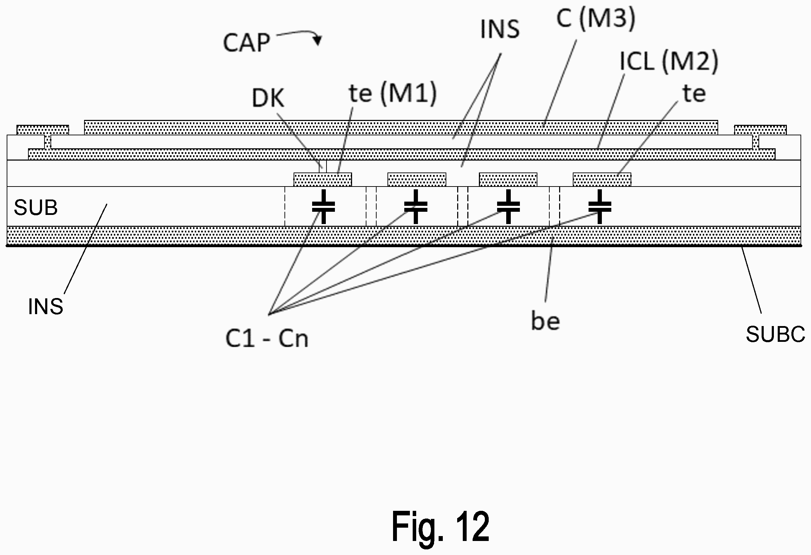

Auch das erfindungsgemäße in Fig. 11 und Fig. 12 gezeigte Kondensator-Array CAP weist eine (linke) Reihe linker Anschlüsse LCA1 bis LCAn und eine (rechte) Reihe rechter Anschlüsse RCA1 bis RACn auf. Die linken Anschlüsse LCA1 bis LCAn und die rechten Anschlüsse RCA1 bis RACn des Kondensator-Arrays CAP sind über elektrische Anschlussleitungen (Leiterbahnen) ICL in einer zweiten Metallisierungsebene auf der Oberseite des Kondensator-Arrays CAP miteinander elektrisch verbunden. Diese Anschlussleitungen ICL des Kondensator-Arrays CAP in der zweiten Metallisierungsebene des Kondensator-Arrays CAP liegen unter der dritten Metallisierungsebene des Kondensator-Arrays CAP. Die eigentlichen Kondensatorelektroden te der Kondensatoren C1 bis C1 des Kondensator-Arrays CAP sind in der ersten Metallisierungsebene des Kondensator-Arrays CAP unter der zweiten und dritten Metallisierungsebene des Kondensator-Arrays CAP angeordnet. Im Gegensatz zur zuvor beschriebenen sub-optimalen Ausführung ist nun je VCSEL-Laser L1 bis Ln nur genau ein Kondensator C1 bis Cn notwendig. Eine Aufspaltung der Kondensatoren C1 bis Cn in einen jeweiligen linken Kondensator und einen jeweiligen rechten Kondensator ist also nicht mehr notwendig. Durchkontaktierungen DK verbinden die Anschlussleitungen ICL des Kondensator-Arrays CAP selektiv mit den darunterliegenden Kondensatorelektroden te der Kondensatoren C1 bis Cn des Kondensator-Arrays CAP. Der Abstand ICLA der Anschlussleitungen ICL des Kondensator-Arrays CAP untereinander richtet sich erfindungsgemäß nach dem minimalen fünften Abstand PTLa der VCSEL-Laser L1 bis Ln im VCSEL-Laser-Array-Die VCSELA. Bevorzugt ist der Abstand ICLA der Ansteuerleitungen ICL des Kondensator-Arrays CAP untereinander gleich dem minimalen fünften Abstand PTLa der VCSEL-Laser L1 bis Ln im VCSEL-Laser-Array-Die VCSELA. Die Kondensatoren C1 bis Cn sind vorzugsweise in Gruppen in Zeilen und Spalten in dem Kondensator-Arrays CAP angeordnet. Mehrere Anschlussleitungen ICL des Kondensator-Arrays CAP liegen nun oberhalb einer Zeile von nebeneinanderliegenden Kondensatorelektroden te der Kondensatoren C1 bis Cn des Kondensator-Arrays CAP. Jeder der Kondensatoren einer Zeile des Kondensator-Arrays CAP ist mit genau einer Anschlussleitung ICL des Kondensator-Arrays CAP über eine Durchkontaktierung elektrisch verbunden. Daher liegen in einer Zeile des Kondensator-Arrays CAP genauso viele Kondensatoren des Kondensator-Arrays CAP nebeneinander, wie die Anzahl der Anschlussleitungen ICL ist, die über diese elektrisch isoliert von deren Kondensatorelektroden te hinwegführen. Genau eine dieser Anschlussleitungen ICL ist dabei immer mit der Kondensatorelektrode te des betreffenden Kondensators elektrisch mittels einer Durchkontaktierung verbunden. Hierdurch können zum Ersten der Pitch der Kondensatoren C1 bis Cn des Kondensator-Arrays CAP mit dem Pitch der VCSEL-Laser L1 bis Ln des VCSEL-Laser-Array-Dies VCSELA in Übereinstimmung gebracht werden. Zum Zweiten ermöglich dies eine symmetrische Einspeisung des Laser-Stromes I_{dis} aus den Kondensatoren C1 bis Cn in die VCSEL-Laser L1 bis Ln von links und rechts. Auch der Bauraum ist reduziert, indem sich wesentliche Teile des Kondensator-Arrays CAP unter dem VCSEL-Laser-Array-Die VCSELA befinden. Durch die unterschiedliche Stromrichtung des Kondensatorentladestromes I_{dis} kompensiert sich das magnetischer Fernfeld dieser Entladeströme in weiterer Entfernung im Wesentlichen und zwar sowohl horizontal als auch vertikal, was die EMV-Eigenschaften verbessert und die Induktivität senkt. Somit wird die Flankensteilheit der emittierten Laserpulse der emittierenden Laser der VCSEL-Laser L1 bis Ln verbessert.

Kurze Bonddrähte BdL1 bis BdLn verbinden die linken Anschlüsse LCA1 bis LCAn des Kondensator-Arrays CAP mit den linken Anschlüssen LA1 bis LAn des VCSEL-Laser-Array-Dies VCSELA.

Kurze Bonddrähte BdR1 bis BdRn verbinden die rechten Anschlüsse RCA1 bis RCAn des Kondensator-Arrays CAP mit den rechten Anschlüssen RA1 bis RAn des VCSEL-Laser-Array-Dies VCSELA.

Auf dem Kondensator-Array CAP ist eine Kathodenplatte in Form einer gemeinsamen Kathodenelektrode C als gemeinsame Kathode der VCSEL-Laser L1 bis Ln des VCSEL-Laser-Array-Dies VCSELA durch z.B. Metallisierung angeordnet. Die gemeinsame Kathodenelektrode C dient als Landefläche für die Bond-Bälle der Bondleitungen Bd vom zweiten Anschluss CT des Entladetransistors T_{DIS} der Treiberschaltung IC zur gemeinsamen Kathodenelektrode C und damit zur gemeinsamen Kathode der VCSEL-Laser L1 bis Ln des VCSEL-Laser-Array-Dies VCSELA.

Diese gemeinsame Kathodenelektrode C ist mittels mehrerer Bonddrähte Bd mit dem entsprechenden zweiten Anschluss C des Entladetransistors T_{DIS} der Treiberschaltung IC verbunden. Der zweite Anschluss der gemeinsamen Kathodenelektrode C ist der gemeinsame Sternpunkt des Schalttransistors T_{dis}.

Die Steuerleitungen der Treiberschaltung IC sind in einer Variante mit Anschlusspads BP0 bis BP4 einer gedruckten Schaltung PCB verbunden. Auf der gedruckten Schaltung befinden sich bevorzugt weitere Schaltungsteile und elektrische und elektronische Bauelemente. In den Figuren sind die Ladeschaltungen, wie z.B. bei der Vorrichtung nach WO-A-2021/140160 vorhanden, nicht gezeigt. Sie befinden sich in der Treiberschaltung IC oder bevorzugt in einer anderen Schaltung auf der gedruckten Schaltung PCB. Vorzugsweise sind die Kondensatoren C1 bis Cn des Kondensator-Arrays CAP über weitere Bonddrähte und ggf. Leitungen auf dem PCB mit ihren jeweiligen Ladeschaltungen auf dem PCB oder in der Treiberschaltung IC verbunden. Diese weiteren Bonddrähte sind typischerweise relativ lang und in den Figuren nicht gezeigt.

Des Weiteren schlägt die hier vorgestellte technische Lehre vor, den Rückseitenkontakt des Kondensator-Arrays CAP statt einer thermisch schlecht leitenden gedruckten Schaltung PCB mit einer thermisch und elektrisch leitenden Massefläche GNDP, z.B. aus Aluminium oder Kupfer zu verbinden. Ideal wäre mit Gold beschichtetes Kupfer als Material einer solchen Massefläche GNDP. Es kann sich beispielsweise um einen Kühlkörper HS (Englisch Heat-Sink) handeln.

Die gedruckte Schaltung PCB kann beispielsweise auch auf dem Kühlkörper HS befestigt werden. Bonddrähte Bd stellen bevorzugt die elektrischen Verbindungen zwischen der Treiberschaltung IC und der gedruckten Schaltung PCB her.

Das Kondensator-Array CAP umfasst bevorzugt bzw. zumindest die drei nachfolgend beschriebenen Metalllagen. In der ersten Metalllage M1 des Kondensator-Arrays CAP befinden sich die oberen Elektroden (Kondensatorelektroden te) der Kondensatoren C1 bis Cn des Kondensator-Arrays CAP angeordnet. Eine Isolationsschicht INS trennt die erste Metalllage M1 von der zweiten Metalllage M2 elektrisch. In der zweiten Metalllage M2 sind die Anschlussleitungen ICL der Kondensatoren C1 bis Cn des Kondensator-Arrays CAP gefertigt. Durchkontaktierungen DK durch die Isolationsschicht INS verbinden die Anschlussleitungen ICL in der zweiten Metalllage M2 mit den Kondensatorelektroden te in der ersten Metalllage M1 elektrisch. Das Kondensator-Array CAP umfasst des Weiteren ein Substrat SUB. Dieses Substrat SUB umfasst bevorzugt das Dielektrikum der Kondensatoren C1 bis Cn des Kondensator-Arrays CAP. Die Unterseite des Kondensator-Arrays CAP bildet ein Substratkontakt SUBC. Der Bereich zwischen einer Kondensatorelektrode te in der ersten Metalllage M1 und dem Substratkontakt SUBC bildet jeweils die (vertikale) Kapazität der Kompensatoren C1 bis Cn des Kondensator-Arrays CAP. Eine solche Kapazität ist somit jeweils eine vertikale Kapazität zwischen der ersten Metalllage M1 und dem sämtlichen Kondensatoren C1 bis Cn des Kondensator-Arrays CAP gemeinsamen Substratkontakt SUBC auf der Unterseite des Kondensator-Arrays CAP. Dieser Substratkontakt SUBC ist bevorzugt mit der Massefläche GNDP elektrisch verbunden. Auf der Rückseite sind die einen Elektroden (Platten) sämtlicher Kondensatoren C1 bis Cn des Kondensator-Arrays CAP somit kurzgeschlossen. Die jeweilige Kondensatorelektrode te der jeweiligen Kapazität ist also jeweils in der ersten Metalllage M1 gefertigt, während die querlaufenden Anschlussleitungen ICL in der zweiten Metalllage M2 gefertigt sind. Die gemeinsame Kathodenelektrode C des VCSEL-Laser-Array-Dies VCSELA ist ggf. bevorzugt in einer dritten Metalllage M3 gefertigt.

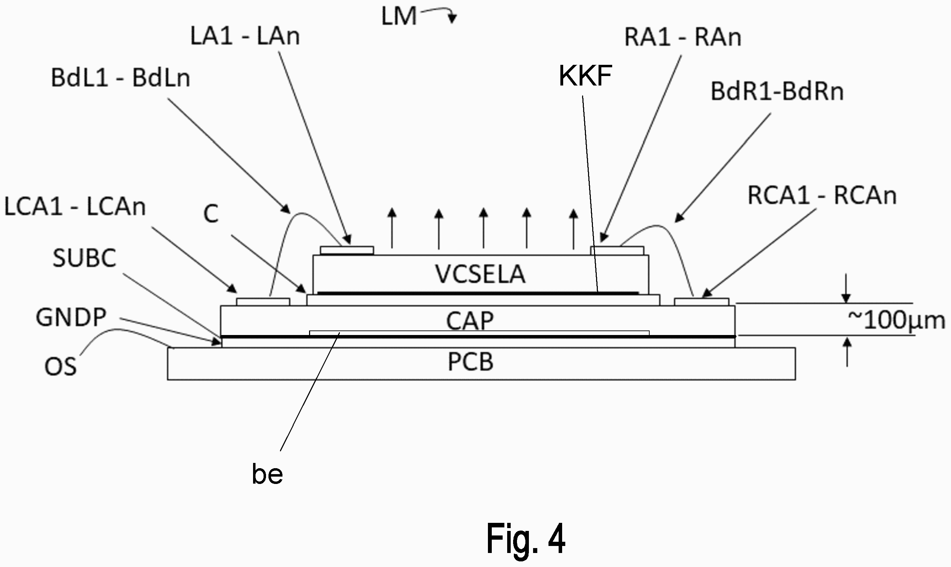

### HAUPTVARIANTE A (siehe insbesondere die Fign. 4, 5 und 7)

Gemäß einer ersten Hauptvariante der Erfindung umfasst das Lichtmodul LM einen Träger, ein Kondensator-Array CAP und ein VCSEL-Laser-Array-Die VCSELA. Der Träger weist eine Oberseite mit bevorzugt einer elektrisch leitfähigen und elektrisch kontaktierbaren Masse-Fläche GNDP auf.

Das VCSEL-Laser-Array-Die VCSELA weist bevorzugt eine Oberseite und eine Unterseite auf. Das VCSEL-Laser-Array-Die VCSELA umfasst bevorzugt n VCSEL-Laser L1 bis Ln, mit n als ganzer positiver Zahl größer 0. Das VCSEL-Laser-Array-Die VCSELA weist bevorzugt an seiner Oberseite beidseitig der n VCSEL-Laser L1 bis Ln eine (linke) Reihe von n elektrisch kontaktierbaren linken Laser-Kontaktflächen LA1 bis LAn und eine (rechte) Reihe von n elektrisch kontaktierbaren rechten Laser-Kontaktflächen RA1 bis RAn. Die Anode jedes Lasers der VCSEL-Laser L1 bis Ln des VCSEL-Laser-Array-Dies VCSELA ist vorzugsweise mit einer jeweiligen (linken) Kontaktfläche der linken Reihe von n Laser-Kontaktflächen LA1 bis LAn elektrisch verbunden und mit einer jeweiligen rechten Kontaktfläche der rechten Reihe von n Laser-Kontaktflächen LA1 bis LAn elektrisch verbunden. Das VCSEL-Laser-Array-Die VCSELA weist bevorzugt einen gemeinsamen Kathodenkontakt an seiner Unterseite auf. Die Kathode jeder Laserdiode der VCSEL-Laser L1 bis Ln des VCSEL-Laser-Array-Dies VCSELA ist bevorzugt mit diesem gemeinsamen Kathodenkontakt an der Unterseite des VCSEL-Laser-Array-Dies VCSELA elektrisch verbunden. Benachbarte VCSEL-Laser L1 bis Ln des VCSEL-Laser-Array-Dies VCSELA, also benachbarte Streifen von Laderdioden VSEL, weisen typischerweise einen minimalern fünften Abstand PTLa zueinander auf.

Das Kondensator-Array CAP weist eine Oberseite und eine Unterseite auf. Das Kondensator-Array CAP umfasst typischerweise einen oder mehrere Kondensatoren, vorzugsweise n Kondensatoren C1 bis Cn, also so viele Kondensatoren wie Laser existieren. Das Kondensator-Array CAP umfasst ein Substrat SUB. Das Kondensator-Array CAP weist einen elektrisch kontaktierbaren Substratkontakt SUBC an seiner Unterseite auf. Das Kondensator-Array CAP umfasst n Kondensatoren C1 bis Cn mit n als ganzer positiver Zahl größer 0. Das Kondensator-Array CAP weist eine Kathodenelektrode C an seiner Oberseite typischerweise in einer Metalllage M3 (zuvor und nachfolgend auch als dritte Metalllage M3 bezeichnet) auf. Das Kondensator-Array CAP weist bevorzugt eine linke Reihe von elektrisch kontaktierbaren linken Kontaktflächen LC1 bis LCn an seiner Oberseite auf. Das Kondensator-Array CAP weist bevorzugt eine rechte Reihe von elektrisch kontaktierbaren rechten Kontaktflächen LC1 bis LCn an seiner Oberseite auf. Das Kondensator-Array CAP weist typischerweise für jeden der n Kondensatoren C1 bis Cn jeweils genau eine obere Kondensatorelektrode te auf. Bevorzugt bildet jede Kondensatorelektrode te zusammen mit dem Material des Substrats SUB als Dielektrikum in dem Bereich des Kondensator-Arrays CAP, der im Wesentlichen durch die Ausdehnung der Kondensatorelektrode te bestimmt ist, und mit dem Substratkontakt SUBC, der die untere Kondensatorelektrode be bildet bzw. kontaktiert, den ihm zugeordneten jeweiligen Kondensator C1 bis Cn. Die oberen Kondensatorelektroden te sind bevorzugt in einer (ersten) Metalllage M1 auf dem Substrat SUB gefertigt. Die n oberen Kondensatorelektroden und damit die n Kondensatoren C1 bis Cn des Kondensator-Arrays CAP sind bevorzugt in j Zeilen und k Spalten im Substrat SUB des Kondensator-Arrays CAP angeordnet, wobei j*k=n (die Anzahl an Kondensatoren C1 bis Cn) gilt und wobei j und k positive ganze Zahlen sind. Die Kondensator-Zeilen des Kondensator-Arrays CAP weisen einen zweiten Abstand PTCY voneinander auf. Die Kondensator-Spalten C1 bis Cn des Kondensator-Arrays CAP weisen einen dritten Abstand PTCX auf. Das Kondensator-Array CAP weist bevorzugt m Anschlussleitungen ICL typischerweise in einer zweiten Metalllage M2 auf. Die Anschlussleitungen ICL sind bevorzugt parallel zu den Zeilen der Kondensatoren C1 bis Cn ausgerichtet. Der vierte Abstand PTCC der Anschlussleitungen ICL untereinander entspricht typischerweise im Wesentlichen dem zweiten Abstand PTCY der Zeilen der Kondensatoren C1 bis Cn geteilt durch die Anzahl der Kondensator-Spalten C1 bis Cn, also geteilt durch die Anzahl der Kondensatorelektroden te der Kondensatoren pro Zeile.

Der minimale fünfte Abstand PTLa der VCSEL-Laser L1 bis Ln des VCSEL-Laser-Array-Dies VCSELA zueinander, also der Laserdiodenstreifen, weicht bevorzugt um nicht mehr als 25% und/oder besser um nicht mehr als 10% und/oder besser um nicht mehr als nicht mehr als 5% und/oder besser um nicht mehr als nicht mehr als 2% und/oder besser um nicht mehr als nicht mehr als 1% vom minimalen vierten Abstand PTCC der Kontaktflächen LCA1 bis LCAn und RCA1 bis RCAn der Kondensatoren C1 bis Cn des Kondensator-Arrays CAP ab.

Der minimale erste Abstand PTL der linken Laser-Kontaktflächen LA1 bis LAn des VCSEL-Laser-Array-Dies VCSELA zueinander und/oder der minimale erste Abstand PTR der rechten Laser-Kontaktflächen RA1 bis RAn des VCSEL-Laser-Array Dies VCSELA zueinander weicht bevorzugt um nicht mehr als 25% und/oder besser um nicht mehr als 10% und/oder besser um nicht mehr als nicht mehr als 5% und/oder besser um nicht mehr als nicht mehr als 2% und/oder besser um nicht mehr als nicht mehr als 1% vom minimalen vierten Abstand PTCC der Kontaktflächen LCA1 bis LCAn und RCA1 bis RCAn der Kondensatoren C1 bis Cn des Kondensator-Arrays CAP. ab.

Die dritte Metalllage M3 (siehe Fig. 12) befindet sich typischerweise oberhalb sowohl der zweiten Metalllage M2 als auch der ersten Metalllage M1 auf dem Substrat SUB. Die zweite Metalllage M2 befindet sich typischerweise oberhalb der ersten Metalllage M1 und typischerweise unterhalb der dritten Metalllage M3 auf dem Substrat SUB. Die dritte Metalllage M3 ist bevorzugt von der zweiten Metalllage M2 und damit auch von der ersten Metalllage M1 und dem Substrat SUB durch eine Isolation INS elektrisch isoliert. Die zweite Metalllage M2 ist bevorzugt von der ersten Metalllage M1 und damit auch von dem Substrat SUB durch eine Isolation INS oder die Isolation INS elektrisch isoliert. Vorzugsweise ist jede Anschlussleitung ICL durch ein sich von der ersten Metalllage M1 bis zur zweiten Metalllage M2 erstreckende Durchkontaktierung durch die Isolationsschicht mit einer Kondensatorelektrode te des dieser Anschlussleitung ICL zugeordneten Kondensators des Kondensator-Arrays CAP elektrisch verbunden und ferner mit einer Kontaktfläche der linken Reihe von elektrisch kontaktierbaren Kontaktflächen LC1 bis LCn des Kondensator-Arrays CAP und gleichzeitig mit einer rechten Kontaktfläche der rechten Reihe von elektrisch kontaktierbaren Kontaktflächen RC1 bis RCn des Kondensator-Arrays CAP elektrisch verbunden, und zwar ebenfalls mittels Durchkontaktierungen DK durch die Isolationsschicht INB, die sich von der zweiten Metalllage M2 bis zur dirtten Metalllage M3 des Kondensator-Arrays CAP, in der sich beidseitig der gemeinsamen Kathodenelektrode C auch die Kontaktflächen LC1 bis LCn und RC1 bis RCn befinden.

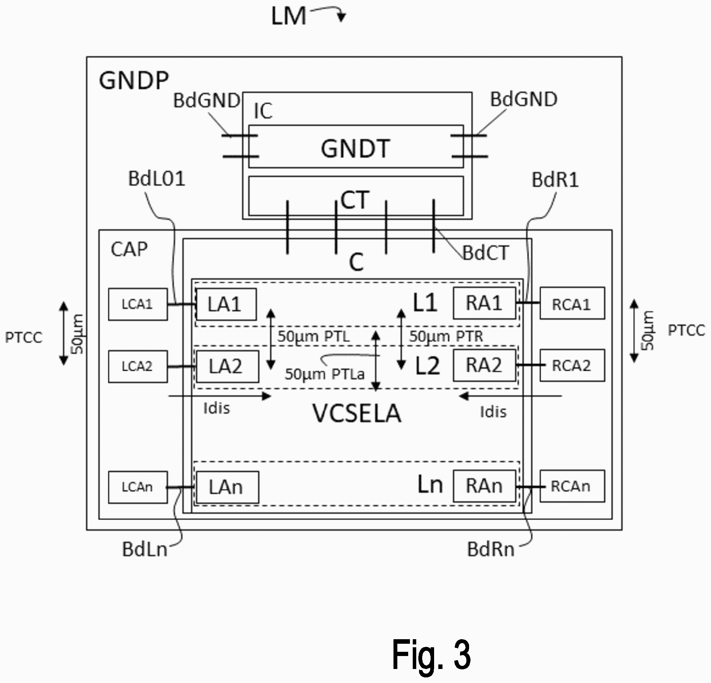

Wie z.B. in den Fign. 3 und 4 zu erkennen, ist vorzugsweise jede Kontaktfläche der linken Reihe von n Laser-Kontaktflächen LA1 bis LAn des VCSEL-Laser-Array-Dies VCSELA elektrisch mit einer Kontaktfläche der linken Reihe von elektrisch kontaktierbaren Kontaktflächen LC1 bis LCn des Kondensator-Arrays CAP verbunden, während jede Kontaktfläche der rechten Reihe von n Laser-Kontaktflächen RA1 bis RAn des VCSEL-Laser-Array-Dies VCSELA elektrisch mit einer Kontaktfläche der rechten Reihe von elektrisch kontaktierbaren Kontaktflächen RC1 bis RCn des Kondensator-Arrays CAP verbunden ist.

Der gemeinsame Kathodenkontakt C des VCSEL-Laser-Array-Dies VCSELA an dessen Unterseite ist vorzugsweise auf der Kathodenelektrode C des Kondensator-Arrays CAP aufgesetzt und mit der Kathodenelektrode C des Kondensator-Arrays CAP elektrisch verbunden. Die Kathodenelektrode C des Kondensator-Arrays CAP ist dabei von den Kondensatoren C1 bis Cn des Kondensator-Arrays CAP elektrisch isoliert. Der Substratkontakt SUBC des Kondensator-Arrays CAP ist vorzugsweise auf der Massefläche GNDP aufgesetzt ist und mit der Massefläche GNDP des Trägers (PCB oder Kühlkörper oder PCB auf Kühlkörper) elektrisch und bevorzugt mechanisch fest verbunden.

Von primärer Bedeutung für die Erfindung ist, dass es durch die Aufteilung der Anschlussleitung ICL pro Zeile (oder Spalte) der oberen Kondensatorelektroden te der Kondensatoren C1 bis Cn des Kondensator-Arrays CAP gelingt, die mit diesen Anschlussleitungen ICL verbundenen Kondensator-Kontaktflächen LAC1 bis LACn und RAC1 bis RACn so dicht anordnen zu können, dass ihr Pitch gleich dem der Laser-Kontaktflächen LA1 bis LAn und RA1 bis Ran ist. Hierfür ist die Abmessung (Dimension in Zeilen- bzw. Spaltenrichtung) der oberen Kondensatorelektrode te zu betrachten. Es können dann pro Zeile (oder Spalte) so viele obere Kondensatorelektroden te vorhanden sein, wie unter Berücksichtigung des Mittenabstands und der Größe der Kondensator-Kontaktflächen LAC1 bis LACn, RAC1 bis RACn nebeneinanderliegend auf die betreffenden Abmessungen der oberen Kondensatorelektroden te verteilt angeordnet werden können.

In einer ersten Untervariante umfasst das Lichtmodul LM zusätzlich eine Treiberschaltung IC (siehe Fig. 3). Die Treiberschaltung IC weist typischerweise eine Oberseite und eine Unterseite auf. Die Treiberschaltung IC umfasst bevorzugt den Entladetransistor T_{DIS} (siehe auch Fig. 2). Der Entladetransistor T_{DIS} weist bevorzugt einen ersten Anschluss GNDT einen zweiten Anschluss CT und typischerweise einen Steueranschluss auf. Der Entladetransistor T_{DIS} kann in Abhängigkeit von dem am Steueranschluss anliegenden elektrischen Steuersignal seinen ersten Anschluss GNDT von seinem zweiten Anschluss CT elektrisch isolieren oder seinen ersten Anschluss GNDT mit seinem zweiten Anschluss CT elektrisch verbinden. Der erste Anschluss GNDT des Entladetransistors T_{DIS} ist bevorzugt mit der Massefläche GNDP elektrisch verbunden. Der zweite Anschluss CT des Entladetransistors T_{DIS} ist bevorzugt mit der Kathodenelektrode C elektrisch verbunden. Die Treiberschaltung IC ist bevorzugt mit ihrer Unterseite auf der Oberfläche des Trägers befestigt. Die Steuerschaltung der Treiberschaltung IC steuert mittels des Steuersignals über den Steueranschluss des Entladetransistors T_{DIS} den Entladetransistor T_{DIS}.

In einer zweiten Untervariante, die eine Untervariante der ersten Untervariante ist, kann die Treiberschaltung IC eine Ladeschaltung SUPL für die Kondensatoren C1 bis Cn des Kondensator-Arrays CAP zum Aufladen derselben mit einem elektrischen Ladestrom, wenn der Entladetransistor T_{DIS} der Treiberschaltung IC sperrt, aufweisen.

In einer dritten Untervariante, die eine Untervariante der zweiten Untervariante ist, können Vorrichtungs- bzw. Schaltungselemente und/oder -teile der Treiberschaltung IC und/oder eine andere elektrische Schaltung, die an dem Träger angeordnet sind oder Teil des Trägers sind, den Steueranschluss des Entladetransistors T_{DIS} der Treiberschaltung IC so ansteuern, dass der Entladetransistor T_{DIS} die Kondensatoren C1 bis Cn des Kondensator-Arrays CAP über die jeweiligen VCSEL-Laser L1 bis Ln des VCSEL-Laser-Array-Die VCSELA, die diesen Kondensatoren C1 bis Cn des Kondensator-Arrays CAP zugeordnet sind, mittels jeweiligen Laser spezifischen Entladeströmen I_{dis} entlädt. Dabei emittieren die VCSEL-Laser L1 bis Ln des VCSEL-Laser-Array-Dies VCSELA, die von einem Entladestrom I_{dis} durchströmt werden, senkrecht zur Oberseite (alternativ: Unterseite) des VCSEL-Laser-Array-Dies VCSELA Licht.

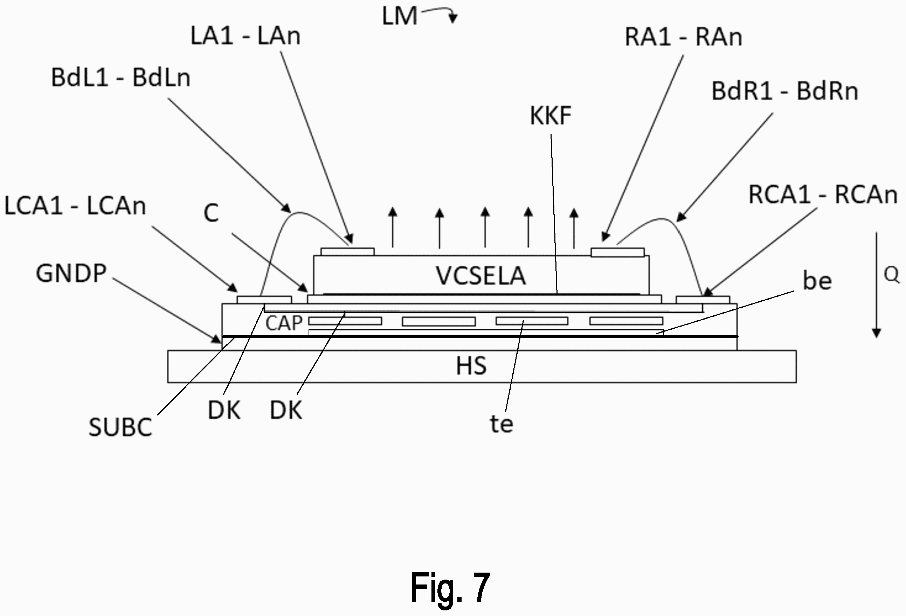

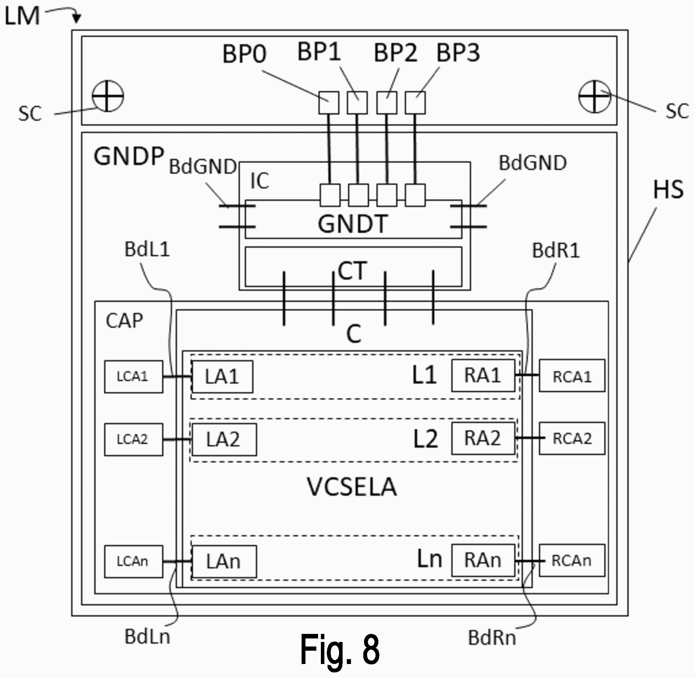

In einer vierten Untervariante, die eine Untervariante der vorausgehenden Untervarianten ist, umfasst der Träger eine gedruckte Schaltung PCB und/oder einen Kühlkörper HS (siehe Fign. 7 und 8).

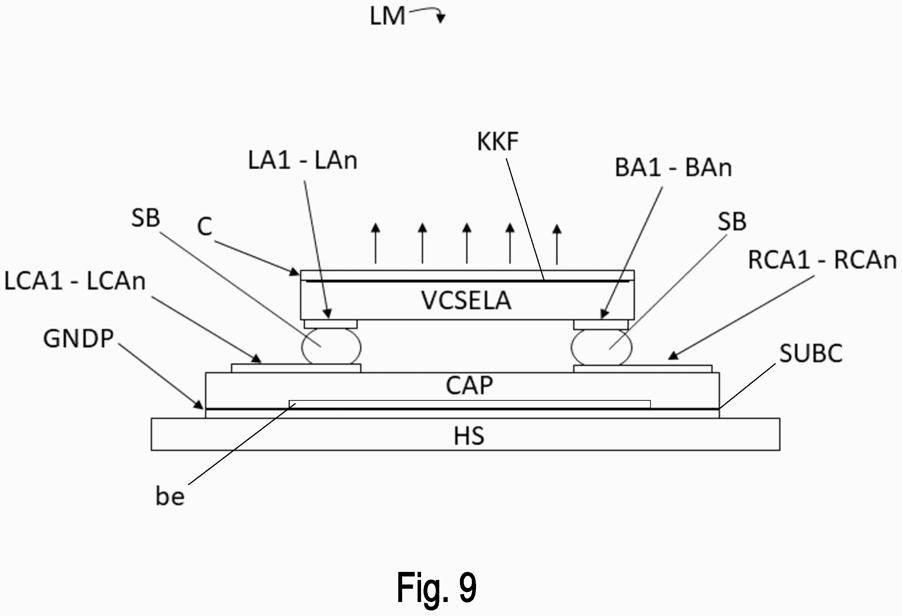

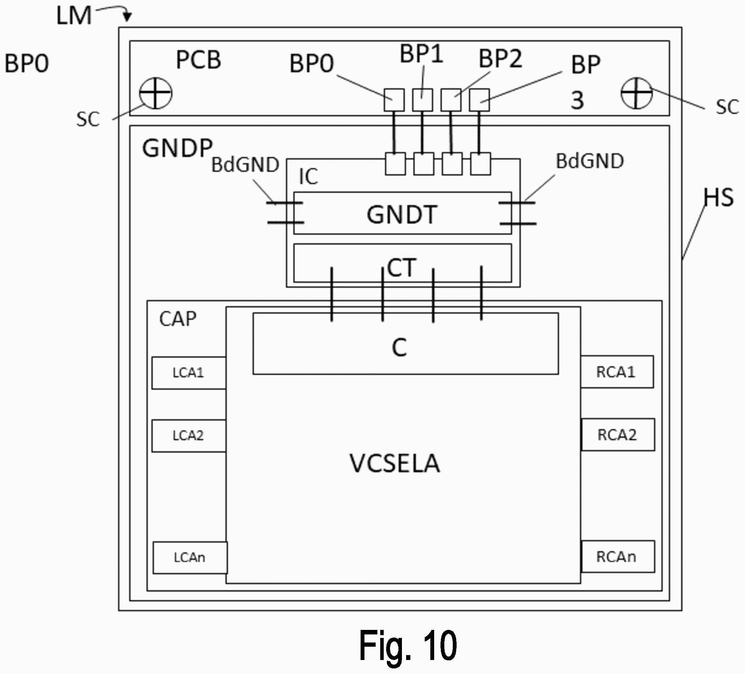

### HAUPTVARIANTE B (Flip-Chip-Montage) (siehe insbesondere die Fign. 9 und 10)

Gemäß einer zweiten Hauptvariante der Erfindung umfasst das Lichtmodul LM einen Träger, ein Kondensator-Array CAP und ein VCSEL-Laser-Array-Die VCSELA. Im Falle der hier vorgesehenen Flip-Chip-Montage (Fig. 9) weist der Träger eine Oberseite auf. Der Träger (z.B. Kühlkörper HS) weist bevorzugt an seiner Oberseite eine elektrisch leitfähige und elektrisch kontaktierbare Masse-Fläche GNDP auf, die für die emittierte Strahlung transparent sein sollte, es sei denn, dass sich die Massefläche GNPD nur über einen Teilbereich der Oberseite erstreckt, der für die Emission der Strahlung nicht genutzt wird.

Das VCSEL-Laser-Array-Die VCSELA weist bevorzugt eine Oberseite und eine Unterseite auf. Das VCSEL-Laser-Array-Die VCSELA umfasst bevorzugt n VCSEL-Laser L1 bis Ln, mit n als ganzer positiver Zahl größer 0. Das VCSEL-Laser-Array-Die VCSELA weist bevorzugt eine linke Reihe von n elektrisch kontaktierbaren linken Laser-Kontaktflächen LA1 bis LAn an seiner Oberseite auf. Das VCSEL-Laser-Array-Die VCSELA weist bevorzugt eine rechte Reihe von n elektrisch kontaktierbaren rechten Laser-Kontaktflächen RA1 bis RAn an seiner Oberseite auf. Die Anode jedes Lasers der VCSEL-Laser L1 bis Ln des VCSEL-Laser-Array-Dies VCSELA ist vorzugsweise mit einer der linken n Laser-Kontaktflächen LA1 bis LAn und mit einer der rechten n Laser-Kontaktflächen LA1 bis LAn elektrisch verbunden. Das VCSEL-Laser-Array-Die VCSELA weist bevorzugt einen gemeinsamen Kathodenkontakt C an seiner Unterseite auf. Die Kathode jedes Lasers der VCSEL-Laser L1 bis Ln des VCSEL-Laser-Array-Dies VCSELA ist bevorzugt mit diesem gemeinsamen Kathodenkontakt C elektrisch verbunden. Die VCSEL-Laser L1 bis Ln des VCSEL-Laser-Array-Dies VCSELA weisen typischerweise einen minimalen (fünften) Abstand PTLa zueinander auf. Wegen der Flip-Chip-Montage weist der gemeinsame Kathodenkontakt C nach oben, wohin auch die Laser ihre Strahlung abstrahlen. Der Kathodenkontakt C ist vorzugsweise für die Strahlung der Laser transparent und kann die gesamte Unterseite des Laser-Arrays überdecken. Alternativ erstreckt sich der Kathodenkontakt C lediglich über einen Teilbereich der Unterseite, in dem keine Strahlung abgegeben wird. Das Kondensator-Array CAP weist eine Oberseite und eine Unterseite auf und umfasst typischerweise einen oder mehrere Kondensatoren, vorzugsweise n Kondensatoren C1 bis Cn. Das Kondensator-Array CAP umfasst ein Substrat SUB mit einem elektrisch kontaktierbaren Substratkontakt SUBC an seiner Unterseite. Das Kondensator-Array CAP weist bevorzugt an seiner Oberseite eine linke Reihe von elektrisch kontaktierbaren linken Kontaktflächen LC1 bis LCn und eine rechte Reihe von elektrisch kontaktierbaren rechten Kontaktflächen RC1 bis RCn auf. Das Kondensator-Array CAP weist typischerweise für jeden der n Kondensatoren C1 bis Cn jeweils genau eine obere Kondensatorelektrode te auf. Bevorzugt bildet jede Kondensatorelektrode te zusammen mit dem Material des Substrats SUB in dem Bereich des Kondensator-Arrays CAP, der im Wesentlichen durch die Ausdehnung der Kondensatorelektrode te bestimmt ist, und zusammen mit dem Substratkontakt SUBC bzw. der allen Kondensatoren gemeinsamen unteren Kondensatorelektrode be den ihm zugeordneten jeweiligen Kondensator C1 bis Cn des Kondensator-Arrays CAP. Die oberen Kondensatorelektroden te sind bevorzugt in einer ersten Metalllage M1 in dem Substrat SUB gefertigt. Die n oberen Kondensatorelektroden und damit die n Kondensatoren C1 bis Cn des Kondensator-Arrays CAP sind bevorzugt in j Zeilen und k Spalten im Substrat SUB des Kondensator-Arrays CAP angeordnet, wobei j*k=n gilt und wobei j und k positive ganze Zahlen sind. Die k Spalten der Kondensatoren C1 bis Cn in einer Zeile des Kondensator-Arrays CAP weisen einen dritten Spaltenabstand PTCX auf. Das Kondensator-Array CAP weist bevorzugt n Anschlussleitungen ICL typischerweise in einer zweiten Metalllage M2, mit n als ganzer positiver Zahl, auf. Die Anschlussleitungen ICL sind bevorzugt parallel zu den Zeilen der Kondensatoren C1 bis Cn ausgerichtet. Der vierte Abstand PTCC der Anschlussleitungen ICL untereinander entspricht typischerweise im Wesentlichen dem zweiten Zeilenabstand PTCY geteilt durch die Anzahl der Spalten der Kondensatoren C1 bis Cn.

Der minimale fünfte Abstand PTLa der VCSEL-Laser L1 bis Ln des VCSEL-Laser-Array-Dies VCSELA zueinander weicht bevorzugt um nicht mehr als 25% und/oder besser um nicht mehr als 10% und/oder besser um nicht mehr als nicht mehr als 5% und/oder besser um nicht mehr als nicht mehr als 2% und/oder besser um nicht mehr als nicht mehr als 1% von dem vierten Abstand PTCC der Anschlussleitungen ICL untereinander ab.

Der ersten Abstand PTL der linken Laser-Kontaktflächen LA1 bis LAn des VCSEL-Laser-Array-Dies VCSELA weicht bevorzugt um nicht mehr als 25% und/oder besser um nicht mehr als 10% und/oder besser um nicht mehr als nicht mehr als 5% und/oder besser um nicht mehr als nicht mehr als 2% und/oder besser um nicht mehr als nicht mehr als 1% von dem vierten Abstand PTCC der Anschlussleitungen ICL untereinander ab.

Der ersten Abstand PTR der rechten Laser-Kontaktflächen RA1 bis RAn des VCSEL-Laser-Array-Dies VCSELA weicht bevorzugt um nicht mehr als 25% und/oder besser um nicht mehr als 10% und/oder besser um nicht mehr als nicht mehr als 5% und/oder besser um nicht mehr als nicht mehr als 2% und/oder besser um nicht mehr als nicht mehr als 1% von dem vierten Abstand PTCC der Anschlussleitungen ICL untereinander ab.

Die zweite Metalllage M2 (siehe Fig. 12) befindet sich typischerweise oberhalb der ersten Metalllage M1 innerhalb des Substrats SUB. Die zweite Metalllage M2 ist bevorzugt von der ersten Metalllage M1 und dem Substrat SUB durch eine Isolation INS oder die Isolation INS elektrisch isoliert.

Vorzugsweise verbindet jede Anschlussleitung ICL der n Anschlussleitungen ICL zumindest eine jeweilige Kondensatorelektrode te eines dieser Anschlussleitung ICL zugeordneten Kondensators der Kondensatoren C1 bis Cn über eine jeweilige Durchkontaktierung DK elektrisch mit einer der elektrisch kontaktierbaren linken Kontaktflächen LC1 bis LCn des Kondensator-Arrays CAP und mit einer der elektrisch kontaktierbaren rechten Kontaktflächen RC1 bis RCn des Kondensator-Arrays CAP elektrisch.

Vorzugsweise ist jede der n linken Laser-Kontaktflächen LA1 bis LAn des VCSEL-Laser-Array-Dies VCSELA mit einer Kontaktfläche der linken Kontaktflächen LC1 bis LCn des Kondensator-Arrays CAP elektrisch und mechanisch verbunden.

Ebenso ist vorzugsweise jede der n rechten Laser-Kontaktflächen RA1 bis RAn des VCSEL-Laser-Array-Dies VCSELA mit einer Kontaktfläche der rechten Kontaktflächen RC1 bis RCn des Kondensator-Arrays CAP über eine Lot-Kugel SB elektrisch und mechanisch fest verbunden.

In einer ersten Untervariante umfasst das Lichtmodul LM zusätzlich eine Treiberschaltung IC. Die Treiberschaltung IC weist typischerweise eine Oberseite und eine Unterseite auf. Die Treiberschaltung IC umfasst bevorzugt einen Entladetransistor T_{DIS}. Der Entladetransistor T_{DIS} weist bevorzugt einen ersten Anschluss GNDT des Entladetransistors T_{DIS} auf. Der Entladetransistor T_{DIS} weist bevorzugt einen zweiten Anschluss CT des Entladetransistors T_{DIS} auf. Der Entladetransistor T_{DIS} weist typischerweise einen Steueranschluss auf. Der Entladetransistor T_{DIS} kann in Abhängigkeit von dem elektrischen Zustand des Steueranschlusses seinen ersten Anschluss GNDT von seinem zweiten Anschluss CT elektrisch isolieren kann oder seinen ersten Anschluss GNDT mit seinem zweiten Anschluss CT elektrisch verbinden. Der erste Anschluss GNDT des Entladetransistors T_{DIS} ist bevorzugt mit der Massefläche GNDP elektrisch verbunden. Der zweite Anschluss CT des Entladetransistors T_{DIS} ist bevorzugt mit der Kathodenelektrode C elektrisch verbunden. Die Treiberschaltung IC ist bevorzugt mit ihrer Unterseite auf der Oberfläche des Trägers befestigt.

In einer zweiten Untervariante, die eine Untervariante der ersten Untervariante ist, kann die Treiberschaltung mittels einer Ladeschaltung SUPL die Kondensatoren C1 bis Cn des Kondensator-Arrays CAP mit einem elektrischen Ladestrom laden, wenn der Entladetransistor T_{DIS} sperrt.

In einer dritten Untervariante, die eine Untervariante der zweiten Untervariante ist, können Vorrichtungsteile der Treiberschaltung IC und/oder eine andere elektrische Schaltung, die an dem Träger befestigt sind oder Teil des Trägers sind, den Steueranschluss des Entladetransistors T_{DIS} so ansteuern, dass der Entladetransistor T_{DIS} die Kondensatoren C1 bis Cn des Kondensator-Arrays CAP über die jeweiligen VCSEL-Laser L1 bis Ln des VCSEL-Laser-Array-Die VCSELA, die diesen Kondensatoren C1 bis Cn des Kondensator-Arrays CAP zugeordnet sind, mittels jeweiligen Laser spezifischen Entladeströmen I_{dis} entlädt. Dabei emittieren dann die VCSEL-Laser L1 bis Ln des VCSEL-Laser-Array-Dies VCSELA, die ein Entladestrom I_{dis} durchströmt, senkrecht zur Oberfläche (Ober- oder Unterseite) des VCSEL-Laser-Array-Dies VCSELA Licht.

In einer vierten Untervariante, die eine Untervariante der vorausgehenden Untervarianten ist, umfasst der Träger eine gedruckte Schaltung PCB und/oder einen Kühlkörper HS.

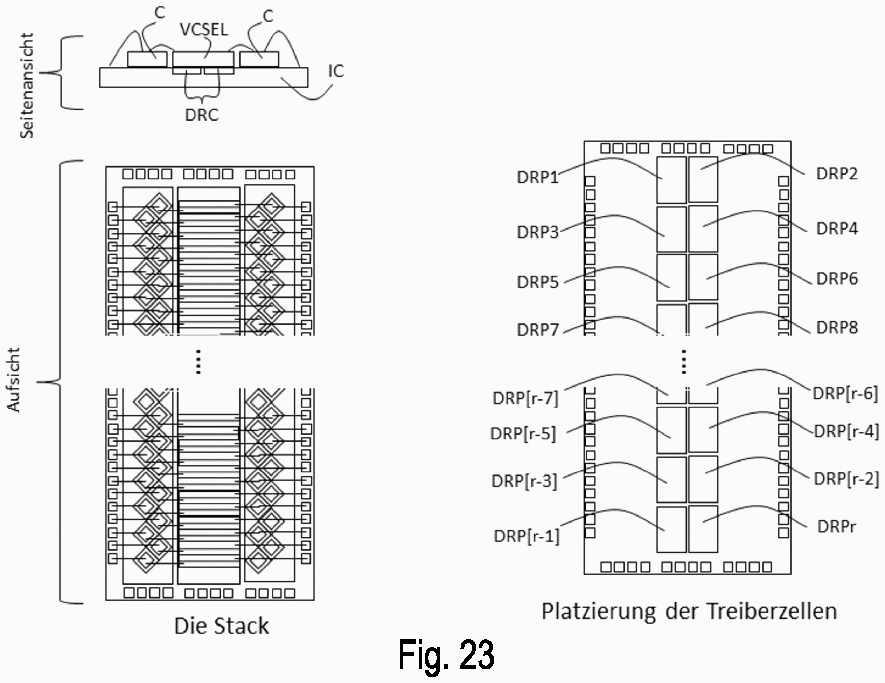

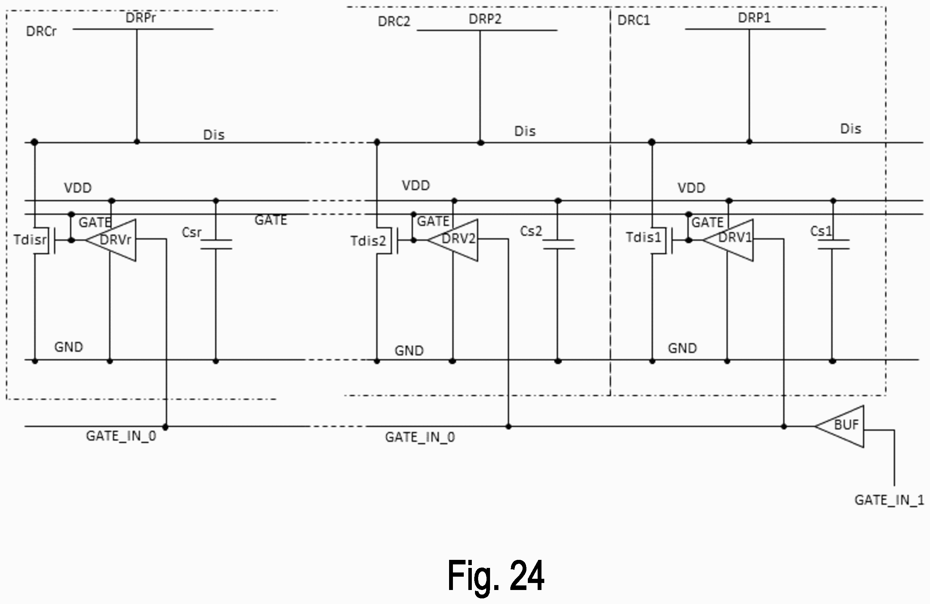

Fig. 1 zeigt eine mögliche, sub-optimale Anordnung der Vorrichtungsteile. Das VCSEL-Laser-Array-Die VCSELA weist bevorzugt eine Mehrzahl von beispielhaft n VCSEL-Lasern L1 bis Ln mit jeweils mehreren parallel geschalteten und nebeneinander in Streifenform angeordneten Laserdioden (im Einzelnen nicht gezeigt) auf. Ein erster Anschluss jedes Lasers ist als unterseitiger Kathodenkontakt mit der gemeinsamen Kathodenelektrode C elektrisch, mechanisch sowie thermisch verbunden. Bonddrähte BdCT verbinden die gemeinsame Kathodenelektrode C mit der Anschlussfläche CT des Entladetransistors T_{DIS} der Treiberschaltung IC. Der Entladetransistor T_{DIS} ist Teil der Treiberschaltung IC. Der Entladetransistor T_{DIS} und seine Verschaltung sind in Fig. 2 eingezeichnet. Der Entladetransistor T_{DIS} ist zur besseren Übersicht in Fig. 1 nicht eingezeichnet. Diese Anschlussfläche CT bildet bevorzugt einen zweiten Anschluss CT des Entladetransistors T_{DIS} der Treiberschaltung IC. Typischerweise ist es der Drain-Anschluss eines N-Kanal-MOS-Transistors, der den Entladetransistor T_{DIS} vorzugsweise bildet. An dieser Stelle sei nochmals auf Fig. 2 verwiesen, die die Entladeschaltung der Treiberschaltung IC schematisch vereinfacht zeigt. In der technischen Realisierung umfasst der Entladetransistor T_{DIS} mehrere verteilt angeordnete Zellen T_{dis1} bis T_{disr}, wie in den Fign. 23 und 24 gezeigt und weiter unten anhand dieser Figuren beschrieben.

Der andere Anschluss, d.h. die Anschlussfläche GNDT des Entladetransistors T_{DIS} der Treiberschaltung IC (siehe auch Fig. 2) ist bevorzugt über weitere Bonddrähte BdGND mit der Massefläche GNDP verbunden. Die Bonddrähte BdGND diese Anschlussfläche GNDT des Entladetransistors T_{DIS} der Treiberschaltung IC mit der Massefläche GNDP.

Links und rechts des VCSEL-Laser-Array-Dies VCSELA sind (bezogen auf die Darstellung in Fig. 1) zwei Reihen mit je n Kondensatoren RC1 bis RCn und LC1 bis LCn platziert. Die linke Kondensatoren-Reihe von n (linken) Kondensatoren LC1 bis LCn kann als gemeinsames linkes Kondensator-Array CAPL ausgeführt sein. Die rechte Kondensatoren-Reihe von n (rechten) Kondensatoren RC1 bis RCn kann als gemeinsames rechtes Kondensator-Array CAPR ausgeführt sein. Jeder dieser Kondensatoren RC1 bis RCn und LC1 bis LCn weist einen unteren Anschlusskontakt und einen jeweiligen oberen Anschlusskontakt LCA1 bis LCAn und RCA1 bis RCAn auf.

Der untere Kontakt jedes dieser Kondensatoren RC1 bis RCn und LC1 bis LCn ist bevorzugt mit der Massefläche GNDP elektrisch leitfähig und bevorzugt auch thermisch leitfähig verbunden. Bevorzugt ist jeder dieser Kondensatoren RC1 bis RCn und LC1 bis LCn bevorzugt an der Massefläche GNDP gehalten.

Jeder der oberen Kontakte LCA1 bis LCAn und RCA1 bis RCAn dieser 2 x n Kondensatoren RC1 bis RCn und LC1 bis LCn ist mittels eines jeweiligen Bonddrahts BdL1 bis BdLn und BdR1 und BdRn bevorzugt mit genau einer Laser-Kontaktfläche LA1 bis LAn und RA1 bis RAn eines VCSEL-Lasers der VCSEL-Laser L1 bis Ln des VCSEL-Laser-Array-Dies VCSELA elektrisch verbunden.

Die elektrische Verbindung sowohl der rechten Kondensatoren RC1 bis RCn als auch der linken Kondensatoren LC1 bis LCn mit den n Ladeschaltungen erfolgt bevorzugt mittels Bonddrähten, die mit den Kontakten RCA1 bis RCAn und LCA1 bis LCAn der n rechten und n linken Kondensatoren RC1 bis RCn und LC1 bis LCn verbunden sind, zur besseren Übersicht in der Fig. 1 jedoch nicht eingezeichnet sind.

Die Länge der Bonddrähte BdL1 bis BdLn zwischen den linken Kontakten LCA1 bis LCAn der n linken Kondensatoren LC1 bis LCn und den linken Laser-Kontaktflächen LA1 bis LAn der n VCSEL-Laser L1 bis Ln des VCSEL-Laser-Array-Dies VCSELA sowie der Bonddrähte BdR1 bis BdRn zwischen den rechten Kontakten RCA1 bis RCAn der n rechten Kondensatoren RC1 bis RCn und den rechten Laser-Kontaktflächen RA1 bis RAn der n VCSEL-Laser L1 bis Ln des VCSEL-Laser-Array-Dies VCSELA ist für die erreichbare Schaltgeschwindigkeit unter anderem maßgeblich.

Das Problem sind relativ lange und zudem auch noch unterschiedlich lange und unterschiedlich geführte Bonddrähte BdL1 bis BdLn und BdR1 bis BdRn zwischen den Anschlüssen LA1 bis LAn und RA1 bis RAn der VCSEL-Laser L1 bis Ln und den Anschlüssen LCA1 bis LCAn und RCA1 und RCAn der Kondensatoren LC1 bis LCn und RC1 bis RCn. Dies führt zu einer spürbaren Verschlechterung der Eigenschaften des Lasermoduls, da die Induktivität dieser unterschiedlich langen und unterschiedlich geführten Bonddrähte BdL1 bis BdLn und BdR1 bis BdRn vergleichsweise hoch ist und damit die maximal erreichbare Schaltgeschwindigkeit beschränkt, was letztendlich der technischen Lehre der WO-A-2021/140160 widerspricht. Ein weiteres Problem ist, dass die linken Kapazitäten LC1 bis LCn auf einem ersten linken Kondensator-Array CAPL und die rechten Kapazitäten RC1 bis RCn auf einem zweiten rechten Kondensator-Array CAPR untergebracht werden können. Eine weitere Kompaktierung zu einem gemeinsamen Kondensator-Array CAP wäre hier jedoch zur weiteren Optimierung wünschenswert. Die Erfindung hat sich daher zusätzlich zum Ziel gesetzt, eine im Hinblick auf Kompaktheit und Schnelligkeit des Schalters und der Kurzzeitigkeit der Lichtemission verbesserte Konstruktion als die der Fig. 1 vorzuschlagen.

Fig. 2 zeigt eine beispielhafte Verschaltung. Die Verschaltung umfasst die Treiberschaltung IC, die wesentlichen Teilkomponenten (S1 bis Sn, SUPL, T_{DIS}) der Treiberschaltung IC umfasst, und die VCSEL-Laser L1 bis Ln. Eine Ladeschaltung SUPL der Treiberschaltung IC versorgt die Schaltung der Fig. 2 mit einem Ladestrom. Die Ladeschaltung SUPL ist bevorzugt Teil der Treiberschaltung IC. Die Steuerung der Treiberschaltung IC schließt denjenigen Ladeschalter S1 bis Sn, der demjenigen VCSEL-Laser L1 bis Ln zugeordnet ist, der als nächstes seinen Lichtpuls abstrahlen soll. Währenddessen ist der Entladeschalter T_{DIS} der Treiberschaltung IC typischerweise geöffnet. Die Ladeschaltung SUPL der Treiberschaltung IC lädt den an die Ladeschaltung SUPL mittels des geschlossenen Ladeschalters S1 bis Sn angeschlossenen Kondensator C1 bis C1 des Kondensatoren Arrays CAP mit dem Ladestrom der Ladeschaltung SUPL. Die n Kondensatoren C1 bis Cn der Fig. 2 repräsentieren dabei bezogen auf die Fig. 1 Parallelschaltungen aus jeweils einem der linken Kondensatoren LC1 bis LCn und einem der rechten Kondensatoren RC1 bis RCn der Fig. 1. Zur besseren Übersicht sind in Fig. 2 die n Kondensatoren C1 bis Cn anstelle der n linken Kondensatoren LC1 bis LCn und der n rechten Kondensatoren RC1 bis RCn der Fig. 1 eingezeichnet. Diese n Kondensatoren C1 bis Cn sind jeweils an einem ersten Anschluss mit der gemeinsamen Masse GND verbunden. Die jeweiligen Kontaktflächen RCA1 bis RCAn und LCA1 bis LCAn der jeweiligen n Kondensatoren LC1 bis LCn und RC1 bis RCn der Fig. 1 bilden den jeweiligen zweiten Anschluss des jeweiligen Kondensators C1 bis C1 und die jeweiligen Knoten A1 bis An der Fig. 2. Für die Entladung der n Kondensatoren C1 bis Cn öffnet bevorzugt die Steuerung der Treiberschaltung IC die ggf. noch geschlossenen Ladeschalter S1 bis Sn, wenn sie nach dem Laden des Kondensators noch geschlossen sein sollten. Wenn nun die Steuerung der Treiberschaltung IC den Entladetransistor T_{DIS} schließt, so entlädt sich der betreffende Kondensator der n Kondensatoren C1 bis Cn über den Entladeschalter T_{DIS} und die Bonddrahtinduktivität L_{BD}0 bis L_{BD}n der Bonddrähte BdL1 bis BdLn und BdR1 bis BdRn (siehe Fig. 1) und über den jeweiligen Laser der VCSEL-Laser L1 bis Ln und über den Kathodenkontakt C. Hierdurch emittiert der jeweilige Laser der n VCSEL-Laser L1 bis Ln Laserstrahlung.

Der jeweilige Stromtransport zwischen den Ladeschaltern S1 bis Sn für die elektrische Vorladung der jeweils zugeordneten Kondensatoren C1 bis Cn aus der Ladeschaltung SUPL zu den Kondensatoren C1 bis Cn erfolgt über einen relativ langen Bonddraht, dessen Induktivität für die zeitliche Dynamik der Entladung des betreffenden jeweiligen Kondensators aber unerheblich ist. Dies ist an sich kein Problem, weil die hierdurch auftretende parasitäre Induktivität die Ladeschaltung SUPL dynamisch während der Pulserzeugung gut von der jeweiligen sich entladenden Kapazität der n Kondensatoren C1 bis Cn isoliert ist. In diesem Zusammenhang sei nochmals auf die technische Lehre der WO-A-2021/140160 verwiesen.

Fig. 2 zeigt vereinfacht und schematisch die typische Entladeschaltung. Die Kondensatoren C1 bis Cn des Kondensator-Arrays CAP sind nun als C1 bis Cn eingezeichnet, da linke und rechte Kondensatoren RC1 bis RCn und LC1 bis LCn mehr unterschieden werden müssen. Den jeweils parallel geschalteten Laserdioden jedes VCSEL-Lasers L1 bis Ln sind genau jeweils ein Ladeschalter der n Ladeschalter S1 bis Sn und jeweils ein Kondensator der n Kondensatoren C1 bis Cn des Kondensator-Arrays CAP zugeordnet. Die Ladeschaltung SUPL lädt vor dem Feuern eines VCSEL-Lasers L1 bis Ln des VCSEL-Laser-Array-Dies VCSELA über den zugeordneten Ladeschalter S1 bis Sn genau diesen Kondensatoren C1 bis Cn des Kondensator-Arrays CAP. Hierzu schließt eine Steuerung den entsprechenden Ladeschalter der Schalter S1 bis Sn, der diesem VCSEL-Laser L1 bis Ln des VCSEL-Laser-Array-Dies VCSELA zugeordnet ist.

Ist der einem der n VCSEL-Laser L1 bis Ln des VCSEL-Laser-Array-Dies VCSELA zugeordnete Kondensator der n Kondensatoren C1 bis Cn des Kondensator-Arrays CAP geladen, so schließt die Steuerung den in Form des Entladetransistors T_{DIS} ausgeführten Entladeschalter. Hierdurch entlädt der Entladetransistor T_{DIS} diesen Kondensator über den diesem Kondensator zugeordneten Laser, so dass ein elektrischer Entladestrom durch dessen Laserdioden fließt. Der elektrische Entladestrom, der durch die Laserdioden fließt, verursacht die gewünschte Lichtemission. Anschließend öffnet die Steuerung den Entladetransistor T_{DIS} wieder. Die eingezeichneten Induktivitäten L_{BD}0 bis L_{BD}n sind die Induktivitäten der Bonddrähte zwischen dem jeweiligen Kondensator und dem diesem Kondensator zugeordneten Laser. Die entsprechenden Bonddrähte müssen daher möglichst kurz sein, um diese Induktivitäten L_{BD}0 bis L_{BD}n zu minimieren, da sie die Anstiegsflanken in ihrer Steilheit begrenzen.

Fig. 3 zeigt das Grundprinzip des Aufbaus des erfindungsgemäßen Lasermoduls.

Das VCSEL-Laser-Array-Die VCSELA ist mit den gemeinsamen Kathoden der Lasern L1 bis Ln auf einer Kathodenelektrode C angeordnet. Die Kathodenelektrode C ist bevorzugt in einer (dritten) Metalllage M3 der Metalllagen der Verdrahtung des Kondensator-Arrays CAP auf der Oberseite dieses Kondensator-Arrays CAP gefertigt (siehe hierzu auch Fig. 12). Die allen Lasern L1 bis Ln bzw. deren Laserdioden gemeinsame Kathode des VCSEL-Laser-Array-Dies VCSELA ist dabei typischerweise elektrisch und thermisch mit der Kathodenelektrode C des Kondensator-Arrays CAP verbunden. Die Kathodenelektrode C ist typischerweise elektrisch gegenüber anderen Vorrichtungsteilen des Kondensator-Arrays CAP durch ein oder mehrere Isolationsschichten INS isoliert. Bevorzugt weist jeder der n Kondensatoren C1 bis Cn des Kondensator-Arrays CAP jeweils zwei Anschlüsse auf, nämlich einen linken Anschluss LCA1 bis LCAn und einen korrespondierenden rechten Anschluss RCA1 bis RCAn. Diese zwei Anschlüsse eines Kondensators der n Kondensatoren C1 bis Cn des Kondensator-Arrays CAP sind bevorzugt links und rechts der Kathodenelektrode C und damit des VCSEL-Laser-Array-Dies VCSELA platziert, wenn dieses sich mit seiner allen Lasern L1 bis Ln gemeinsamen unterseitigen Kathodenfläche auf der Kathodenelektrode C befindet. Für beispielsweise den Kondensator C1 sind eine linke Kontaktfläche LCA1 links des VCSEL-Laser-Array-Die VCSELA und eine rechte Kontaktfläche RCA1 rechts des VCSEL-Laser-Array-Die VCSELA vorgesehen. Als Vorgriff auf die Beschreibung der Fig. 11 sei hier bereits erwähnt, dass dort dargestellt ist, dass beide Kontaktflächen LCA1 und RCA1 die (obere) Kondensatorelektrode te (siehe Fig. 11) des Kondensators C1 kontaktieren. Die oberen Kondensatorelektroden te sind in Fig. 3 nicht dargestellt. Die obere Kondensatorelektrode te des Kondensators C1 ist also mit den beiden Kontaktflächen LCA1 und RCA1 elektrisch verbunden, so dass diese im Wesentlichen als ein elektrischer Knoten A1 betrachtet werden können. Dieser Knoten A1 ist der Knoten A1 der Fig. 2. Dies ist notwendig, um zu verstehen, warum dieser Aufbau besonders günstig ist. Auf diese Weise ist nämlich jeder der Knoten A1 bis An der jeweiligen oberen Kondensatorelektroden te der jeweiligen Kondensatoren C1 bis Cn immer über exakt eine der linken Kontaktflächen LCA1 bis LCAn und über exakt eine der rechten Kontaktflächen RCA1 bis RCAn elektrisch anschließbar. Dies wird weiter unten anhand der Beschreibung der Fig. 11 deutlicher werden.

Ein geeigneter Aufbau des Kondensator-Arrays CAP stellt typischerweise sicher, dass der Abstand PTCL der linken Kontaktflächen LCA1 bis LCAn des Kondensator-Arrays CAP untereinander mit dem ersten Abstand PTL der linken Laser-Kontaktflächen LA1 bis LAn des VCSEL-Laser-Array-Dies VCSELA untereinander übereinstimmt, die Kontaktflächen LCA1 bis LCAn also mit den Laser-Kontaktflächen LA1 bis LAn insoweit fluchten. Dies stellt sicher, dass die Bonddrähte BdL1 bis BDLn zwischen jeweils einer der linken Kontaktflächen LCA1 bis LCAn des Kondensator-Arrays CAP und einer der linken Laser-Kontaktflächen LA1 bis LAn des VCSEL-Laser-Array-Dies VCSELA in etwa immer gleich lang sind und in ihrer Länge durch einen möglichst kleinen Abstand der betreffenden Kontaktflächen minimiert werden können. In gleicher Weise sind die rechten Kontaktflächen des Kondensator-Arrays CAP und die rechten Laser-Kontaktflächen RA1 bis Ran des VCSEL-Laser-Array-Dies VCSELA angeordnet.

Die Treiberschaltung IC ist auf der Massefläche GNDP platziert und befestigt. Die Treiberschaltung IC ist auf der Massefläche GNDP bevorzugt aber nicht notwendiger Weise mit seinem Rückseitenkontakt elektrisch an der Massefläche GNDP angeschlossen. Die Treiberschaltung IC weist bevorzugt eine Anschlussfläche als weiteren Anschluss ihres Entladetransistors T_{DIS} auf, mit der der Drain-Kontakt des Entladetransistors T_{DIS} der Treiberschaltung IC mit der gemeinsamen Kanthoden-Elektrode C des VCSEL-Laser-Array-Dies VCSELA über einen oder besser mehrere Bonddrähte verbunden ist.

Bevorzugt ist die Source des Entladetransistors T_{DIS} der Treiberschaltung IC über eine zweite Anschlussfläche GNDT als erster Anschluss des Entladetransistors T_{DIS} der Treiberschaltung IC mit der Massefläche GNDP elektrisch verbunden.

Das Kondensator-Array CAP ist mit dem gemeinsamen Kontakt seiner Kondensatoren C1 bis Cn bevorzugt mit der Massefläche GNDP elektrisch und mechanisch fest verbunden. Bevorzugt befindet sich der gemeinsame Kontakt der Kondensatoren C1 bis Cn des Kondensator-Arrays CAP auf der Unterseite des es Kondensator-Arrays CAP.

Fig. 4 zeigt eine beispielhafte Schnittansicht durch die Konstruktion der Fig. 3.

Das VCSEL-Laser-Array-Die VCSELA ist mit seiner Unterseite auf die gemeinsame Kathodenelektrode C des Kondensator-Arrays CAP elektrisch leitend aufgesetzt und mit dieser elektrisch und vorzugsweise mechanisch verbunden. Der Unterseitenkontakt des VCSEL-Laser-Array-Die VCSELA bildet die sämtlichen Lasern L1 bis Ln bzw. die sämtlichen Laserdioden des VCSEL-Laser-Array-Die VCSELA gemeinsame Kathode. Das VCSEL-Laser-Array-Die VCSELA ist mit der gemeinsamen Kathodenelektrode C bevorzugt im Stacked-Die-Verfahren mittels elektrisch leitender Klebung oder Lötung oder dergleichen an der gemeinsame Kathodenelektrode C elektrisch leitend befestigt und damit mit dieser elektrisch verbunden. Bevorzugt bildet die oberste Metallisierungslage des Kondensators-Arrays CAP diese gemeinsame Kathodenelektrode C. In dem hier vorgestellten Beispiel ist die oberste Metallisierungslage des beispielhaften Kondensators-Arrays CAP z.B. die (dritte) Metalllage M3. Die gemeinsame Kathodenelektrode C des Kondensators-Arrays CAP ist bevorzugt von seinen n Kondensatoren C1 bis Cn elektrisch isoliert.

Das Kondensator-Array CAP wiederum ist mit einem gemeinsamen Rückseitenkontakt aller Kondensatoren C1 bis Cn des Kondensator-Arrays CAP in dem Beispiel auf die Massefläche GNDP aufgesetzt, die sich auf der Oberseite einer gedruckten Schaltung PCB befindet. Bei der gedruckten Schaltung PCB kann es sich um einen beliebigen Schaltungsträger für elektronische Bauelemente, wie beispielsweise eine FR4-Platine oder einen Keramikschaltungsträger etc. handeln. Bevorzugt ist das Kondensator-Array CAP mit dem sämtlichen seiner Kondensatoren C1 bis Cn gemeinsamen Substrat-(Rückseiten-)kontakt SUBC in dem Beispiel mit der Massefläche GNDP elektrisch und mechanisch fest verbunden.

Es ist möglich, statt der gedruckten Schaltung PCB direkt einen Kühlkörper HS zu verwenden.

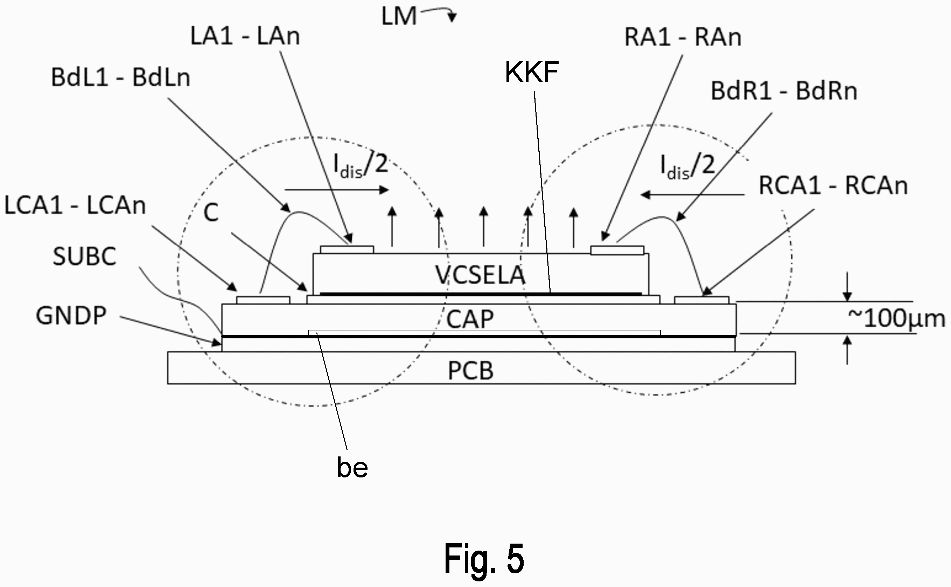

Fig. 5 verdeutlicht die EMV-Optimierung und die Induktivitätsminimierung durch antiparallele Entladeströme I_{dis}. Aufgrund der Symmetrie des Aufbaus verteilt sich der Entladestrom I_{dis} der durch den Entladetransistor T_{DIS} (siehe Fig. 2) bei der Entladung fließt, so dass in etwa die Hälfte des Entladestromes I_{dis} jeweils über einen der n linken Bonddrähte BdL1 bis BdLn und in etwa die Hälfte des Entladestromes I_{dis} über jeweils einen der n linken Bonddrähte BdR1 bis BdRn fließt. Da die räumliche Richtung des Entladestromes I_{dis}/2 über den rechten Bonddraht der räumlichen Richtung des Entladestromes I_{dis}/2 über den linken Bonddraht entgegengesetzt ist, heben sich die Magnetfelder in einiger Entfernung von dem Lichtmodul LM auf. Das bedeutet, dass eine geringere elektromagnetische Abstrahlung dieser Anordnung die verbesserte elektromagnetische Verträglichkeit des Lichtmoduls LM zur Folge hat, was bei den steilen Einschaltflanken von wesentlicher Bedeutung ist.

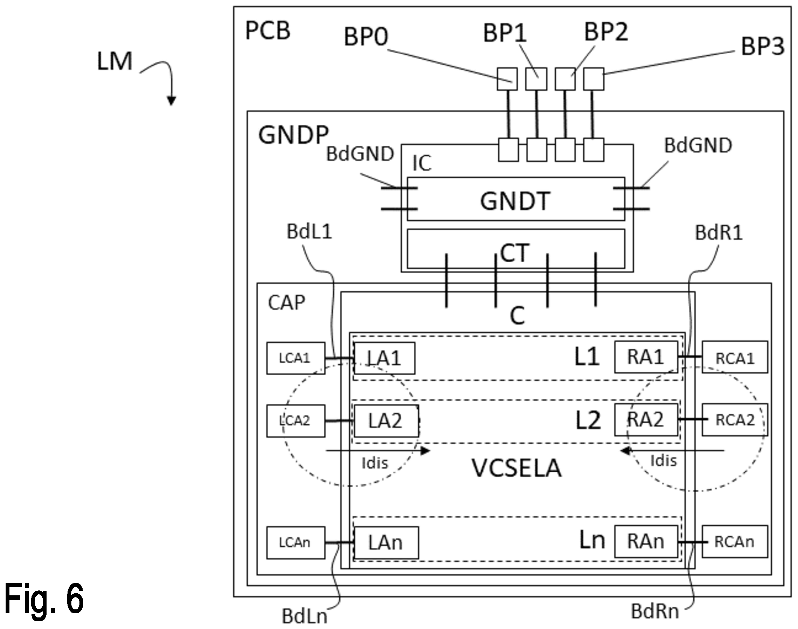

Fig. 6 entspricht der Schnittansicht der Fig. 5 in der Aufsicht. Fig. 6 verdeutlicht die EMV-Optimierung und die Induktivitätsminimierung durch antiparallele Entladeströme I_{dis} anhand der Fig. 3 anlog der Verdeutlichung in Fig. 5 bezogen auf Fig. 4. Über die in der Fig. 6 gezeigten Bonddrähte BdL1 bis BdLn und BdR1 bis BdRn erhält der in Fig. 6 zur besseren Übersicht wiederum nicht eingezeichnete Entladetransistor T_{DIS} (siehe Fig. 2) in der Treiberschaltung IC von Vorrichtungsteilen der gedruckten Schaltung PCB, die zur besseren Übersicht in den Figuren ebenfalls nicht gezeigt sind, und/oder von anderen Vorrichtungsteilen der Treiberschaltung IC das Signal leitend zu werden. Dies schließt somit den Entladeschalter in Form des Entladetransistors T_{DIS}. Während der Entladung öffnen die besagen Vorrichtungsteile der gedruckten Schaltung PCB und/oder Vorrichtungsteile der Treiberschaltung IC bevorzugt die Ladeschalter S1 bis Sn. Daraufhin fließt ein Entladestrom von I_{dis} über den Entladeschalter in Form des Entladetransistors T_{DIS} gegen Masse in Form der Massefläche GNDP ab und der entsprechende der n Kondensatoren C1 bis Cn entlädt sich über den zugeordneten der n VCSEL-Laser L1 bis Ln, wobei dieser Laser dann schlagartig seinen Laser-Puls emittiert.

Bei exakter Symmetrie, die in der Realität und insbesondere bei der (groß-)industriellen Fertigung leider kaum erreicht werden kann, fließt dann der Entladestrom I_{DIS}/2 von links und ein in etwa betragsmäßig gleicher Entladestrom I_{DIS}/2 von rechts in den entsprechenden Laser. Da die räumlichen Stromrichtungen entgegengesetzt sind, heben sich Teile der erzeugten Magnetfelder im Raum infolge des Superpositionsprinzips im Fernfeld im Wesentlichen auf. Damit ist aber auch die im magnetischen Feld gespeicherte Energie geringer und daher die effektive Induktivität kleiner. Die Schaltung ist daher durch die gegensinnige Einkopplung des linken und des rechten Entladestroms schneller. Der eine Entladestrom zieht quasi effektiv den anderen Entladestrom an, was bemerkenswert ist.

Fig. 7 basiert auf der Fig. 4. Auf die Beschreibung der Fig. 4 wird hier verwiesen. Fig. 7 schlägt jedoch abweichend zur Fig. 4 vor, statt einer Massefläche GNDP auf einer gedruckten Schaltung PCB direkt einen Kühlkörper HS als Massefläche GNDP zu benutzen. Der Vorteil ist eine bessere Wärmeableitung.

Fig. 8 basiert auf der Fig. 3. Auf die Beschreibung der Fig. 3 wird hier verwiesen. Fig. 8 entspricht der Fig. 7 in der Aufsicht. Fig. 8 schlägt abweichend von der Fig. 3 vor, statt einer Massefläche GNDP auf einer gedruckten Schaltung PCB direkt einen Kühlkörper HS als Massefläche GNDP zu benutzen und die gedruckte Schaltung PCB kleiner neben der Treiberschaltung IC auf dem Kühlkörper HS zu befestigen. Der Vorteil ist eine bessere Wärmeableitung.

Gemäß Fig. 9 wird vorgeschlagen, als VCSEL-Laser-Array-Die VCSELA ein VCSEL-Laser-Array-Die VCSELA zu benutzen, dass über die Rückseite bzw. Unterseite des VCSEL-Laser-Array-Dies VCSELA das Licht emittiert. Der Kathodenkontakt C ist für die abgegebene Laserstrahlung transparent oder erstreckt sich in einen solchen Bereich der Unterseite des Laser-Arrays, in dem keine Strahlung abgegeben wird. Fig. 9 zeigt den Querschnitt einer solchen beispielhaften Konstruktion. Des Weiteren wird vorgeschlagen, die elektrische Verbindung zwischen dem Kondensator-Array CAP und dem VCSEL-Laser-Array-Die VCSELA nicht mit Bonddrähten, wie in den Fign. 1 bis 8, sondern nun mittels Flip-Chip-Technik und Solder-Balls (Lot-Kugeln SB) oder dergleichen durchzuführen, was die Induktivitäten weiter senkt. Hierzu ist in dem Beispiel der Fig. 9 das VCSEL-Laser-Array-Die VCSELA mit seiner Rückseite nach oben beispielhaft kopfüber auf dem Kondensator-Array CAP mittels Lot-Kugeln SB montiert. Bevorzugt ist der Rückseitenkontakt der gemeinsamen Kathodenelektrode C nun auf dem VCSEL-Laser-Array-Die VCSELA gefertigt. Bevorzugt ist dieser Rückseitenkontakt der gemeinsamen Kathodenelektrode C ganz oder teilweise transparent für die Lichtabstrahlung der n VCSEL-Laser L1 bis Ln des VCSEL-Laser-Array-Dies VCSELA. Dies kann mittels Durchbrüche in dem elektrisch leitfähigen Material des Rückseitenkontakts der gemeinsamen Kathodenelektrode C geschehen. Eine andere Möglichkeit ist ein Rückseitenkontakt der gemeinsamen Kathodenelektrode C, der ganz oder in Teilen ein optisch für die Lichtabstrahlung der VCSEL-Laser L1 bis Ln des VCSEL-Laser-Array-Dies VCSELA transparentes Material umfasst und/oder aufweist. Ein solches Material kann beispielsweise Indium-Zinn-Oxid, auch ITO genannt, sein. Einige der Lot-Kogeln SB können ausschließlich zu dem Zweck der thermischen Ableitung vorgesehen sein. Die Lot-Kugeln SB können auch nicht kugelförmig sein und größere Flächen miteinander verbinden.

Fig. 10 entspricht der Fig. 9 in der Aufsicht. Die Bonddrähte sind durch die Lot-Kugeln SB ersetzt. Das VCSEL-Laser-Array-Dies VCSELA verdeckt die Lotkugeln SB. Diese Konstruktion zeichnet sich durch eine besonders geringe parasitäre Induktivität aus.

Fig. 11 zeigt eine beispielhafte Konstruktion eines erfindungsgemäßen Kondensator-Arrays CAP schematisch vereinfacht in der Aufsicht.

Die n Anschlussleitungen ICL der n Kondensatoren C1 bis Cn sind dichter gepackt als die Kondensatorelektroden te der Kondensatoren hoch sind. Das Wort "hoch" bezieht sich dabei auf die zweidimensionale Darstellung der Fig. 11. Hierbei entspricht das Maß PTCY dieser "Höhe". Das Bezugszeichen PTCY bezeichnet den minimalen Abstand PTCY der Zeilen der n Kondensatoren C1 bis Cn des Kondensator-Arrays CAP. Die Fig. 11 gibt als Beispiel einen Minimalabstand PTCY der Kondensatoren C1 bis Cn des Kondensator-Arrays CAP von 300µm an. Die Anschlussleitungen ICL der Kondensatoren C1 bis Cn sind als breite Linien von links nach rechts in der Fig. 11 vereinfacht gezeichnet. Dies orientiert sich an den Bezugszeichen der Fig. 2 und dient der besseren Übersichtlichkeit. Die Knoten A1 bis An der Fig. 2 sind identisch mit der Kombination der linken Kontaktflächen LCA1 bis LCAn und der rechten Kontaktflächen RCA1 bis RCAn. Diese Änderung der Bezugszeichen dient nur der Übersichtlichkeit. Die Anschlussleitungen ICL verbinden die rechten Kontaktflächen RCA1 bis RCAn elektrisch mit den linken Kontaktflächen LCA1 bis LCAn. Da die Anschlussleitungen ICL der Kondensatoren C1 bis Cn dichter gepackt sind als die Kondensatoren hoch sind, überstreichen immer mehrere Anschlussleitungen ICL einen der n Kondensatoren C1 bis Cn. In dem Bespiel der Fig. 11 sind die Kondensatoren C1 bis Cn des Kondensator-Arrays CAP in Zeilen und Spalten angeordnet. In dem Bespiel der Fig. 11 befinden sich beispielhaft immer vier Kondensatoren in einer Zeile des Kondensator-Arrays CAP. Daher überstreichen auch immer vier Anschlussleitungen ICL jeden Kondensator der Kondensatoren C1 bis Cn des beispielhaften Kondensator-Arrays CAP. Jede Anschlussleitung der Anschlussleitungen ICL, die hier beispielhaft in der zweiten Metalllage M2 realisiert sind (siehe Fig. 12), ist beispielhaft über eine Durchkontaktierung DK mit der oberen Elektrode te genau des einen, ihr zugeordneten Kondensators elektrisch verbunden. In der Fig. 11 symbolisieren schwarze Kreise diese Durchkontaktierungen DK. Jede Anschlussleitung ICL weist links je einen linken der Kontaktflächen LCA1 bis LCAn und je einen rechten der Kontaktflächen RCA1 bis RCAn auf. Die Anschlusskontakte der Kontaktflächen LCA1 bis LCAn und RCA1 bis RCAn der Kondensatoren C1 bis Cn des Kondensator-Arrays CAP sind typischerweise in der ersten Metalllage M1 und in der zweiten Metalllage M2 gefertigt, die im Bereich der Kontaktflächen durch Durchkontaktierungen miteinander verbunden sind. Oberhalb und elektrisch isoliert vom Rest des Kondensator-Arrays CAP ist die gemeinsame Kathodenelektrode C des VCSEL-Laser-Array-Dies VCSELA in einer dritten Metalllage M3 gefertigt. Jede Anschlussleitung ICL mit ihrem linken Anschlusskontakt der Kontaktflächen LCA1 bis LCAn und ihrem rechten Anschlusskontakt der Kontaktflächen RCA1 bis RCAn entspricht somit einem der Knoten A1 bis An der Fig. 2.

Der minimale vierter Abstand PTCC der Kontaktflächen LCA1 bis LCAn und RCA1 bis RCAn der Kondensatoren C1 bis Cn des Kondensator-Arrays CAP errechnet sich aus dem Minimalabstand PTCY der Zeilen der Kondensatoren C1 bis Cn des Kondensator-Arrays CAP geteilt durch die Anzahl der Spalten der Anordnung der Kondensatoren C1 bis Cn. Die Fig. 11 gibt beispielhaft einen Minimalabstand PTCY der Kondensatoren C1 bis Cn des Kondensator-Arrays CAP von 300µm und beispielhaft einen Minimalabstand PTCC der Kontaktflächen LCA1 bis LCAn und RCA1 bis RCAn der Kondensatoren C1 bis Cn des Kondensator-Arrays CAP von 50µm an.

Dieser innere Aufbau des Kondensator-Arrays CAP stellt sicher, dass der rechte Abstand PTCR der rechten Kontaktflächen RCA1 bis RCAn des Kondensator-Arrays CAP untereinander mit dem Abstand PTR der rechten Laser-Kontaktflächen RA1 bis RAn des VCSEL-Laser-Array-Dies VCSELA (siehe Fig. 3) untereinander übereinstimmt. Dies stellt sicher, dass die Bonddrähte BdR1 bis BRRn (siehe Fig. 3) zwischen jeweils einer der rechten Kontaktflächen RCA1 bis RCAn des Kondensator-Arrays CAP und jeweils einer rechten Kontaktfläche der rechten Laser-Kontaktflächen RA1 bis RAn des VCSEL-Laser-Array-Dies VCSELA in etwa immer gleich lang sind und in ihrer Länge minimiert werden können.

Jeweils eine Anschlussleitung ICL verbindet eine rechte Kontaktflächen der rechten Kontaktflächen RCA1 bis RCAn des Kondensator-Arrays CAP mit der korrespondierenden linken Kontaktfläche der linken Kontaktflächen LCA1 bis LCAn des Kondensator-Arrays CAP elektrisch miteinander, sodass sie einen Knoten der Knoten A1 bis An der Fig. 2 bilden.

Bevorzugt entsprechen die Abstände PTCR der rechten Kontaktflächen RCA1 bis RCAn des Kondensator-Arrays CAP untereinander und die Abstände PTCL der linken Kontaktflächen LCA1 bis LCAn des Kondensator-Arrays CAP untereinander einem gemeinsamen vierten Abstand PTCC der Kontaktflächen untereinander. Die Abstände PTCR und PTCL sind nur in Fig. 1 für zwei getrennte Kondensator-Arrays CAPL, CAPR eingezeichnet.

Der zweite Abstand PTCY der Zeilen der Kondensatoren C1 bis Cn des Kondensator-Arrays CAP bleibt jedoch unverändert. In dem Beispiel der Fig. 11 bleibt der zweite Abstand PTCY der Zeilen der Kondensatoren C1 bis Cn des Kondensator-Arrays CAP bei beispielhaften 300µm. Dies stellt sicher, dass die Bonddrähte zwischen jeweils einer der rechten Kontaktflächen RCA1 bis RCAn des Kondensator-Arrays CAP und jeweils einer der rechten Laser-Kontaktflächen RA1 bis RAn des VCSEL-Laser-Array-Dies VCSELA in etwa immer gleich lang sind und in ihrer Länge minimiert werden können. Die Bonddrähte BdR1 bis BdRn und BdL1 bis BdLn verbinden die Kontaktflächen RCA1 bis RCAn und LCA1 bis LCAn des Kondensator-Arrays CAP mit den Laser-Kontaktflächen RA1 bis RAn und LA1 bis LAn der VCSEL-Laser L1 bis Ln des VCSEL-Laser-Array-Dies VCSELA, so dass zwei Paare aus je einem Anschluss des Kondensators und einem Anschluss des VCSEL-Lasers mit genau einem der VCSEL-Laser L1 bis Ln des VCSEL-Laser-Array-Dies VCSELA verbunden sind.

Fig. 12 zeigt einen beispielhaften, vereinfachten nicht maßstabsgerechten Querschnitt durch das Kondensator-Array CAP der Fig. 11 zur Verdeutlichung der verschiedenen Lagen der Verdrahtungsebenen des Kondensator-Arrays CAP und der Durchkontaktierungen DK.

Das Kondensator-Array CAP umfasst bevorzugt drei Metalllagen M1, M2 und M3. In der ersten Metalllage M1 des Kondensator-Arrays CAP sind die oberen Elektroden (Kondensatorelektroden te) der Kondensatoren C1 bis Cn des Kondensator-Arrays CAP gefertigt. Eine Isolationsschicht INS trennt die erste Metalllage M1 von der zweiten Metalllage M2 elektrisch. In der zweiten Metalllage M2 sind die Anschlussleitungen ICL der Kondensatoren C1 bis Cn des Kondensator-Arrays CAP gefertigt.

Durchkontaktierungen DK (siehe Fig. 11) durch die Isolationsschicht INS verbinden die Anschlussleitungen ICL der zweiten Metalllage M2 mit den Kondensatorelektroden te in der ersten Metalllage M1 elektrisch. Das Kondensator-Array CAP umfasst des Weiteren ein Substrat SUB. Dieses Substrat SUB umfasst bevorzugt das Dielektrikum der Kondensatoren C1 bis Cn des Kondensator-Arrays CAP. Die Unterseite des Kondensator-Arrays CAP bildet ein Substratkontakt SUBC. Der Bereich zwischen einer Kondensatorelektrode te in der ersten Metalllage M1 und dem Substratkontakt SUBC bildet jeweils eine vertikale Kapazität der Kondensatoren C1 bis Cn des Kondensator-Arrays CAP. Ein solcher Kondensator ist somit jeweils ein vertikaler Kondensator zwischen der ersten Metalllage M1 und dem allen Kondensatoren C1 bis Cn des Kondensator-Arrays CAP gemeinsamen Substratkontakt SUBC auf der Unterseite des Kondensator-Arrays CAP. Dieser Substratkontakt SUBC ist bevorzugt mit der Massefläche GNDP (siehe auch die Fign. 4, 5, 7, 9) elektrisch verbunden. Auf der Unterseite sind somit die Masseelektroden sämtlicher Kondensatoren C1 bis Cn des Kondensator-Arrays CAP kurzgeschlossen. Die jeweilige Kondensatorelektrode te des jeweiligen Kondensators ist jeweils in der ersten Metalllage M1 gefertigt. Die querlaufenden Anschlussleitungen ICL sind in der zweiten Metalllage M2 gefertigt. Die gemeinsame Kathodenelektrode C des VCSEL-Laser-Array-Dies VCSELA ist ggf. bevorzugt in einer dritten Metalllage M3 gefertigt, in der sich auch die linken und rechten Kontaktflächen LCA1 bis LCAn und RCA1 und RCAn des Kondensator-Arrays CAP befinden, die mittels Durchkontaktierungen DK mit den Anschlussleitungen ICL verbunden sind. Die gemeinsame Kathodenelektrode C des VCSEL-Laser-Array-Dies VCSELA ist in der dritten Metalllage M3 isoliert von den linken und rechten Kontaktflächen LCA1 bis LCAn und RCA1 und RCAn des Kondensator-Arrays CAP von der zweiten Metalllage M2, der ersten Metalllage M1 und dem Substrat SUB gefertigt.

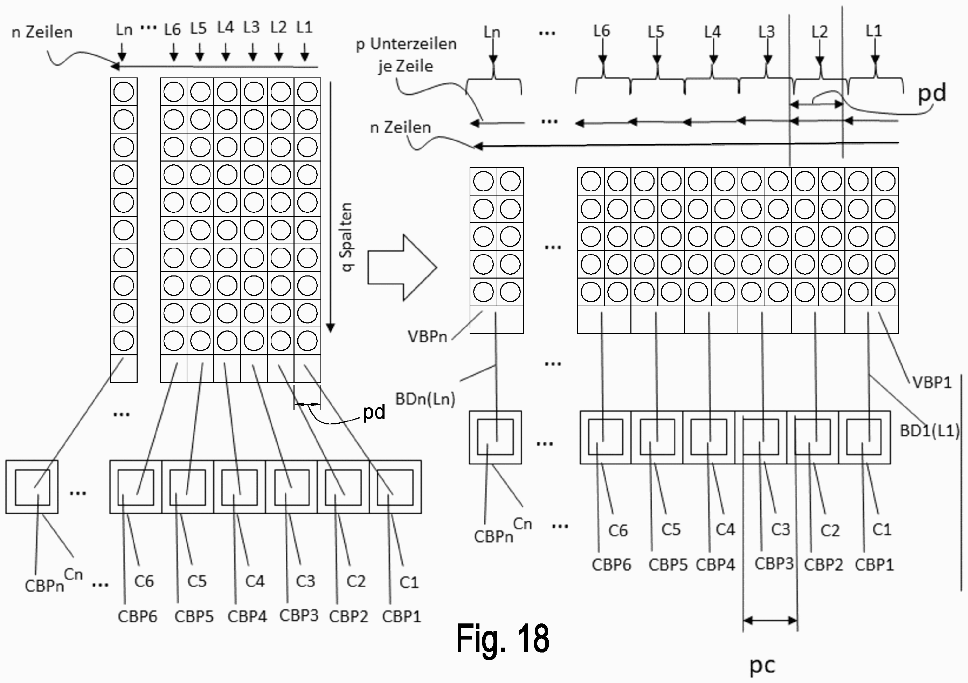

### HAUPTVARIANTE C (Fign. 18, rechter Teil, bis 25)

Die Erfindung betrifft ferner ein VCSEL-Laser-Modul mit einem ersten gemeinsamen Energiespeichersubstrat C_{L} und gegebenenfalls mit einem zweiten gemeinsamen Energiespeichersubstrat C_{R} sowie mit einem VCSEL-Laser-Array VCSELA und einer Treiberschaltung IC. Die Treiberschaltung IC weist dabei eine Oberfläche auf. Das erste gemeinsame Energiespeichersubstrat C_{L} ist auf vorzugsweise der Oberseite der Treiberschaltung IC montiert. Das zweite gemeinsame Energiespeichersubstrat C_{R} ist, wenn vorhanden, ebenfalls auf der Oberseite der Treiberschaltung IC montiert. Das VCSEL-Laser-Array VCSELA ist ebenso auf der Oberseite der Treiberschaltung IC neben dem ersten Energiespeichermodul C_{L} und, bei Vorhandensein des zweiten Energiespeichermoduls C_{R}, zwischen diesen beiden montiert. Das VCSEL-Laser-Array VCSELA emittiert bei Versorgung einer oder mehrerer VCSEL-Laserzeilen des VCSEL-Laser-Arrays VCSELA mit elektrischer Energie optische Strahlung in einer Richtung im Wesentlichen senkrecht zu dieser Oberfläche (Ober- oder Unterseite). Jeweils ein Energiespeicher des ersten gemeinsamen Energiespeichersubstrats C_{L} und/oder jeweils ein Energiespeicher des zweiten gemeinsamen Energiespeichersubstrats C_{R} versorgen eine oder mehrere VCSEL-Laserzeilen des VCSEL-Laser-Arrays VCSELA mit elektrischer Energie, damit dieses bzw. diese Licht emittieren. Dabei umfasst die Treiberschaltung IC Mittel, diese Energieentnahme aus den Energiespeichern zu steuern und/oder die Energiespeicher mit elektrischer Energie zu laden, was grundsätzlich aus WO-A-2021/140160 bekannt ist.

Fig. 13 zeigt eine erfindungsgemäße Vorrichtung VGV mit einer typischen Verschaltung einer weiteren Variante der LIDAR-Laser Anordnung einer oder mehrerer, beispielweise n als Streifen aus einer oder mehreren parallelen Reihen von VCSEL-Laserdioden ausgebildeten VCSEL-Laser L1 bis Ln, mit n als positiver ganzer Zahl größer 0. Diese Vorrichtung VGV kann zwecks besserer Übersichtlichkeit in n funktionale Gruppen FG1 bis FGn aufgeteilt werden. Jede der n funktionalen Gruppen FG1 bis FGn umfasst bevorzugt
- eine oder mehrere der n VCSEL-Laser L1 bis Ln der Vorrichtung VGV,
- genau einen der n Ladeschalter S1 bis Sn der Vorrichtung VGV,
- genau einen der n Energiespeicher C1 bis Cn der Vorrichtung VGV.

Jede der n funktionalen Gruppen FG1 bis FGn umfasst bevorzugt genau einen der n Zwischenknoten K1 bis Kn der Vorrichtung VGV.

In einer Aussendephase soll bevorzugt der mindestens eine VCSEL-Laser einer der n funktionalen Gruppen FG1 bis FGn einen Laserpuls aussenden. Bevorzugt sollen dabei die VCSEL-Laserzeilen der anderen n funktionalen Gruppen FG1 bis FGn keinen Laserpuls aussenden. Es ist aber auch denkbar (jedoch weniger bevorzugt), dass in einer Aussendephase m der VCSEL-Laserzeilen einer der n funktionalen Gruppen FG1 bis FGn einen Laserpuls aussenden, wobei m eine positive ganze Zahl kleiner n ist. Bevorzugt sollen dann die anderen n-m VCSEL-Laserzeilen anderer funktionaler Gruppen FG1 bis FGn keinen Laserpuls aussenden. Diese Beschreibung betrifft zur besseren Klarheit den Fall, dass m=1 ist, ohne die technische Lehre der Erfindung darauf zu beschränken.

Die Vorrichtung VGV umfasst bevorzugt eine Steuervorrichtung, die zur Vereinfachung in der Fig. 13 nicht gezeigt ist. Die Steuervorrichtung der erfindungsgemäßen Vorrichtung steuert die funktionalen Gruppen FG1 bis FGn.

Die Steuerung schließt in einer Ladephase, die der Aussendephase zeitlich vorausgeht, bevorzugt den Ladeschalter derjenigen funktionalen Gruppe FG1 bis FGn, deren VCSEL-Laser L1 bis Ln der Vorrichtung VGV in der typischerweise nachfolgenden Aussendephase einen Laserpuls aussenden soll. Hierbei lädt der Ladeschalter der betreffenden funktionalen Gruppe FG1 bis FGn die Energiereserve dieser funktionalen Gruppe, deren VCSEL-Laserzeile in der nachfolgenden Aussendephase einen Laser-Puls aussenden soll, mit elektrischer Energie aus der Versorgungsspannungsleitung VDD in der Ladephase.

Der Ladeschalter der betreffenden funktionalen Gruppen FG1 bis FGn bezieht die elektrische Energie zum Laden des Energiespeichers dieser funktionalen Gruppe aus der Versorgungsspannungsleitung VDD auf Versorgungsspannungspotenzial. Bei den n Ladeschaltern S1 bis Sn und damit auch bei dem Ladeschalter der betreffenden funktionalen Gruppe kann es sich auch um komplexe Schaltungen wie beispielsweise Stromquellen mit zugehörigen Diagnoseschaltungen etc. handeln. Insofern stellt die Fig. 13 bereits eine sehr grobe Vereinfachung zur Verdeutlichung des Funktionsprinzips dar. In diesem Zusammenhang sei verwiesen auf WO-A-2021/140160. Man kann also statt der n Ladeschalter S1 bis Sn der erfindungsgemäßen Vorrichtung VGV auch n Ladevorrichtungen vorsehen, die denjenigen Energiespeicher C1 bis Cn, der Teil ihrer jeweiligen funktionalen Gruppe ist, in der Ladephase zeitlich vor der Aussendephase entsprechend einem Aussendemuster mit Energie lädt, wenn in der nachfolgenden Aussendephase die jeweilige VCSEL-Laser L1 bis Ln, die der funktionalen Gruppe mit diesem Ladeschalter zugehörig ist, einen Laser-Puls entsprechend dem besagten Aussendemuster aussenden soll. Die elektrische Verbindung zwischen dem Zwischenknoten der funktionalen Gruppe und der Anode der VCSEL-Laserzeile dieser funktionalen Gruppe stellt die elektrische Bondverbindung der funktionalen Gruppe her. Diese elektrische Bondverbindung der funktionalen Gruppe ist eine von n elektrischen Bondverbindungen BD1 bis BDn der Vorrichtung VGV. Im Ersatzschaltbild der Fig. 13 verbindet die parasitäre elektrische Induktivität der funktionalen Gruppe den Zwischenknoten der betreffenden funktionalen Gruppe mit der Anode der VCSEL-Laserzeile der funktionalen Gruppe. Diese parasitäre Induktivität der Bondverbindung ist eine von n parasitären Induktivitäten L1 bis Ln der erfindungsgemäßen Vorrichtung VGV. Erfahrungsgemäß muss der Induktivitätswert der parasitären Induktivität jeder funktionalen FG1 bis FGn so klein wie möglich sein, damit die Anstiegsgeschwindigkeit der Intensität eines Laserpulses, den die VCSEL-Laserzeile dieser funktionalen Gruppe aussenden kann, so hoch wie möglich ist, um eines steile Anstiegsflanke des LaserPulses zu erhalten.

Bevorzugt sind alle funktionalen Gruppen in gleicher Weise aufgebaut und in gleicher Weise angeordnet, um die elektrischen Eigenschaften gleich zu halten. Bevorzugt sind monolithisch auf einem Halbleiterkristall oder in einem Substrat angeordnete Vorrichtungsteile der Vorrichtung VGV, die Teilvorrichtungen verschiedener funktionaler Gruppen sind, matchend ausgeführt. (siehe auch https://en.wikipedia.org/wiki/Integrated circuit design und https://de.wikipedia.org/wiki/Common-centroid-Layout)

Die Steuerung der Vorrichtung VGV veranlasst in einer Ladephase, die der Aussendephase zeitlich vorausgeht, bevorzugt die Ladeschalter derjenigen funktionalen Gruppen FG1 bis FGn, deren VCSEL-Laser L1 bis Ln in der typischerweise nachfolgenden Aussendephase keinen Laserpuls aussenden sollen, eine eventuell vorhandene Energiereserve dieser funktionalen Gruppe zu entladen.

Somit ist jeder der Ladeschalter S1 bis Sn der Vorrichtung VGV bevorzugt genau einer funktionalen Gruppen FG1 bis FGn zugeordnet. Damit ist bevorzugt jeder der Ladeschalter S1 bis Sn der Vorrichtung VGV genau einer der n VCSEL-Laser L1 bis Ln der Vorrichtung VGV und bevorzugt genau einem der n Energiespeicher C1 bis Cn der Vorrichtung VGV zugeordnet. Bevorzugt ist jeder der n VCSEL-Laser L1 bis Ln umgekehrt genau einer der n funktionalen Gruppen FG1 bis FGn und damit genau einem der n Ladeschalter S1 bis Sn und bevorzugt genau einem der n Energiespeicher C1 bis Cn zugeordnet. Ebenso ist bevorzugt jedem der n Energiespeicher C1 bis Cn genau einer der n funktionalen Gruppen FG1 bis FGn und damit genau einer der n Ladeschalter S1 bis Sn und genau einer der n VCSEL-Laser L1 bis Ln zugeordnet. D.h. genau einer der n-Ladeschalter S1 bis Sn und genau einer der n Energiespeicher C1 bis Cn und genau einen der n VCSEL-Laser L1 bis Ln und genau einer der n Zwischenknoten K1 bis Kn und genau eine der n elektrischen Bondverbindungen BD1 bis BDn und genau eines der n VCSEL-Bondpads VBP1 bis VBPn und genau eines der n Kondensator-Bondpads CBP1 bis CBPn bilden bevorzugt jeweils eine der n funktionalen Gruppen FG1 bis FGn (bzw. gehören zu dieser) der Vorrichtung VGV zum Aussenden eines Laserpulses. Jede der n elektrischen Bindeverbindungen BD1 bis BDn weist dabei eine jeweilige zugehörige parasitäre Induktivität auf, die somit dieser elektrischen Bondverbindung dieser betreffenden funktionalen Gruppe der n funktionalen Gruppen FG1 bis FGn zugeordnet ist. Jede der n funktionalen Gruppen FG1 bis FGn umfasst daher bevorzugt genau eine der n parasitären Induktivitäten L1 bis Ln der Vorrichtung VGV.

Bevorzugt verbindet genau einer der n Zwischenknoten K1 bis Kn der Vorrichtung VGV den ersten Anschluss eines der n Energiespeicher C1 bis Cn der Vorrichtung VGV, der der gleichen funktonalen Gruppe wie der Zwischenknoten zugehörig ist, zum einen mit dem betreffenden der n Ladeschalter S1 bis Sn, der Teil dieser funktionalen Gruppe ist, und zum anderen mit dem ersten Anschluss des betreffenden VCSEL-Lasers L1 bis Ln der Vorrichtung VGV, wobei diese VCSEL-Laserzeile ebenfalls Teil dieser funktionalen Gruppe ist. Diese Verbindung ist elektrisch leitend. Typischerweise ist derjenige der n Energiespeicher C1 bis Cn, der Teil dieser funktionalen Gruppe ist, mit seinem zweiten Anschluss mit dem Bezugspotenzial GND verbunden. Bevorzugt sind die Kathoden der n VCSEL-Laser L1 bis Ln mit einem gemeinsamen Entladesternpunkt Dis elektrisch verbunden.

Die in Fig. 13 zur besseren Übersicht nicht gezeigte Steuervorrichtung der Vorrichtung VGV kann den elektrische Entladesternpunkt Dis mittels eines Entladeschalters Tdis mit dem Bezugspotenzial einer Bezugspotenzialleitung GND verbinden. In dem hier beschriebenen Ausführungsbeispiel umfasst der Entladeschalter tatsächlich mehrere Teilentladeschalter mit Teilentladevorrichtungen, die die Aufgabe haben, für diejenige Gruppe FG1 bis FGn, deren VCSEL-Laserzeile einen Laserpuls aussenden soll, die wirksamen parasitären elektrischen Komponenten seitens des Entladeschalters Tdis ebenfalls zu minimieren.

Zu Beginn der Aussendephase beendet die in Fig. 13 nicht gezeigte Steuervorrichtung der Vorrichtung VGV das Laden der Energiespeicher derjenigen funktionalen Gruppen, deren VCSEL-Laserzeile jeweils einen Laser-Puls abgeben sollen. Bevorzugt schließt dann die Steuervorrichtung den Entladeschalter Tdis. Hierdurch sorgt die Steuervorrichtung für die elektrische Verbindung des Entladesternpunktes Dis mit dem Bezugspotenzial der Bezugspotenzialleitung GND. Der Energiespeicher derjenigen funktionalen Gruppe, deren VCSEL-Laserzeile einen Laser-Puls abgeben soll, entlädt sich dann über die parasitäre Induktivität und die VCSEL-Laserzeile dieser funktionalen Gruppe zur Bezugspotenzialleitung GND hin. Hierbei durchfließt ein elektrischer Entladestrom die VCSEL-Laserzeile dieser funktionalen Gruppe, die daraufhin einen Laser-Puls aussendet. Da die Energiespeicher derjenigen funktionalen Gruppen, deren VCSEL-Laserzeilen keinen Laser-Puls abgeben sollen, nicht geladen sind, können diese Energiespeicher sich dann auch nicht über die parasitäre Induktivität und die VCSEL-Laserzeile dieser funktionalen Gruppe zur Bezugspotenzialleitung GND hin entladen. Hierdurch durchfließt dann kein elektrischer Entladestrom die VCSEL-Laserzeile dieser funktionalen Gruppen und die VCSEL-Laserzeile senden somit dann auch keinen LaserPuls aus.

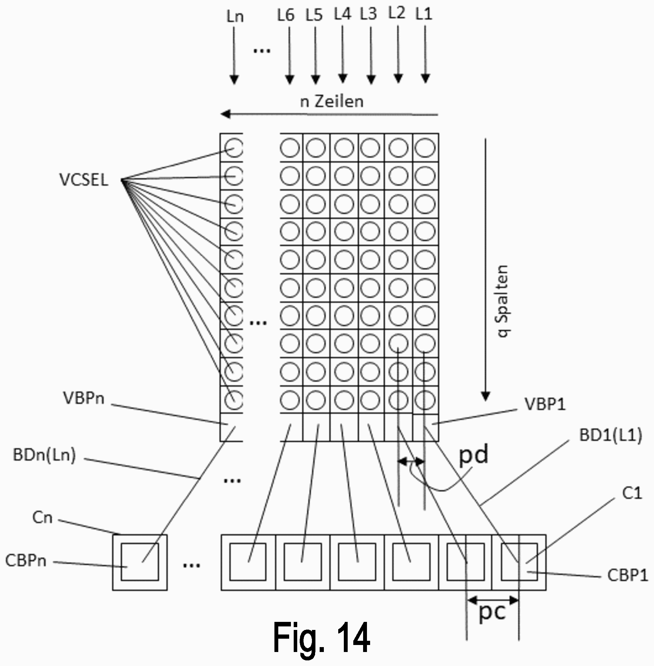

Fig. 14 zeigt eine typische Anordnung von n VCSEL-Lasern L1 bis Ln. Ein kleines, schwarzes Quadrat mit einem Kreis soll einen VCSEL-Laser symbolisieren. In dem Beispiel der Fig. 14 umfasst jede der n VCSEL-Laser L1 bis Ln q VCSEL-Laserdioden. Aufgrund der später noch beschriebenen VCSEL-Arrays ist das Substrat um 90° gedreht dargestellt, so dass die Zeilen senkrecht und die Spalten waagerecht verlaufen. Das skizzierte und vereinfacht schematisch dargestellte VCSEL-Laser-Array umfasst somit n Zeilen und q Spalten von VCSEL-Lasern VCSEL. Bevorzugt umfassen die VCSEL-Laser VCSEL-Laserdioden. Zur Vereinfachung sind nur die VCSEL-Laser VCSEL der n-ten VCSEL-Lasers Ln mit dem Bezugszeichen VCSEL versehen. Die VCSEL-Laser VCSEL jeder der n VCSEL-Laser L1 bis Ln sind bevorzugt elektrisch parallelgeschaltet. Ein jeweiliges VCSEL-Bondpad VBP1 bis VBPn des gezeigten VCSEL-Laser-Arrays versorgt somit bevorzugt die jeweiligen VCSEL-Laser VCSEL der jeweils zugehörigen Zeile der n VCSEL-Laser L1 bis Ln mit elektrischer Energie während der Entladung eines jeweils zugehörigen Energiespeichers C1 bis Cn über diese VCSEL-Laserzeile. Bevorzugt ist jeder der n VCSEL-Laser L1 bis Ln mit einem zugeordneten Energiespeicher der n Energiespeichern C1 bis Cn verbunden. Der betreffende jeweilige Energiespeicher und die betreffende VCSEL-Laserzeile sowie die betreffende elektrische Bondverbindung zwischen dem VCSEL-Bondpad dieser VCSEL-Laserzeile und dem Kondensator-Bondpad dieses Energiespeichers sind Teil der gleichen funktionalen Gruppe FG1 bis FGn der Vorrichtung VGV. Zur Vereinfachung der Darstellung sind in dem Beispiel der Fig. 14 nur das erste Kondensator-Bondpad CBP1 des ersten Energiespeichers C1 der ersten funktionalen Gruppe FG1, der erste Energiespeicher C1 der ersten funktionalen Gruppe FG1, die erste Bondverbindung BD1 und ihre erste parasitäre Induktivität Lp1 der ersten funktionalen Gruppe FG1, das erste VCSEL-Bondpad VBP1 des ersten VCSEL-Lasers L1 der ersten funktionalen Gruppe FG1 und der erste VCSEL-Laser L1 der ersten funktionalen Gruppe FG1 sowie das n-te Kondensator-Bondpad CBPn des n-ten Energiespeichers Cn der n-ten funktionalen Gruppe FGn, der n-te Energiespeicher Cn der n-ten funktionalen Gruppe FGn, die n-te Bondverbindung BDn und ihre n-te parasitäre Induktivität Lpn der n-ten funktionalen Gruppe FGn, das n-te VCSEL-Bondpad VBPn des n-ten VCSEL-Lasers Ln der n-ten funktionalen Gruppe FGm und der n-te VCSEL-Laser Ln der n-ten funktionalen Gruppe FGn gezeigt.

Die Energiespeicher sind in dem Beispiel der Fig. 14 als lineares Array von n bevorzugt gleich ausgeführten Energiespeichern C1 bis Cn ausgeführt. Bevorzugt weist daher jeder Energiespeicher C1 bis Cn im Wesentlichen die gleichen Abmessungen auf. Bevorzugt stimmen Höhe, Breite und Tiefe der Energiespeicher C1 bis Cn untereinander im Wesentlichen überein. Bevorzugt sind die n Energiespeicher C1 bis Cn in dem Beispiel der Fig. 14 als lineare Kette angeordnet. Dabei ist der Abstand pc (Englisch pitch) zwischen zwei benachbarten Energiespeichern der linearen Kette der n Energiespeicher C1 bis Cn für zwei beliebige unmittelbar benachbarte Energiespeicher C1 bis Cn bevorzugt im Wesentlichen stets gleich.

Die geometrischen Abmessungen der VCSEL-Laser VCSEL sind für alle n x q VCSEL-Laser VCSEL des VCSEL-Laser-Arrays bevorzugt im Wesentlichen gleich. Daher sind die Abstände pd (Englisch pitch) zweier beliebiger, unmittelbar benachbarter VCSEL-Laser L1 bis Ln innerhalb des Laser-Arrays typischerweise im Wesentlichen gleich.

Ein Problem entsteht nun dadurch, dass der Pitch pd der VCSEL-Laser L1 bis Ln typischerweise ein anderer, nämlich normalerweise kleinerer ist, als der Pitch pc der Energiespeicher C1 bis Cn. Hierdurch erstreckt sich die Aneinanderreihung der Energiespeicher C1 bis Cn über eine größere Strecke als die Aufeinanderfolge der VCSEL-Laser L1 bis Ln, wodurch sich die Längen der n Bondverbindungen BD1 bis BDn der Vorrichtung VGV unterscheiden. Dies hat zur Folge, dass die n parasitären Induktivitäten Lp1 bis Lpn dieser n Bondverbindungen BD1 bis BDn ebenfalls unterschiedlich sind. Hierdurch sind die Anstiegszeiten der abgestrahlten Intensitäten der verschiedenen VCSEL-Laser L1 bis Ln unterschiedlich, was zu inhomogenen Ergebnissen führt.

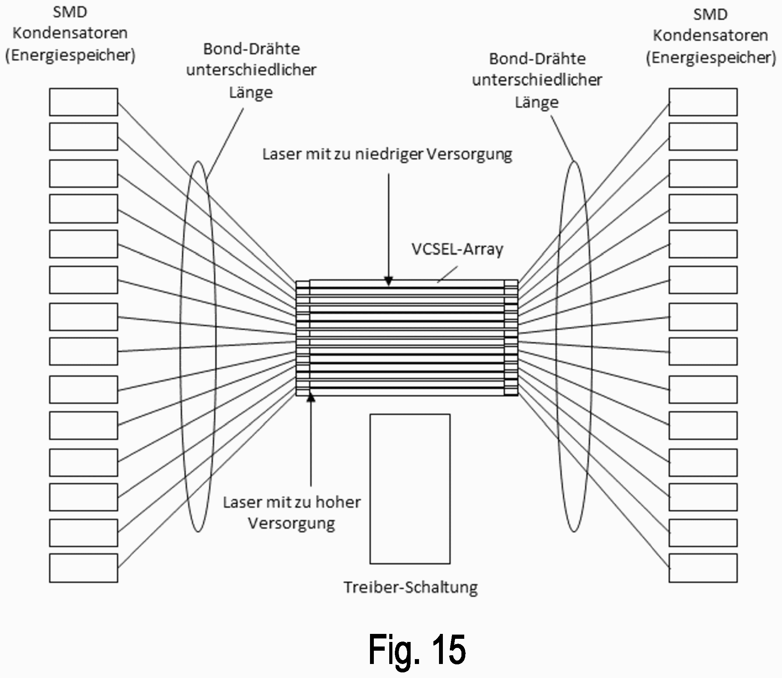

Ein weiteres Problem der zuvor beschriebenen Anordnung verdeutlicht Fig. 15. Um die Anbindung der VCSEL-Laserzeilen zu verbessern, werden diese nicht einseitig mit einem VCSEL-Bondpad angeschlossen, sondern beidseitig über jeweils einen VCSEL-Bondpad, die im Folgenden als linkes VCSEL-Bondpad und rechtes VCSEL-Bondpad bezeichnet werden. Neben den unterschiedlich langen Bondverbindungen zwischen den Energiespeichern und den VCSEL-Laserzeilen kommt nun noch hinzu, dass die Länge der Verbindung zwischen einer VCSEL-Laserzeile und dem Entladetransistor Tdis unterschiedlich lang ist, wenn diese neben dem VCSEL-Laser-Array platziert wird. Die VCSEL-Laserzeile, die der Treiber-Schaltung am nächsten liegt "sieht" die geringsten ohmschen Verluste und den geringsten Induktivitätsbelag auf der Leitung zwischen dem Entladeschalter Tdis und der VCSEL-Laserzeile. Die VCSEL-Laserzeile, die am entferntesten zum Entladeschalter Tdis liegt, "sieht" die höchsten ohmschen Verluste und den höchsten Induktivitätsbelag auf der Leitung zwischen dem Entladeschalter Tdis und der VCSEL-Laserzeile. Somit ist die VCSEL-Laserzeile, die am weitesten entfernt liegt, diejenige mit der geringsten Auflösung und Reichweite.

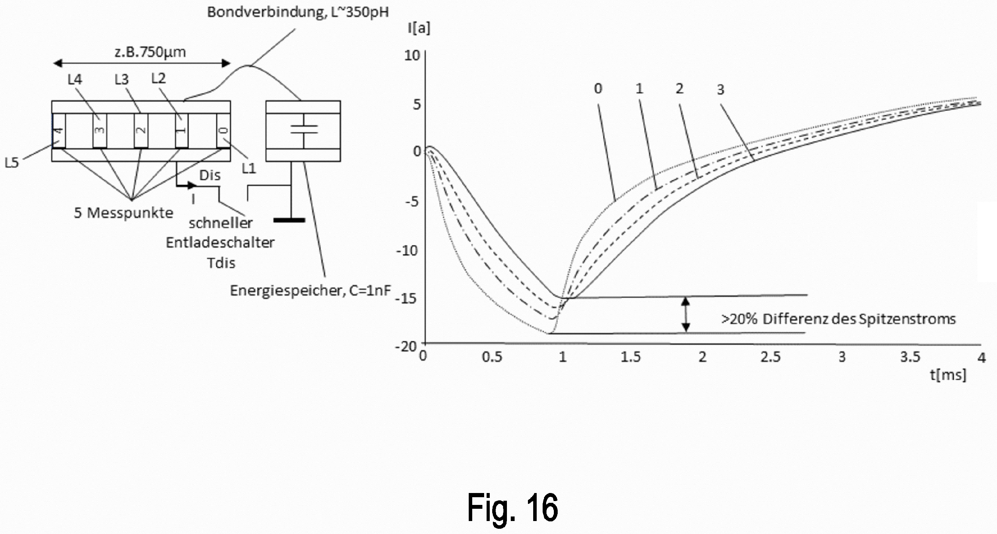

Fig. 16 verdeutlicht das Problem der unterschiedlichen Lichtpulsintensität und -steilheit am vereinfachten Beispiel der Einspeisung des Stromes zum Betrieb einer VCSEL-Laserzeile mit fünf VCSEL-Lasern L1 bis L5. Der schnelle Entladeschalter Tdis verbindet den Entladesternpunkt Dis mit der Bezugspotenzialleitung. Hierdurch entlädt er die Energiereserve in Form der Kapazität gegen das Bezugspotenzial der Bezugspotenzialleitung GND mit dem Strom I. Je nachdem, wo (bezogen auf die Aufeinanderfolge von VCSEL-Lasern) die Leitung zwischen Entladeschalter Tdis der VCSEL-Laserzeile mit der VCSLE-Laserzeile elektrisch verbunden ist, ändert sich die Anstiegsgeschwindigkeit und der Spitzenwert der Intensität der Abstrahlung eines VCSEL-Lasers. Dies kann zu einer Differenz von mehr als 20% im Spitzenwert der Intensität der Abstrahlung des Laser-Pulses führen. Die Fig. 16 stellt beispielhaft die Ergebnisse einer entsprechenden Simulation dar.

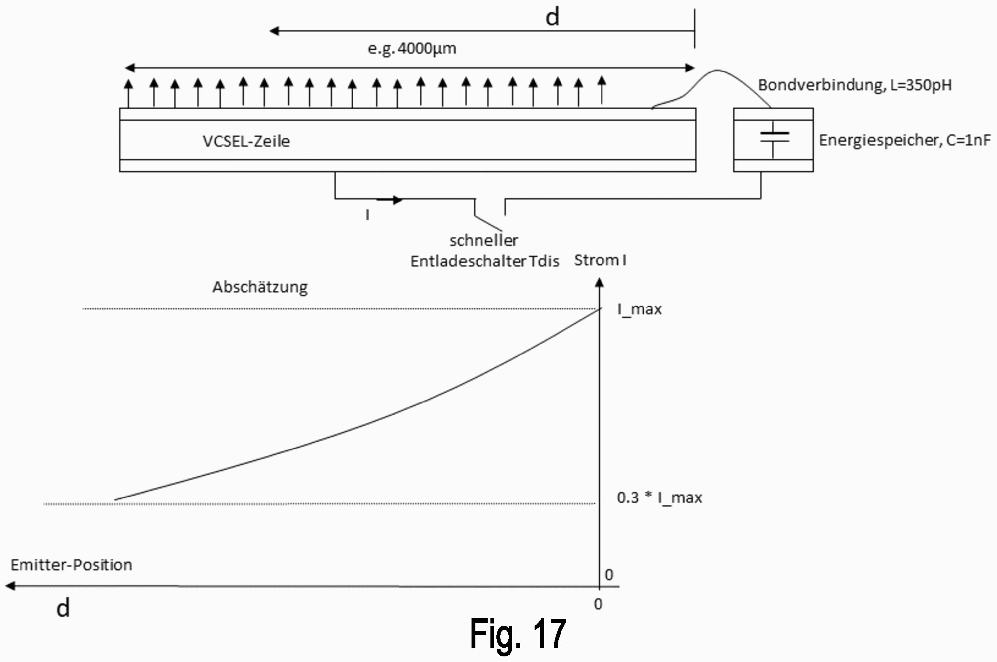

Ähnlich wie in Fig. 16 stellt Fig. 17 die Änderung des Stromes durch einen VCSEL-Laser in Abhängigkeit von dessen Entfernung von dem Stromeinspeisepunkt (typischerweise das VCSEL-Bondpad) dar. Erschreckenderweise muss mit einem Abfall der Stromstärke auf bis zu 30% gerechnet werden, was für die Brauchbarkeit verheerend ist.

Fig. 18 zeigt einen Teil des erfindungsgemäßen Ansatzes, bei dem der Pitch pc der Energiespeicher C1 bis Cn und der Pitch pd der VCSEL-Laserzeilen aufeinander abgestimmt sind. In Fig. 18 ist links die Anordnung entsprechend der Fig. 14 gezeigt. Wie oben erläutert, weichen somit in der links gezeigten Konstruktion die Längen der Bondverbindungen zwischen den jeweiligen Kondensatoren-Bondpads CBP1 bis CBPn der n Energiespeicher C1 bis Cn einerseits und den VCSEL-Bondpads VBP1 bis VBPn andererseits erheblich untereinander ab.

Die rechte Teilfigur zeigt den erfindungsgemäßen Lösungsansatz. Die VCSEL-Laserzeilen umfassen nun mehrere, beispielsweise p VCSEL-Laser-Unterzeilen. Dabei soll p eine ganze positive Zahl größer 0 sein. Für p gleich 1 ergäbe sich typischerweise wieder das in der rechten Teilfigur dargestellte Problem. Daher ist p bevorzugt größer 1. In dem Beispiel der Fig. 18 ist in der rechten Teilfigur p gleich 2. D.h. In diesem Beispiel der Fig. 18 umfasst jede VCSEL-Laserzeile also zwei VCSEL-Laser-Unterzeilen. Die Anzahl p der VCSEL-Laser-Unterzeilen ist aber nicht auf zwei beschränkt, sondern kann auch andere Anzahlen von VCSEL-Laser-Unterzeilen umfassen. Bevorzugt ist die Anzahl an VCSEL-Laser-Unterzeilen für mehrere und bevorzugt für alle VCSEL-Laserzeilen gleich. Hierdurch vergrößert sich der Pitch pd der VCSEL-Laserzeilen um den Faktor p. Dies ermöglicht es, den Pitch der VCSEL-Laserzeilen an den Pitch pd der Energiespeicher anzugleichen. Falls erforderlich, können noch bestehende kleinere Unterschiede durch entsprechende Beabstandung der Energiespeicher untereinander oder der VCSEL-Laserzeilen untereinander ausgeglichen werden. Wie leicht erkennbar ist, gleicht sich dadurch auch die Länge der Bondverbindungen BD1 bis BDn an. In Folge dessen gleichen sich auch die Werte der parasitären Induktivitäten L1 bis Ln dieser Bondverbindungen BD1 bis BDn der verschiedenen funktionalen Gruppen FG1 bis FGn aneinander an. Hierdurch gleichen sich auch die Anstiegszeiten und die Spitzenwerte der Intensitäten der Abstrahlungen der verschiedenen VCSEL-Laser L1 bis Ln aneinander an. Um im Falle der beiden Konstruktionen links und rechts der Fig. 18 die gleiche Abstrahlleistung zu erzeugen (gleiche Anzahl an VCSEL-Laser), sind rechts nun nur noch q/p VCSEL-Laser-Spalten erforderlich, was die Zuleitungslänge und damit die Unterschiede der parasitären Zuleitungswiderstände der VCSEL-Laser einer gemeinsamen VCSEL-Laserzeile weiter vermindert.

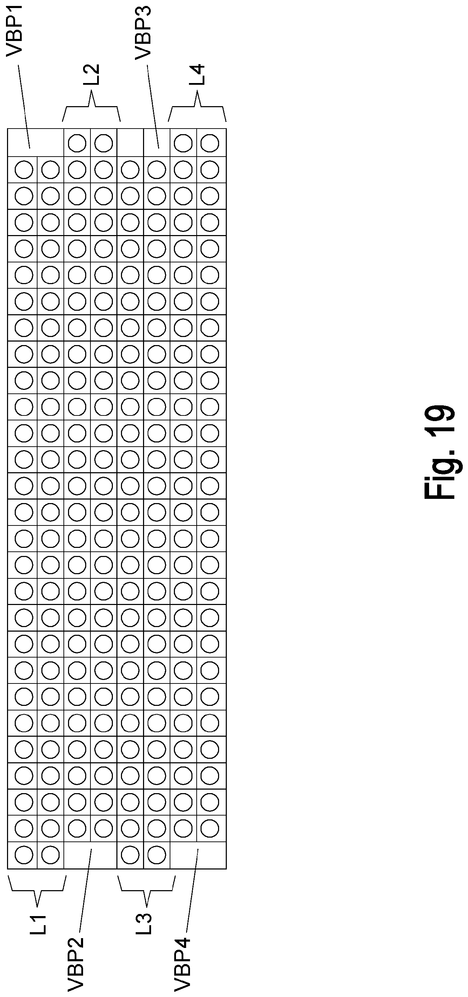

Fig. 19 stellt ein leicht verändertes Prinzip der Anordnung verschiedener VCSEL-Laserzeilen und der diesen zugeordneten Energiespeicher dar. In dem Beispiel der Fig. 19 sind beispielhaft n gleich 4 VCSEL-Laser L1 bis L4 dargestellt, die jede für sich jeweils zwei VCSL-Unterzeilen aufweist. Die korrespondierenden VCSEL-Bondpads VBP1 bis VBP4 sind alternierend links und rechts angeordnet. Die VCSEL-Laser L1 und L3 mit den ungeraden Zeilennummern 1 und 3 werden in dem Beispiel der Fig. 19 von rechts angeschlossen. Die VCSEL-Laser L2 und L4 mit den geraden Zeilennummern 2 und 4 werden in dem Beispiel der Fig. 19 von links angeschlossen. Über das erste VCSEL-Bondpad VBP1 wird der erste VCSEL-Laser L1 elektrischer Energie versorgt, während über das zweite VCSEL-Bondpad VBP2 der zweite VCSEL-Laser L2 mit elektrischer Energie versorgt wird. Über das dritte VCSEL-Bondpad VBP3 wird der dritte VCSEL-Laser L3 mit elektrischer Energie versorgt, während über das vierte VCSEL-Bondpad VBP4 der vierte VCSEL-Laser L4 mit elektrischer Energie versorgt wird.

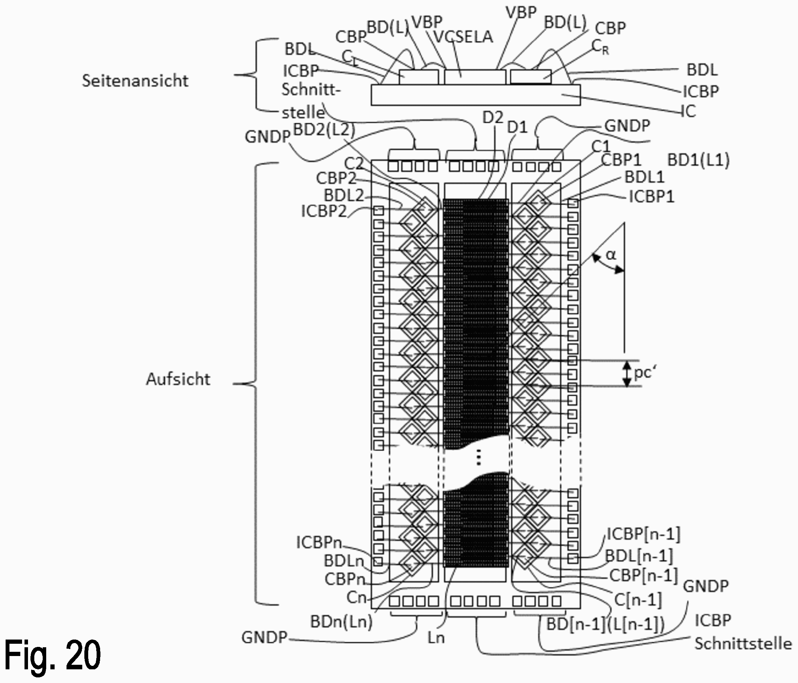

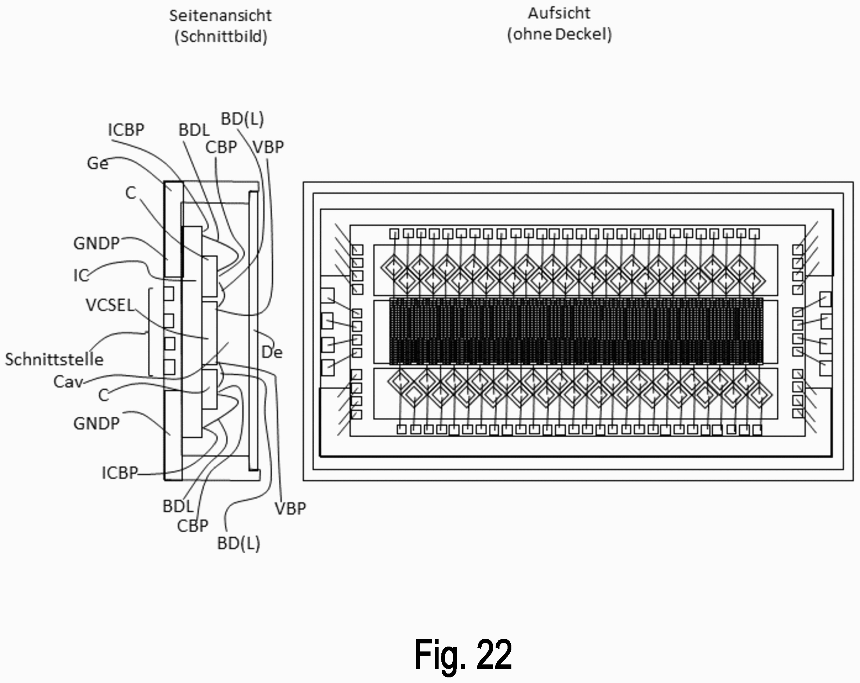

Fig. 20 zeigt eine erfindungsgemäße Vorrichtung VGV. In der Mitte befindet sich das als zeichnerische Darstellung nur unzureichend auflösbare VCSEL-Array der n VCSEL-Laser L1 bis Ln. Analog zu dem Anschlussprinzip, wie es in der Fig. 19 beispielhaft für n gleich 4 VCSEL-Laser L1 bis L4 dargestellt ist, werden gemäß Fig. 20 die VCSEL-Laserzeilen der n VCSEL-Laser L1 bis Ln, die ungerade Zeilennummern haben, von der rechten Seite und die VCSEL-Laserzeilen der n VCSEL-Laser L1 bis Ln, die gerade Zeilennummern haben, von der linken Seite angeschlossen (siehe auch die diesen wechselseitigen Anschluss der VCSEL-Zeilen L1 bis Ln besser verdeutlichende Fig. 22, linker Teil "Die Stack"). Im Gegensatz zur Anordnung der rechten Teilfigur der Fig. 18 und zur Fig. 14 sind die Energiespeicher nun jedoch nicht als lineare Kette von Energiespeichern ausgeführt. Vielmehr werden die Energiespeicher C1 bis Cn nun zwar weiterhin mit dem Pitch pc der Energiespeicher C1 bis Cn angeordnet. Die Anordnung der Energiespeicher erfolgt nun aber so, dass die Energiespeicher zu Energiespeichergruppen von m Energiespeichern, die innerhalb einer Gruppe linear in einer Energiespeichergruppenkette angeordnet sind, zusammengefasst werden. Diese Energiespeichergruppenketten sind nun nicht mehr parallel zur Längskante des VCSEL-Arrays ausgerichtet, sondern um einen Winkel a=90°-(90°/m) aus dieser Parallelen herausgeschwenkt. Die nächste Energiegruppenspeicherkette ist dann in einem geänderten Pitch pc'=m*cos(a)*pc von der vorausgehenden Energiegruppenspeicherkette platziert. Im Beispiel der Fig. 20 bedeutet das, dass für beispielhaft m gleich 2 die Energiespeichergruppenkette einen ersten Energiespeicher und einen zweiten Energiespeicher umfassen, die um a=45° aus der Senkrechten geschwenkt sind. Der Abstand dieser Energiespeichergruppenketten liegt dann bei $pc ′ = \sqrt{2} * pc$.

Der Nachteil dieser Anordnung ist, dass die Länge zwischen zwei benachbarten Bondverbindungen sich um ΔI=pc*sin(a) und zwischen zwei beliebigen Bondverbindungen um maximal ΔI=m*pc*sin(a) unterscheidet.

Gemäß Fig. 20 wird also vorgeschlagen, eine erste Hälfte der Energiespeicher mit geraden Nummern C2 bis Cn in einem ersten gemeinsamen Energiespeichersubstrat C_{L} auf der linken Seite des VCSEL-Arrays VCSELA der n VCSEL-Laser L1 bis Ln zu platzieren und eine zweite Hälfte der Energiespeicher mit ungeraden Nummern C1 bis C(n-1) in einem zweiten gemeinsamen Energiespeichersubstrat C_{R} auf der rechten Seite des VCSEL-Arrays VCSELA zu platzieren, wobei n eine ganze gerade positive Zahl ist. Dies ermöglicht eine Halbierung des effektiv wirksamen Pitches der Energiespeicher, da das erste gemeinsame Energiespeichersubstrat C_{L} um einen Wert $pc " = \left(1/\sqrt{2}\right) * pc$ parallel zur Längskante des VCSEL-Arrays VCSELA gegenüber dem zweiten gemeinsamen Energiespeichersubstrat C_{R} verschoben platziert sein kann.

Bevorzugt handelt es sich bei dem ersten Energiespeichersubstrat C_{L} um ein Kondensator-Array, das n/2 Kondensatoren (z.B. die oben erwähnten Energiespeicher C2 bis Cn mit den geraden Nummern) umfasst. Bevorzugt handelt es sich bei dem zweiten Energiespeichersubstrat C_{R} um ein Kondensator-Array, das ebenfalls n/2 Kondensatoren (z.B. de oben erwähnten Energiespeicher C1 bis C(n-1) mit den ungeraden Nummern) umfasst.

Bevorzugt sind das Substrat des ersten gemeinsamen Energiespeichersubstrats C_{L} und das Substrat des VCSEL-Laser-Arrays VCSELA und das Substrat des zweiten gemeinsamen Energiespeichersubstrats C_{R} auf die Oberfläche (bevorzugt Oberseite) der Treiberschaltung IC aufgesetzt. Die Treiberschaltung IC ist bevorzugt eine mikrotechnisch hergestellte mikroelektronische Schaltung. Bevorzugt ist die Treiberschaltung IC eine CMOS Schaltung. Bevorzugt umfasst die Treiberschaltung IC die Ladeschalter S1 bis Sn und die Teilentladeschalter des Entladeschalters Tdis und die Steuervorrichtung zur Ansteuerung der Vorrichtung VGV. Bevorzugt weist die Treiberschaltung ein oder mehrere Schnittstellen auf. Bevorzugt weist die Treiberschaltung IC eine Vielzahl von Anschlüssen GNDP für die Bezugspotenzialleitung GND auf. Bevorzugt ist die Treiberschaltung IC anreihbar gestaltet, so dass eine zweite nachfolgende Treiberschaltung beispielsweise an den Schmalseiten (bezogen auf die Darstellung in Fig. 20 oben und/oder unten) eine kreuzungsfreie Verbindung der Schnittstellen und eine kreuzungsfreie Verbindung der Anschlüsse GNDP der Bezugspotenzialleitung GND mittels Bonddrähten ermöglicht. Bevorzugt ist jeweils ein Ladeschalter der Treiberschaltung mit genau einem Kondensator-Bondpad über eine Bondverbindung elektrisch verbunden. Die Vorrichtung VGV der Fig. 20 weist n solcher Bondverbindungen BDL1 bis BDLn auf. Auch deren Länge variiert nur gering.

Fig. 20 zeigt das Modul der erfindungsgemäßen Vorrichtung VGV in Aufsicht und im Querschnitt.

Der Vorteil der Vorrichtung der Fig. 20 ist, dass die elektrischen Verbindungen extrem kurz sind und dass daher die Werte der parasitären Induktivitäten, Kapazitäten und Widerstände ebenfalls sehr klein sind.

Besonders vorteilhaft ist, dass bei einer Anordnung entsprechend der Fig. 20 der Entladeschalter Tdis in der Treiberschaltung IC unmittelbar unter dem VCSEL-Array VCSELA platziert werden kann, wodurch die Induktivität dieser Zuleitung praktisch keine Rolle mehr spielt. Die Ladeschalter S1 bis Sn können beispielsweise in der Treiberschaltung IC unter dem gemeinsamen Energiespeichersubstrat C_{L} und unter dem zweiten gemeinsamen Energiespeichersubstrat C_{R} platziert werden.

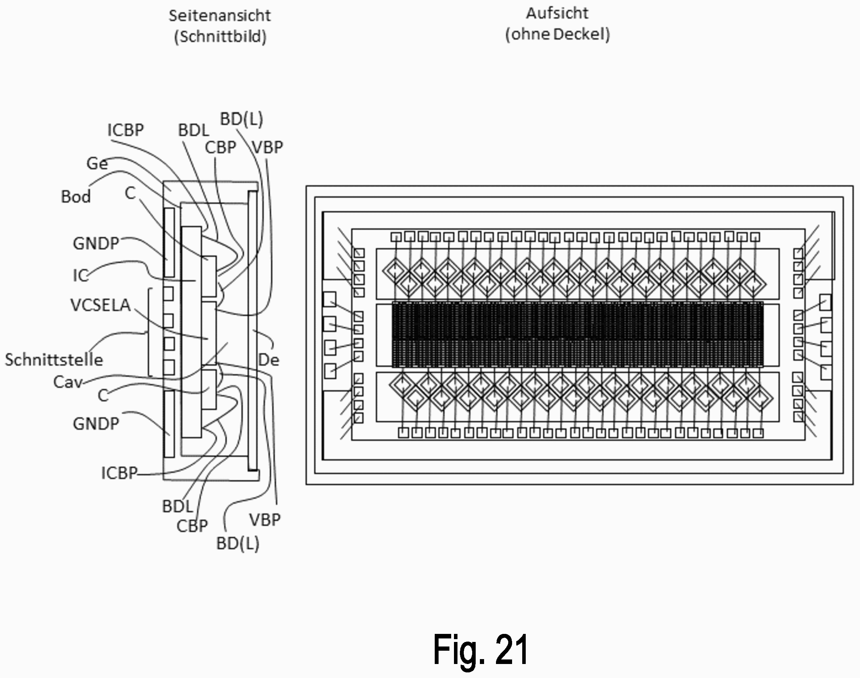

Fig. 21 zeigt ein Gehäuse Ge für ein Modul der Fig. 20. Das Gehäuse Ge weist eine Kavität Cav auf, in die das Modul der Fig. 20 eingesetzt ist. Das Gehäuse Ge weist einen Boden Bod auf, auf den das Modul der Fig. 20 aufgesetzt und/oder aufgeklebt und/oder auf andere Weise befestigt ist. Bevorzugt ist dieses Modul mit der Unterseite der Treiberschaltung IC auf dem Boden Bod in die Kavität Cav des Gehäuses Ge eingebaut. Bevorzugt ist das Modul aus Treiberschaltung IC, erstem gemeinsamen Energiespeichersubstrat C_{L}, VCSEL-Laser-Array VCSELA und zweitem gemeinsamen Energiespeichersubstrat C_{R}, mit der Unterseite der Treiberschaltung IC auf dem Boden Bod in die Kavität Cav des Gehäuses Ge eingeklebt oder eingelötet. Bevorzugt sind die Anschlüsse GNDP für die Bezugspotenzialleitung als Masseplatten des Lead-Frames des Gehäuses Ge ausgeführt. Bevorzugt sind die Anschlüsse GNDP für die Bezugspotenzialleitung als Exposed-Die-Pads des Gehäuses Ge ausgeführt. Das bedeutet, dass an der Unterseite des Gehäuses Ge diese Montageflächen des Leadframes des Gehäuses Ge bevorzugt frei liegen, um eine gute Wärmeabfuhr zu ermöglichen. Bevorzugt weist also das Gehäuse Ge zumindest ein Exposed Die-Pad für den Anschluss der Bezugspotenzialleitung GNDP auf. Dies ermöglicht außerdem eine verbesserte Wärmeabfuhr. Bevorzugt ist die Kavität Cav des Gehäuses Ge mit einem Deckel De verschlossen, der optisch transparent für eine Strahlung der VCSEL-Laser L1 bis Ln des VCSEL-Laser-Arrays VCSELA ist. Bevorzugt ist der Deckel De auf eine umlaufende Einkerbung der Gehäusewand des Gehäuses Ge am oberen Ende der Kavität Cav aufgesetzt.

Die Fig. 22 entspricht weitestgehend der Fig. 21 mit dem Unterschied, dass die Exposed Die-Pads der Bezugspotenzialleitung GNDP nun soweit vergrößert sind, als sie auch an den Längsseiten des Gehäuses einen Meniskus bei einer Lötung ausbilden können und daher nun besonders gut optisch inspizierbar sind.

Fig. 23 zeigt das VCSEL-Laser-Modul der Fign. 8 bis 10, wobei nun gezeigt werden soll, wie der Entladeschalter Tdis (siehe Fig. 13) in mehrere, nämlich r Treiberzellen DRC1 bis DRCr unterteilt ist, die miteinander parallelgeschaltet sind. Jeder der r Treiberzellen DRC1 bis DRCr ist dabei ein Bondpad-Anschluss DRP1 bis DRPr zugeordnet, der die elektrische Verbindung zwischen dem Entladesternpunkt Dis der Vorrichtung VGV und der Rückseite des VCSEL-Arrays VCSELA und damit zu den Kathoden der VCSEL-Laser L1 bis Ln herstellt. Besonders vorteilhaft ist die Platzierung dieser Bondpad-Anschluss DRP1 bis DRPr und der Treiberzellen DRC1 bis DRCr direkt unter dem VCSEL-Laser-Array VCSELA. Hierdurch ist die entsprechende elektrische Verbindung besonders kurz. Dies führt zu sehr geringen parasitären kapazitiven, ohmschen und induktiven Belägen dieses Leitungsstücks, was sich sehr positiv auf die Schaltzeiten auswirkt, die hierdurch wesentlich verkürzt sind. Bevorzugt werden die Ladeschalter S1 bis Sn unter dem ersten gemeinsamen Energiespeichersubstrat C_{L} und unter dem zweiten gemeinsamen Energiespeichersubstrat C_{R} und zwar möglichst nahe an den zugehörigen Bondpad-Anschlüssen ICBP1 bis ICBPn der jeweiligen Ladeschalter S1 bis Sn platziert.

Fig. 24 zeigt eine beispielhafte Verschaltung der Treiberzellen DRC1 bis DRCr. Die Bondpad-Anschlüsse DRP1 bis DRPr kontaktieren typischerweise Bereiche der Rückseite des VCSEL-Laser-Arrays VCSELA. Die Teilentladetransistoren Tdis1 bis Tdisr bilden in diesem Ausführungsbeispiel als (Gesamt-)Transistoren den Entladeschalter Tdis der Fig. 13. Jeder der Teilentladetransistoren Tdis1 bis Tdisr ist mit einem von r Gate-Treibern DRV1 bis DRVr der Vorrichtung VGV versehen, der die Steuerleitung des jeweiligen Teilentladetransistors Tdis1 bis Tdisr ansteuert. Eine Versorgungsspannungsleitung VDD und die Bezugspotenzialleitung GND versorgen jeden der Teilentladetransistoren Tdis1 bis Tdisr mit elektrischer Energie. Sobald der zugehörige Gate-Treiber DRV1 bis DRVr seinen Schaltzustand ändert, kommt es zu einem Spannungsabfall auf der Versorgungsspannungsleitung VDD und der Bezugspotenzialleitung GND. Um diesen Spannungsabfall zu minimieren, ist jedem der r Gate-Treiber DRV1 bis DRVr eine jeweilige Stützkapazität Cs1 bis Csr zugeordnet, die zwischen die Versorgungsspannungsleitung VDD und der Bezugspotenzialleitung GND geschaltet ist und mit möglichst kurzen Leitungslängen mit dem Abzapfungspunkt der Versorgungsleitungen für den zugeordneten Gate-Treiber DRV1 bis DRVr elektrisch verbunden ist. Dies führt dazu, dass der betreffende Gate-Treiber, wenn er eingeschaltet wird, lediglich in geringerem Maße von parasitischen kapazitiven, induktiven und ohmschen Leitungsbelägen der Versorgungsspannungsleitung VDD und der Bezugspotenzialleitung GND beeinflusst wird, und zwar weitaus weniger als ohne diese Maßnahme, da der Stützkondensator ausreichen Energie in der Einschaltphase an den Gate-Treiber liefert.

Bevorzugt sind die Steuerleitungen sämtlicher Teiltransistoren Tdis 1 bis Tdisr über eine gemeinsame Steuerleitung GATE miteinander verbunden, an die auch die Ausgänge aller Gate-Treiber DRV1 bis DRVr angeschossen sind. Die gleichmäßige Verteilung der Treiber DRC1 bis DRCr unter dem elektrischen Rückseitenkathodenkontakt des VCSEL-Laser-Arrays VCSELA verhindert im Wesentlichen, dass sich die Einschaltvorgänge der VCSL-Laser L1 bis Ln unterscheiden, da die Stützkondensatoren Cs1 bis Csr und die Segmentierung des Entladetransistors Tdis in die r Teilentladetransistoren Tdis1 bis Tdisr sowie die Zuordnung eines jeweiligen Gate-Treibers DRV1 bis DRVr zu genau einem dieser r Teilentladetransistoren Tdis1 bis Tdisr sicherstellt, dass sich die Ansteuerung hinsichtlich der wirkenden parasitären Elemente von VCSEL-Laserzeile zu VCSEL-Laserzeile nicht wesentlich unterscheidet.

Über das Signal GATE_IN_1 signalisiert die Steuervorrichtung der Vorrichtung, dass der Entladeschalter Tdis geschlossen werden soll. Ein Buffer BUF verstärkt das Signal GATE_IN_1 zum Signal GATE_IN_2. Jeder der Gate-Treiber DRV1 bis DRVr steuert dann in Abhängigkeit von dem Signal GATE_IN_2 das Steuersignal des diesem Gate-Treiber zugeordneten Teilentladetransistors Tdis1 bis Tdisr separat an, wobei der diesem Gate-Treiber zugeordnete Stützkondensator Cs1 bis Csr einen Spannungseinbruch der Versorgungsspannung zwischen dem Potenzial der Versorgungsspannungsleitung VDD und dem Potenzial der Bezugsspannungsleitung GND zunächst verhindert. Bevorzugt sind die r Stützkondensatoren Cs1 bis Csr als MOS-Transistoren in dem Substrat bzw. auf dem Substrat der Treiberschaltung IC ausgebildet.

Bevorzugt umfasst also ein solcher vorgeschlagener Treiber DRC der r Treiber DRC1 bis DRCr jeweils einen Bondpad-Anschluss DRP1 bis DRPr, jeweils einen der r Teilentladetransistoren Tdis1 bis Tdisr, jeweils einen der r Gate-Treiber DRV1 bis DRVr und jeweils einen der r Stützkondensatoren Cs1 bis Csr. Bevorzugt sind der Entladesternpunkt Dis und die Versorgungsspannungsleitung und die Bezugspotenzialleitung und das Steuersignal GATE für die Steueranschlüsse der r Teilentladetransistoren Tdis1 bis Tdisr und das Signal GATE_IN_2 sämtlicher der r Treiber DRC1 bis DRCr gemeinsam. Bevorzugt sind die Leitungslängen für das Signal GATE_IN_2, der Versorgungsspannungsleitung VDD und der Massepotenzialleitung GND von jeweils einem Punkt des jeweiligen Netzes gleich lang, so dass diese Leitungslängen nur eine stets gleiche Verzögerung verursachen.

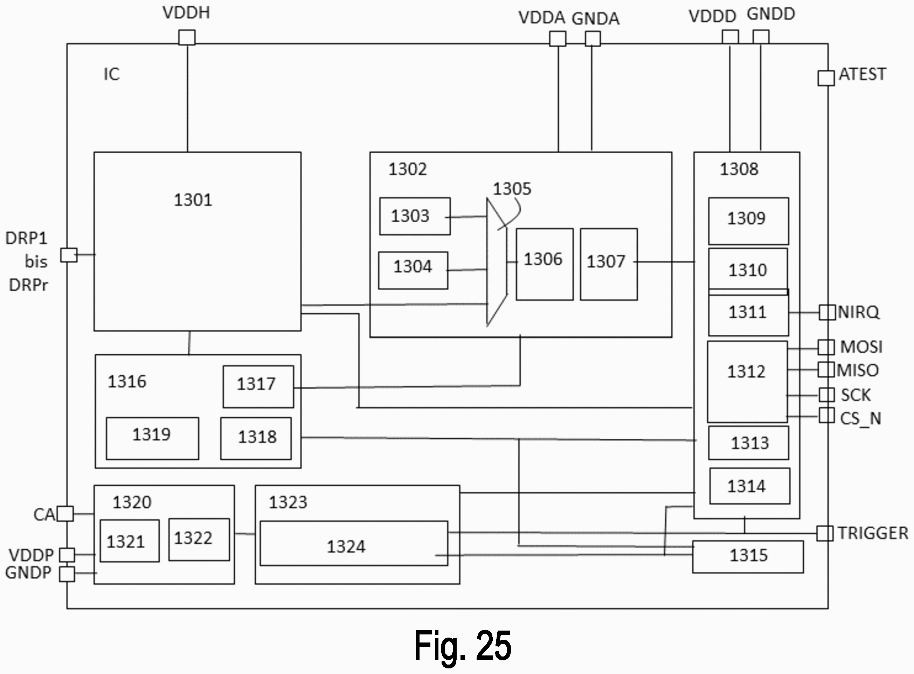

Fig. 25 zeigt ein vereinfachtes und schematisches Blockschaltbild einer beispielhaften Treiber-Schaltung IC für die Vorrichtung VGV.

Die Fig. 25 zeigt den Block 1301 mit den r Treibern DRC1 bis DRCr zur Ansteuerung der VCSEL-Laser L1 bis Ln des VCSEL-Laser-Arrays VCSELA über die r Bondpad-Anschlüsse DRP1 bis DRPr, die sich bevorzugt auf der Oberseite der Treiberschaltung IC als freie Bondflächen oder dergleichen befinden und auf die der gemeinsame den Entladesternpunkt DIS bildende Kathodenrückseitenkontakt der n VCSEL-Laser L1 bis Ln aufgesetzt elektrisch leitend und kontaktierend wird. Der Digitalteil 1308 der Treiberschaltung IC steuert bevorzugt den Block 1301 mit den r Treibern DRC1 bis DRCr und damit die Ansteuerung der VCSEL-Laser L1 bis Ln des VCSEL-Laser-Arrays VCSELA. Der Monitoring-Block 1302 erfasst Spannungspegel innerhalb des Blocks 1301 mit den r Treibern DRC1 bis DRCr. Außerdem umfasst der Monitoring-Block 1302 vorzugsweise eine Überwachung der Spannungswandlung 1303 und eine Temperaturüberwachung 1304. Mittels eines analogen Multiplexers 1305 kann der Digitalteil 1308 der Treiberschaltung IC deren Ausgänge und die Messleitungen für die Erfassung von Spannungspegeln innerhalb des Blocks 1301 mit den r Treibern DRC1 bis DRCr wahlweise auf den Eingang eines Analog-zu-Digital-Wandlers 1307 legen. Um Störungen durch Rauschen und andere Einflüsse zu minimieren, ist bevorzugt eine Abtastschaltung (Englisch Sample &Hold) 1306 bevorzugt zwischen den Ausgang des Analogmultiplexers 1305 und den Eingang des Analog-zu-Digital-Wandlers 1307 geschaltet, die bevorzugt von dem Digitalteil 1308 der Treiberschaltung IC gesteuert wird. Der Digitalteil 1308 wertet die durch den Analog-zu-Digital-Wandler 1307 erfassten Daten bevorzugt aus. Bevorzugt umfasst der Digitalteil 1308 eine Kontrollvorrichtung und Steuervorrichtung 1309, die bevorzugt einen Mikrocontroller und/oder einen endlichen Automaten umfasst. (Englisch: Finite-State-Machine). Des Weiteren umfasst der Digitalteil 1308 der Treiber-Schaltung IC bevorzugt eine Testlogik 1310, die den Fertigungstest der Treiberschaltung IC in der Halbleiterproduktion erlaubt. Darüber hinaus sollte diese Testlogik 1310 geeignet sein, gezielt die Erzeugung eines Laserpulses durch einen vorbestimmten der n VCSEL-Laser L1 bis Ln mittels eines Testdatenbefehls beispielsweise über die Testschnittstelle ATEST zu initiieren, so dass ein Test des späteren VCSEL-Laser-Moduls (z.B. entsprechend Fig. 22) möglich ist. Bevorzugt verfügt der Digitalteil 1308 über einen Diagnoseeingang bzw. eine Diagnoseschnittstelle 1311 über die der Digitalteil 1308 Diagnosedaten mit anderen externen Systemkomponenten austauschen kann. Bevorzugt kann der Diagnoseteil 1311 ein Interrupt-Signal NIRQ erzeugen und/oder empfangen. Bevorzugt verfügt der Digitalteil 1308 über eine SPI und/oder eine JTAG-Datenschnittstelle oder andere Datenschnittstellen 1312, um Daten mit der "Außenwelt" austauschen zu können. Der Digitalteil 1308 erzeugt je nach Betriebszustand verschiedene Registerinformationen, die verschiedene Fehlerfälle verschiedener Vorrichtungsteile der Treiberschaltung IC betreffen. Liegen beispielsweise Spannungswerte der Treiberzellen DRC1 bis DRCr, die der Analog-zu-Digitalwandler 1307 ermittelt hat, nicht innerhalb vorbestimmter und/oder ermittelter Erwartungswertintervalle, die zu dem derzeitigen Betriebszustand der Treiberschaltung IC passen, so kann der Digitalteil 1308 auf einen Fehler schließen, eine entsprechende Information in einem Register 1313 ablegen und über die Interrupt-Leitung NIRQ einen Interrupt eines externen Prozessors auslösen, der daraufhin die Daten über die Datenschnittstelle 1312 ausliest. Umgekehrt kann der externe Prozessor über das Einschreiben von Daten in die Register 1313 die Konfiguration und das Verhalten der Treiberschaltung IC vorzugsweise beeinflussen. Bevorzug umfasst der Digitalteil 1308 der Treiberschaltung IC auch einen oder mehrere flüchtige und/oder nicht-flüchtige Speicher. Flüchtige Speicher sind dabei beispielsweise RAMs und/oder SRAMS und/oder DRAMS oder dergleichen. Nicht flüchtige Speicher sind beispielsweise Flash-Speicher oder dergleichen.

Des Weiteren umfasst die Treiberschaltung IC bevorzugt einen Oszillator und/oder ein Taktsystem 1315 zur Versorgung der Schaltungen der Treiber-Schaltung IC mit dem Systemtakt und ggf. anderen Takten.

Neben diesen Komponenten umfasst die Treiberschaltung IC bevorzugt ein oder mehrere Spannungswandler und eine oder mehrere Referenzerzeugungen 1316. Beispielswiese kann die Treiberschaltung IC eine Bandgap-Schaltung 1317 umfassen, um eine Referenzspannung und/oder einen Referenzstrom insbesondere für die Analogteile der Treiberschaltung IC zu erzeugen.

Auch umfasst die Treiberschaltung bevorzugt eine Reset-Schaltung 1218, die untervorgegebenen Bedingungen die Treiberschaltung IC und/oder Teile derselben in einen jeweils vordefinierten neuen Startzustand bringt. Eine solche vorbestimmte Bedingung kann das Einschalten der Betriebsspannung oder ein Software-Befehl über eine Datenschnittstelle oder das Signal eines Zeitgebers (Watchdog-Timers) sein. Bevorzugt umfasst die Treiberschaltung IC einen solchen Watchdog-Timer. Bevorzugt umfasst die Treiberschaltung IC eine Spannungserzeugung 1319 für ein virtuelles Massepotenzial für die Massepotenzialleitung GND der VCSEL-Laser L1 bis Ln. Es ist nämlich vorteilhaft, wenn die Bezugspotenzialleitung GND der VCSEL-Laser L1 bis Ln von Störungen auf einer der Massezuleitungen GNDA, GNDD, GNDP unabhängig ist. Bevorzugt umfasst die Treiberschaltung IC einen Low-Drop-Spannungswandler 1320 zur Erzeugung interner Versorgungsspannungen. Bevorzugt umfasst der Low-Drop Spannungswandler 1320 einen N-Kanal-Transistor 1321, der als Pass-Element des Spannungswandlers dient, und eine entsprechende Treiberschaltung 1322 für den N-Kanal-Feldeffekt-Transistor 1321 des Low-Drop-Treibers 1320, die die externe Eingangsspannung von einem vorbestimmten Wert innerhalb der Treiberschaltung IC mittels geeigneter Ansteuerung des N-Kanal-Feldeffekt-Transistors 1321 regelt.

Bevorzugt umfasst die Treiberschaltung IC eine Teilvorrichtung 1323, die eine Schaltung zur Schärfung des Pulses ist. Der Digitalteil 1308 steuert bevorzugt diese Teilvorrichtung 1323. Bevorzugt können eine DLL 1324 und ein Digital-zu-Analog-Wandler ein TriggerSignal TRIGGER erzeugen, das andere Schaltungen synchronisieren kann. Je nach Konfiguration kann das Signal TRIGGER auch als Eingang für den Empfang und die Weiterverarbeitung eines solchen Synchronisationssignals genutzt werden.

Die erfindungsgemäße Vorrichtung zeichnet sich somit dadurch aus, dass sie sehr kleine Induktivitäten bei gleichzeitig hoher Montagedichte und Kompaktheit des Aufbaus bietet. Außerdem führen die gegenläufigen Entladeströme I_{dis} zu einer verringerten elektromagnetischen Störstrahlung, was die Induktivitäten weiter verringert. Der verringerte Bauraum ist ein weiterer Vorteil. Durch die kurzen im Wesentlichen gleich langen Bondverbindungen und die unmittelbare Kontaktierung zwischen einem Anschluss des Entladetransistors Tdis und dem Entladesternpunkt Dis sind die Einflüsse parasitischer Leitungsbeläge wie ohmsche, kapazitive und/oder induktive Leitungsbeläge besonders stark minimiert. Die Vorteile sind hierauf aber nicht beschränkt.

Die nachfolgende Auflistung der Erfindung fassen die Merkmale der Erfindung und deren Weiterbildungen nochmals zusammen. Anwendungen der technischen Lehre können die Merkmale miteinander kombinieren, sofern diese Kombinationen nicht sachliche Widersprüche verursachen. Insofern stellen die hier vorgestellten Abhängigkeiten und Bezüge nur besonders bevorzugte, beispielhafte Ausführungsformen dar.
1. Lichtmodul LM,
   - wobei das Lichtmodul LM einen Träger umfasst und
   - wobei das Lichtmodul LM ein Kondensator-Array CAP umfasst und
   - wobei das Lichtmodul ein VCSEL-Laser-Array-Die VCSELA umfasst und
   - wobei der Träger eine Oberseite aufweist und
   - wobei der Träger an seiner Oberseite eine elektrisch leitfähige und elektrisch kontaktierbare Masse-Fläche GNDP aufweist und
   - wobei das VCSEL-Laser-Array-Die VCSELA eine Oberseite und eine Unterseite aufweist und
   - wobei das VCSEL-Laser-Array-Die VCSELA n VCSEL-Laser L1 bis Ln, mit n als ganzer positiver Zahl größer 0, aufweist und
   - wobei das VCSEL-Laser-Array-Die VCSELA eine linke Reihe von n elektrisch kontaktierbaren linken Laser-Kontaktflächen LA1 bis LAn an seiner Oberfläche aufweist und
   - wobei das VCSEL-Laser-Array-Die VCSELA eine rechte Reihe von n elektrisch kontaktierbaren rechten Laser-Kontaktflächen RA1 bis RAn an seiner Oberfläche aufweist und
   - wobei die Anode jedes Lasers der VCSEL-Laser L1 bis Ln des VCSEL-Laser-Array-Dies (VCSELA mit einer jeweiligen linken Kontaktfläche der linken Reihe von n Laser-Kontaktflächen LA1 bis LAn elektrisch verbunden ist und
   - wobei die Anode jedes Lasers der VCSEL-Laser L1 bis Ln des VCSEL-Laser-Array-Dies VCSELA mit einer jeweiligen rechten Kontaktfläche der rechten Reihe von n Laser-Kontaktflächen LA1 bis LAn elektrisch verbunden ist und
   - wobei das VCSEL-Laser-Array-Die VCSELA einen gemeinsamen Kathodenkontakt an seiner Unterseite aufweist und
   - wobei die Kathode jedes Lasers der VCSEL-Laser L1 bis Ln des VCSEL-Laser-Array-Dies VCSELA mit diesem gemeinsamen Kathodenkontakt an der Unterseite des VCSEL-Laser-Array-Dies VCSELA elektrisch verbunden ist und
   - wobei die VCSEL-Laser L1 bis Ln des VCSEL-Laser-Array-Dies VCSELA einen fünften Abstand PTLa zueinander aufweisen und
   - wobei das Kondensator-Array CAP eine Oberseite und eine Unterseite aufweist und
   - wobei das Kondensator-Array CAP einen oder mehrere Kondensatoren C1 bis Cn umfasst und
   - wobei das Kondensator-Array CAP ein Substrat SUB umfasst und
   - wobei das Kondensator-Array CAP einen elektrisch kontaktierbaren Substratkontakt SUBC an seiner Unterseite aufweist und
   - wobei das Kondensator-Array CAP n Kondensatoren C1 bis Cn mit n als ganzer positiver Zahl größer 0 umfasst und
   - wobei das Kondensator-Array CAP eine Kathodenelektrode C an seiner Oberseite in einer dritten Metalllage M3 aufweist und
   - wobei das Kondensator-Array CAP eine linke Reihe von elektrisch kontaktierbaren linken Kontaktflächen LC1 bis LCn an seiner Oberfläche aufweist und
   - wobei das Kondensator-Array CAP eine rechte Reihe von elektrisch kontaktierbaren rechten Kontaktflächen LC1 bis LCn an seiner Oberfläche aufweist und
   - wobei das Kondensator-Array CAP für jeden der Kondensatoren C1 bis Cn jeweils genau eine obere Kondensatorelektrode te aufweist und
   - wobei jede Kondensatorelektrode te zusammen mit dem Material des Substrats SUB in dem Bereich des Kondensator-Array CAP, der im Wesentlichen durch die Ausdehnung der Kondensatorelektrode te bestimmt ist, und zusammen mit dem Substratkontakt SUBC bzw. der unteren Kondensatorelektrode be den ihm zugeordneten jeweiligen Kondensator C1 bis Cn des Kondensator-Arrays CAP bildet und
   - wobei die oberen Kondensatorelektroden te in einer ersten Metalllage M1 auf dem Substrat SUB gefertigt sind und
   - wobei die n oberen Kondensatorelektroden und damit die n Kondensatoren C1 bis Cn des Kondensator-Arrays CAP in j Zeilen und k Spalten im Substrat SUB des Kondensator-Arrays CAP angeordnet sind, wobei j*k=m gilt und wobei j und k positive ganze Zahlen sind, und
   - wobei die Zeilen der Kondensatoren C1 bis Cn in einer Zeile des Kondensator-Arrays CAP einen zweiten Abstand PTCY aufweisen und
   - wobei das Kondensator-Array CAP m Anschlussleitungen ICL in einer zweiten Metalllage M2, mit m als ganzer positiver Zahl, aufweist und
   - wobei die Anschlussleitungen ICL parallel zu den Zeilen der Kondensatoren C1 bis Cn ausgerichtet sind und
   - wobei der vierte Abstand PTCC der Anschlussleitungen ICL untereinander dem zweiten Abstand PTCY der Zeilen der Kondensatoren C1 bis Cn geteilt durch die Anzahl der Spalten der Kondensatoren C1 bis Cn entspricht und
   - wobei der fünfte Abstand PTLa um nicht mehr als 25% und/oder nicht mehr als 10% und/oder nicht mehr als 5% und/oder nicht mehr als 2% und/oder nicht mehr als 1% vom vierten Abstand PTCC abweicht und
   - wobei die dritte Metalllage M3 sich oberhalb der zweiten Metalllage M2 und der ersten Metalllage M1 auf der Oberfläche des Substrats SUB befindet und
   - wobei die zweite Metalllage M2 sich oberhalb der ersten Metalllage M1 und unterhalb der dritten Metalllage M3 auf der Oberfläche des Substrats SUB befindet und
   - wobei die dritte Metalllage M3 von der zweiten Metalllage M2 und der ersten Metalllage M1 und dem Substrat SUB durch eine Isolation INS elektrisch isoliert ist und
   - wobei die zweite Metalllage M2 von der ersten Metalllage M1 und dem Substrat SUB durch eine Isolation INS oder die Isolation INS elektrisch isoliert ist und
   - wobei Anschlussleitungen ICL der m Anschlussleitungen ICL jede jeweils für sich zumindest eine jeweilige Kondensatorelektrode te eines dieser Anschlussleitung ICL zugeordneten Kondensators der Kondensatoren C1 bis Cn über eine jeweilige Durchkontaktierung DK elektrisch mit einer jeweiligen linken Kontaktfläche der linken Reihe von elektrisch kontaktierbaren linken Kontaktflächen LC1 bis LCn des Kondensator-Arrays CAP und mit einer jeweiligen rechten Kontaktfläche der rechten Reihe von elektrisch kontaktierbaren rechten Kontaktflächen RC1 bis RCn des Kondensator-Arrays CAP elektrisch verbindet und
   - wobei linke Kontaktflächen der linken Reihe von n linken Laser-Kontaktflächen LA1 bis LAn des VCSEL-Laser-Array-Dies VCSELA jede jeweils für sich mit einer jeweiligen linken Kontaktfläche der linken Reihe von elektrisch kontaktierbaren linken Kontaktflächen LC1 bis LCn des Kondensator-Arrays CAP elektrisch verbunden sind und
   - wobei rechte Kontaktflächen der linken Reihe von n rechten Laser-Kontaktflächen RA1 bis RAn des VCSEL-Laser-Array-Dies VCSELA jede jeweils für sich mit einer jeweiligen rechten Kontaktfläche der rechten Reihe von elektrisch kontaktierbaren rechten Kontaktflächen RC1 bis RCn des Kondensator-Arrays CAP elektrisch verbunden sind und
   - wobei der gemeinsame Kathodenkontakt des VCSEL-Laser-Array-Dies VCSELA auf der Kathodenelektrode C des Kondensator-Arrays CAP aufgesetzt ist und mit der Kathodenelektrode C des Kondensator-Arrays CAP elektrisch und mechanisch fest verbunden ist und
   - wobei der Substratkontakt SUBC des Kondensator-Arrays CAP auf der Massefläche GNDP aufgesetzt ist und mit der Massefläche GNDP elektrisch und mechanisch fest verbunden ist.
2. Lichtmodul nach Ziffer 1,
   - wobei das Lichtmodul LM eine Treiberschaltung IC umfasst und
   - wobei die Treiberschaltung IC eine Oberseite und eine Unterseite aufweist und
   - wobei die Treiberschaltung IC einen Entladetransistor T_{DIS} umfasst und
   - wobei der Entladetransistor T_{DIS} einen ersten Anschluss GNDT des Entladetransistors T_{DIS} aufweist und
   - wobei der Entladetransistor T_{DIS} einen zweiten Anschluss CT des Entladetransistors T_{DIS} aufweist und
   - wobei der Entladetransistor T_{DIS} einen Steueranschluss aufweist und
   - wobei der Entladetransistor T_{DIS} in Abhängigkeit von dem elektrischen Zustand des Steueranschlusses seinen ersten Anschluss GNDT von seinem zweiten Anschluss CT elektrisch isolieren kann oder seinen ersten Anschluss GNDT mit seinem zweiten Anschluss CT elektrisch verbinden kann und
   - wobei der erste Anschluss GNDT des Entladetransistors T_{DIS} mit der Massefläche GNDP elektrisch verbunden ist und
   - wobei der zweite Anschluss CT des Entladetransistors T_{DIS} mit der Kathodenelektrode C elektrisch verbunden ist und
   - wobei die Treiberschaltung IC mit Ihrer Unterseite auf der Oberfläche des Trägers befestigt ist.
3. Lichtmodul nach Ziffer 2,
   - wobei die Treiberschaltung mittels einer Ladeschaltung SUPL die Kondensatoren C1 bis Cn des Kondensator-Arrays CAP mit einem elektrischen Ladestrom laden kann, wenn der Entladetransistor T_{DIS} sperrt.
4. Lichtmodul nach Ziffer 3,
   - wobei Vorrichtungsteile der Treiberschaltung IC und/oder eine andere elektrische Schaltung, die an dem Träger befestigt sind oder Teil des Trägers sind, den Steueranschluss des Entladetransistors T_{DIS} so ansteuern können, dass der Entladetransistor T_{DIS} die Kondensatoren C1 bis Cn des Kondensator-Arrays CAP über die jeweiligen VCSEL-Laser L1 bis Ln des VCSEL-Laser-Array-Die VCSELA, die diesen Kondensatoren C1 bis Cn des Kondensator-Arrays CAP zugeordnet sind, mittels jeweiligen Laser spezifischen Entladeströmen I_{dis} entlädt und
   - wobei dann die VCSEL-Laser L1 bis Ln des VCSEL-Laser-Array-Dies VCSELA, die ein Entladestrom I_{dis} durchströmt, senkrecht zur Oberfläche des VCSEL-Laser-Array-Dies VCSELA Licht emittieren.
5. Lichtmodul nach einer der Ziffern 1 bis 4, wobei der Träger eine gedruckte Schaltung PCB oder einen Kühlkörper HS umfasst.
6. Lichtmodul LM,
   - wobei das Lichtmodul LM einen Träger umfasst und
   - wobei das Lichtmodul LM ein Kondensator-Array CAP umfasst und
   - wobei das Lichtmodul ein VCSEL-Laser-Array-Die VCSELA umfasst und
   - wobei der Träger eine Oberseite aufweist und
   - wobei der Träger an seiner Oberseite eine elektrisch leitfähige und elektrisch kontaktierbare Masse-Fläche GNDP aufweist und
   - wobei das VCSEL-Laser-Array-Die VCSELA eine Oberseite und eine Unterseite aufweist und
   - wobei das VCSEL-Laser-Array-Die VCSELA n VCSEL-Laser L1 bis Ln, mit n als ganzer positiver Zahl größer 0, aufweist und
   - wobei das VCSEL-Laser-Array-Die VCSELA eine linke Reihe von n elektrisch kontaktierbaren linken Laser-Kontaktflächen LA1 bis LAn an seiner Oberfläche aufweist und
   - wobei das VCSEL-Laser-Array-Die VCSELA eine rechte Reihe von n elektrisch kontaktierbaren rechten Laser-Kontaktflächen RA1 bis RAn an seiner Oberfläche aufweist und
   - wobei die Anode jedes Lasers der VCSEL-Laser L1 bis Ln des VCSEL-Laser-Array-Dies VCSELA mit einer jeweiligen linken Kontaktfläche der linken Reihe von n Laser-Kontaktflächen LA1 bis LAn elektrisch verbunden ist und
   - wobei die Anode jedes Lasers der VCSEL-Laser L1 bis Ln des VCSEL-Laser-Array-Dies VCSELA mit einer jeweiligen rechten Kontaktfläche der rechten Reihe von n Laser-Kontaktflächen LA1 bis LAn elektrisch verbunden ist und
   - wobei das VCSEL-Laser-Array-Die VCSELA einen gemeinsamen Kathodenkontakt an seiner Unterseite aufweist und
   - wobei die Kathode jedes Lasers der VCSEL-Laser L1 bis Ln des VCSEL-Laser-Array-Dies VCSELA mit diesem gemeinsamen Kathodenkontakt an der Unterseite des VCSEL-Laser-Array-Dies VCSELA elektrisch verbunden ist und
   - wobei die VCSEL-Laser L1 bis Ln des VCSEL-Laser-Array-Dies VCSELA einen fünften Abstand PTLa zueinander aufweisen und
   - wobei das Kondensator-Array CAP eine Oberseite und eine Unterseite aufweist und
   - wobei das Kondensator-Array CAP ein Substrat SUB umfasst und
   - wobei das Kondensator-Array CAP einen elektrisch kontaktierbaren Substratkontakt SUBC an seiner Unterseite aufweist und
   - wobei das Kondensator-Array CAP n Kondensatoren C1 bis Cn mit n als ganzer positiver Zahl größer 0 umfasst und
   - wobei das Kondensator-Array CAP eine linke Reihe von elektrisch kontaktierbaren linken Kontaktflächen LC1 bis LCn an seiner Oberfläche aufweist und
   - wobei das Kondensator-Array CAP eine rechte Reihe von elektrisch kontaktierbaren rechten Kontaktflächen LC1 bis LCn an seiner Oberfläche aufweist und
   - wobei das Kondensator-Array CAP für jeden der Kondensatoren C1 bis Cn jeweils genau eine obere Kondensatorelektrode te aufweist und
   - wobei jede Kondensatorelektrode te zusammen mit dem Material des Substrats SUB in dem Bereich des Kondensator-Array CAP, der im Wesentlichen durch die Ausdehnung der Kondensatorelektrode te bestimmt ist, und zusammen mit dem Substratkontakt SUBC den ihr zugeordneten jeweiligen Kondensator der Kondensatoren C1 bis Cn des Kondensator-Arrays CAP bildet und
   - wobei die oberen Kondensatorelektroden te in einer ersten Metalllage M1 auf dem Substrat SUB gefertigt sind und
   - wobei die n oberen Kondensatorelektroden und damit die n Kondensatoren C1 bis Cn des Kondensator-Arrays CAP in j Zeilen und k Spalten im Substrat SUB des Kondensator-Arrays CAP angeordnet sind, wobei j*k=m gilt und wobei j und k positive ganze Zahlen sind, und
   - wobei die Zeilen der Kondensatoren C1 bis Cn in einer Zeile einen zweiten Abstand PTCY aufweisen und
   - wobei das Kondensator-Array CAP m Anschlussleitungen ICL in einer zweiten Metalllage M2, mit m als ganzer positiver Zahl, aufweist und
   - wobei die Anschlussleitungen ICL parallel zu den Zeilen der Kondensatoren C1 bis Cn ausgerichtet sind und
   - wobei der vierte Abstand PTCC der Anschlussleitungen ICL untereinander dem zweiten Abstand PTCY geteilt durch die Anzahl k der Spalten der Kondensatoren C1 bis Cn entspricht und
   - wobei der fünfte Abstand PTLa um nicht mehr als 25% und/oder nicht mehr als 10% und/oder nicht mehr als 5% und/oder nicht mehr als 2% und/oder nicht mehr als 1% vom vierten Abstand PTCC abweicht und
   - wobei die zweite Metalllage M2 sich oberhalb der ersten Metalllage auf der Oberfläche des Substrats SUB befindet und
   - wobei die zweite Metalllage M2 von der ersten Metalllage M1 und dem Substrat SUB durch eine Isolation INS oder die Isolation INS elektrisch isoliert ist und
   - wobei jede Anschlussleitung ICL der m Anschlussleitungen ICL zumindest eine jeweilige Kondensatorelektrode te eines dieser Anschlussleitung ICL zugeordneten Kondensators der Kondensatoren C1 bis Cn über eine jeweilige Durchkontaktierung DK elektrisch mit einer jeweiligen linken Kontaktfläche der linken Reihe von elektrisch kontaktierbaren linken Kontaktflächen LC1 bis LCn des Kondensator-Arrays CAP und mit einer jeweiligen rechten Kontaktfläche der rechten Reihe von elektrisch kontaktierbaren rechten Kontaktflächen RC1 bis RCn des Kondensator-Arrays CAP elektrisch verbindet und
   - wobei jede linke Kontaktfläche der linken Reihe von n linken Laser-Kontaktflächen LA1 bis LAn des VCSEL-Laser-Array-Dies VCSELA mit einer jeweiligen linken Kontaktfläche der linken Reihe von elektrisch kontaktierbaren linken Kontaktflächen LC1 bis LCn des Kondensator-Arrays CAP über eine Lot-Kugel SB elektrisch und mechanisch fest verbunden ist und
   - wobei jede rechte Kontaktfläche der linken Reihe von n rechten Laser-Kontaktflächen RA1 bis RAn des VCSEL-Laser-Array-Dies VCSELA mit einer jeweiligen rechten Kontaktfläche der rechten Reihe von elektrisch kontaktierbaren rechten Kontaktflächen RC1 bis RCn des Kondensator-Arrays CAP über eine Lot-Kugel SB elektrisch und mechanisch fest verbunden ist und
   - wobei der gemeinsame Kathodenkontakt des VCSEL-Laser-Array-Dies VCSELA eine Kathodenelektrode C bildet und
   - wobei der Substratkontakt SUBC des Kondensator-Arrays CAP auf der Massefläche GNDP aufgesetzt ist und mit der Massefläche GNDP elektrisch und mechanisch fest verbunden ist.
7. Lichtmodul nach Ziffer 6,
   - wobei das Lichtmodul LM eine Treiberschaltung IC umfasst und
   - wobei die Treiberschaltung IC eine Oberseite und eine Unterseite aufweist und
   - wobei die Treiberschaltung IC einen Entladetransistor T_{DIS} umfasst und
   - wobei der Entladetransistor T_{DIS} einen ersten Anschluss GNDT des Entladetransistors T_{DIS} aufweist und
   - wobei der Entladetransistor T_{DIS} einen zweiten Anschluss CT es Entladetransistors T_{DIS} aufweist und
   - wobei der Entladetransistor T_{DIS} einen Steueranschluss aufweist und
   - wobei der Entladetransistor T_{DIS} in Abhängigkeit von dem elektrischen Zustand des Steueranschlusses zwischen seinem ersten Anschluss GNDT und seinem zweiten Anschluss CT elektrisch isolieren kann oder zwischen seinem ersten Anschluss GNDT und seinem zweiten Anschluss CT elektrisch leitend sein kann und
   - wobei der erste Anschluss GNDT des Entladetransistors T_{DIS} mit der Massefläche GNDP elektrisch verbunden ist und
   - wobei der zweite Anschluss CT des Entladetransistors T_{DIS} mit der Kathodenelektrode C elektrisch verbunden ist und
   - wobei die Treiberschaltung IC mit Ihrer Unterseite auf der Oberfläche des Trägers befestigt ist.
8. Lichtmodul nach Ziffer 7, wobei die Treiberschaltung mittels einer Ladeschaltung SUPL die Kondensatoren C1 bis Cn des Kondensator-Arrays CAP mit einem elektrischen Ladestrom laden kann, wenn der Entladetransistor T_{DIS} sperrt.
9. Lichtmodul nach Ziffer 8,
   - wobei Vorrichtungsteile der Treiberschaltung IC und/oder eine andere elektrische Schaltung, die an dem Träger befestigt sind oder Teil des Trägers sind, den Steueranschluss des Entladetransistors T_{DIS} so ansteuern können, dass der Entladetransistor T_{DIS} die Kondensatoren C1 bis Cn des Kondensator-Arrays CAP über die jeweiligen VCSEL-Laser L1 bis Ln des VCSEL-Laser-Array-Die VCSELA, die diesen Kondensatoren C1 bis Cn des Kondensator-Arrays CAP zugeordnet sind, mittels jeweiligen Laser spezifischen Entladeströmen I_{dis} entlädt und
   - wobei dann die VCSEL-Laser L1 bis Ln des VCSEL-Laser-Array-Die VCSELA, die ein Entladestrom I_{dis} durchströmt, senkrecht zur Oberfläche des VCSEL-Laser-Array-Dies VCSELA Licht emittieren.
10. Lichtmodul nach einer der Ziffern 6 bis 9, wobei der Träger eine gedruckte Schaltung PCB oder einen Kühlkörper HS umfasst.
11. VCSEL-Laser-Modul
   - mit einem ersten gemeinsamen Energiespeichersubstrat (C_{L}) und
   - mit einem zweiten gemeinsamen Energiespeichersubstrat (C_{R}) und
   - mit einem VCSEL-Laser-Array (VCSELA) und
   - mit einer Treiberschaltung (IC),
   - wobei die Treiberschaltung (IC) eine Oberfläche aufweist
   - wobei das erste gemeinsamen Energiespeichersubstrat (C_{L}) auf dieser Oberfläche der Treiberschaltung (IC) montiert ist und
   - wobei das zweite gemeinsamen Energiespeichersubstrat (C_{R}) auf dieser Oberfläche der Treiberschaltung (IC) montiert ist und
   - wobei das VCSEL-Laser-Array (VCSELA) auf dieser Oberfläche der Treiberschaltung (IC) zwischen dem ersten gemeinsamen Energiespeichersubstrat (C_{L}) und dem zweiten gemeinsamen Energiespeichersubstrat (C_{R}) montiert ist und
   - wobei das VCSEL-Laser-Array (VCSELA) dazu eingerichtet ist, optische Strahlung im Wesentlichen senkrecht zu dieser Oberfläche bei Bestromung einer oder mehrerer VCSEL-Laserzeilen des VCSEL-Laser-Arrays (VCSELA) mit elektrischer Energie zu emittieren, und
   - wobei ein Energiespeicher des ersten gemeinsamen Energiespeichersubstrats (C_{L}) und/oder ein Energiespeicher des zweiten gemeinsamen Energiespeichersubstrats (C_{R}) dazu eingerichtet sind, eine oder mehrere VCSEL-Laserzeilen des VCSEL-Laser-Arrays (VCSELA) mit elektrischer Energie zu versorgen, wenn dieses bzw. diese Licht emittieren, und
   - wobei die Treiberschaltung (IC) Mittel umfasst, diese Energieentnahme aus den Energiespeichern (C1 bis Cn) zu steuern und/oder die Energiespeicher (C1 bis Cn) mit elektrischer Energie zu füllen.

Weitere Aspekte der Erfindung:
1. Modul zur Abgabe elektromagnetischer Strahlung, insbesondere Laserlichtmodul, mit
   - einem VCSEL-Laser-Array-Die (VCSELA), das eine Vielzahl von streifenförmig und zueinander parallel verlaufenden VCSEL-Lasern (L1 bis Ln) mit jeweils in einer Reihe oder in mehreren parallelen Reihen angeordneten VCSEL-Laserdioden mit jeweils einer Anode und einer Kathode aufweist,
   - wobei jeder VCSEL-Laser (L1 bis Ln) an beiden in Längserstreckung seines Streifens liegenden Streifenenden eine erste Laser-Kontaktfläche (LA1 bis LAn) und eine zweite Laser-Kontaktfläche (RA1 bis RAn) aufweist, mit denen die Anoden sämtlicher VCSEL-Laserdioden des betreffenden VCSEL-Lasers (L1 bis Ln) elektrisch verbunden sind,
   - einem Kondensator-Array (CAP), das ein elektrisch isolierendes Substrat (SUB) aufweist, auf dessen Oberseite sich parallel zueinander verlaufende Aufeinanderfolgen von ersten Kondensator-Kontaktflächen (LCA1 bis LCAn) und von zweiten Kondensator-Kontaktflächen (RCA1 bis RCAn) befinden,
   - wobei das Kondensator-Array (CAP) eine 2D-Anordnung von Kondensatoren (C1 bis Cn) aufweist, die den VCSEL-Lasern (L1 bis Ln) jeweils als Energiespeicher zugeordnet sind,
   - wobei die Kondensatoren (C1 bis Cn) des Kondensator-Arrays (CAP) obere Kondensatorelektroden (te), die sämtlich in 2D-Anordnung innerhalb des Substrats (SUB) ausgebildet sind, und eine sämtlichen Kondensatoren (C1 bis Cn) gemeinsame, mit Abstand zu den oberen Kondensatorelektroden (te) angeordnete untere Kondensatorelektrode (be) aufweist,
   - wobei jede obere Kondensatorelektrode (te) einer Zeile oder einer Spalte von Kondensatoren (C1 bis Cn) des Kondensator-Arrays (CAP) mittels in dem Substrat (SUB) ausgebildeter, parallel zueinander angeordneter und oberhalb der oberen Kondensatorelektroden (te) verlaufender Anschlussleitungen (ICL) elektrisch sowohl mit den ersten Kondensator-Kontaktflächen (LCA1 bis LCAn) als auch mit den zweiten Kondensator-Kontaktflächen (RCA1 bis RCAn) verbunden ist,
   - wobei jede Anschlussleitung (ICL) mittels einer innerhalb des Substrats (SUB) des Kondensator-Arrays (CAP) ausgebildeten Durchkontaktierung (DK) an die obere Kondensatorelektrode (te) des betreffenden Kondensators (C1 bis Cn) und mittels zweier weiterer innerhalb des Substrats (SUB) des Kondensator-Arrays (CAP) ausgebildeter Durchkontaktierungen (DK) an die betreffende erste Kondensator-Kontaktfläche (LCA1 bis LCAn) und an die betreffende zweite Kondensator-Kontaktfläche (RCA1 bis RCAn) angeschlossen ist und
   - wobei die ersten Laser-Kontaktflächen (LA1 bis LAn) der VCSEL-Laser (L1 bis Ln) des VCSEL-Laser-Array-Dies (VCSELA) sowie die ersten Kondensator-Kontaktflächen (LAC1 bis LACn) des Kondensator-Arrays (CAP) einerseits und die zweiten Laser-Kontaktflächen (RA1 bis RAn) der VCSEL-Laser (L1 bis Ln) des VCSEL-Laser-Array-Dies (VCSELA) sowie die zweiten Kondensator-Kontaktflächen (RAC1 bis RACn) des Kondensator-Arrays (CAP) andererseits jeweils in Verlängerung der Erstreckung der streifenförmigen VCSEL-Laser (L1 bis Ln) miteinander fluchtend und benachbart nebeneinander liegen und jeweils untereinander die gleichen Mittenabstände und gegebenenfalls zusätzlich in Richtung ihrer jeweiligen Aufeinanderfolgen gleiche Abmessungen aufweisen, und
   - im Wesentlichen gleich langen Bonddrähte, die jeweils eine der ersten Laser-Kontaktflächen (LA1 bis LAn) der VCSEL-Laser (L1 bis Ln) des VCSEL-Laser-Array-Dies (VCSELA) mit den jeweils benachbarten ersten Kondensator-Kontaktflächen (LAC1 bis LACn) des Kondensator-Arrays (CAP) und jeweils eine der zweiten Laser-Kontaktflächen (RA1 bis RAn) der VCSEL-Laser (L1 bis Ln) des VCSEL-Laser-Array-Dies (VCSELA) mit der jeweils benachbarten zweiten Kondensator-Kontaktfläche (RAC1 bis RACn) des Kondensator-Arrays (CAP) elektrisch verbinden.
2. Modul nach 1, dadurch gekennzeichnet, dass die oberen Kondensatorelektroden (te) der Kondensatoren (C1 bis Cn) des Kondensator-Arrays (CAP) innerhalb einer ersten Metalllage (M1) des Substrats (SUB), die Anschlussleitungen (ICL) in einer oberhalb der ersten Metalllage (M1) angeordneten zweiten Metalllage (M2) des Substrats (SUB) und die ersten Kondensator-Kontaktflächen (LAC1 bis LACn) sowie die zweiten Kondensator-Kontaktflächen (RAC1 bis RACn) in einer oberhalb der zweiten Metalllage (M2) angeordneten dritten Metalllage (M3) des Substrats (SUB) ausgebildet sind.
3. Modul nach 1 oder 2, dadurch gekennzeichnet, dass die sämtlichen Kondensatoren (C1 bis Cn) gemeinsame untere Kondensatorelektrode (be) in einer unterhalb der ersten Metalllage (M1) angeordneten weiteren Metalllage des Substrats (SUB) des Kondensator-Arrays (CAP) angeordnet ist.
4. Modul nach einem der 1 bis 3, dadurch gekennzeichnet, dass das VCSEL-Laser-Array-Die (VCSELA) eine unterseitige Kathodenkontaktfläche (KKF) aufweist, mit der die Kathoden der VCSEL-Laserdioden sämtlicher VCSEL-Laser (L1 bis Ln) elektrisch verbunden sind, und dass das Kondensator-Array (CAP) auf seiner Oberseite zwischen den beiden Aufeinanderfolgen von ersten Kondensator-Kontaktflächen (LCA1 bis LCAn) und von zweiten Kondensator-Kontaktflächen (RCA1 bis RCAn) eine Kathodenelektrode (C) für den Kontakt zur unterseitigen Kathoden-Kontaktfläche (KKF) des VCSEL-Laser-Array Dies (VCSELA) aufweist.
5. Modul nach 4, dadurch gekennzeichnet, dass die Kathodenelektrode (C) des Kathoden-Arrays (CAP) in der dritten Metalllage (M3) des Substrats (SUB) des Kathoden-Arrays (CAP) angeordnet ist.
6. Modul nach einem der 1 bis 5, gekennzeichnet durch eine Steuerschaltung (IC) und eine elektronische Entladestruktur (T_{DIS}) zum Entladen von in einem der Kondensatoren (C1 bis Cn) gespeicherten Ladung zur Abgabe eines Strahlungspulses durch den dem zu entladenden Kondensator (C1 bis Cn) zugeordneten VCSEL-Laser (L1 bis Ln), wobei die Entladestruktur (T_{DIS}) mit der Kathodenkontaktfläche (KKF) verbunden und nach Masse geschaltet sowie von der Steuerschaltung (IC) leitend oder sperrend schaltbar ist.
7. Modul nach 6, gekennzeichnet durch eine Ladeschaltung (SUPL) zum Aufladen der Kondensatoren (C1 bis Cn) des Kondensator-Arrays (CAP), die eine Anordnung von von der Steuerschaltung (IC) steuerbaren elektronischen Schaltern (S1 bis Sn) zum selektiven Aufladen eines einzelnen der Kondensatoren (C1 bis Cn) oder einiger weniger der Kondensatoren (C1 bis Cn) des Kondensator-Arrays (CAP) aufweist.
8. Modul nach 6 oder 7, gekennzeichnet durch einen Träger, auf dem oder an dem das Kondensator-Array (CAP) mit auf diesem befindlichen VCSEL-Laser-Array-Die (VCSELA) und gegebenenfalls die Steuerschaltung (IC) sowie die Entladestruktur (T_{DIS}) und/oder die Ladeschaltung (SUPL) angeordnet ist bzw. sind.
9. Modul nach Anspruch 8, dadurch gekennzeichnet, dass der Träger einen Kühlkörper (HS) oder eine Platine (PCB) mit oder ohne Kühlkörper (HS) aufweist.
10. Modul zur Abgabe elektromagnetischer Strahlung, insbesondere Laserlichtmodul, mit
   - einem VCSEL-Laser-Array-Die (VCSELA), das eine Vielzahl von streifenförmig und zueinander parallel verlaufenden VCSEL-Lasern (L1 bis Ln) mit jeweils in einer Reihe oder in mehreren parallelen Reihen angeordneten VCSEL-Laserdioden mit jeweils einer Anode und einer Kathode aufweist,
   - wobei jeder VCSEL-Laser (L1 bis Ln) an beiden in Längserstreckung seines Streifens liegenden Streifenenden eine erste Laser-Kontaktfläche (LA1 bis LAn) und eine zweite Laser-Kontaktfläche (RA1 bis RAn) aufweist, mit denen die Anoden sämtlicher VCSEL-Laserdioden des betreffenden VCSEL-Lasers (L1 bis Ln) elektrisch verbunden sind,
   - einem Kondensator-Array (CAP), das ein elektrisch isolierendes Substrat (SUB) aufweist, auf dessen Oberseite sich parallel zueinander ausgerichtete Aufeinanderfolgen von ersten Kondensator-Kontaktflächen (LCA1 bis LCAn) und von zweiten Kondensator-Kontaktflächen (RCA1 bis RCAn) befinden,
   - wobei das Kondensator-Array (CAP) eine 2D-Anordnung von Kondensatoren (C1 bis Cn) aufweist, die den VCSEL-Lasern (L1 bis Ln) jeweils als Energiespeicher zugeordnet sind,
   - wobei die Kondensatoren (C1 bis Cn) des Kondensator-Arrays (CAP) obere Kondensatorelektroden (te), die sämtlich in 2D-Anordnung innerhalb des Substrats (SUB) ausgebildet sind, und eine sämtlichen Kondensatoren (C1 bis Cn) gemeinsame, mit Abstand zu den oberen Kondensatorelektroden (te) angeordnete untere Kondensatorelektrode (be) aufweist,
   - wobei jede obere Kondensatorelektrode (te) einer Zeile oder einer Spalte von Kondensatoren (C1 bis Cn) des Kondensator-Arrays (CAP) mittels in dem Substrat (SUB) ausgebildeter, parallel zueinander angeordneter und oberhalb der oberen Kondensatorelektroden (te) verlaufender Anschlussleitungen (ICL) elektrisch sowohl mit den ersten Kondensator-Kontaktflächen (LCA1 bis LCAn) als auch mit den zweiten Kondensator-Kontaktflächen (RCA1 bis RCAn) verbunden ist,
   - wobei jede Anschlussleitung (ICL) mittels einer innerhalb des Substrats (SUB) des Kondensator-Arrays (CAP) ausgebildeten Durchkontaktierung (DK) an die obere Kondensatorelektrode (te) des betreffenden Kondensators (C1 bis Cn) und mittels jeweils zweier weiterer innerhalb des Substrats (SUB) des Kondensator-Arrays (CAP) ausgebildeter Durchkontaktierungen (DK) an die betreffende erste Kondensator-Kontaktfläche (LCA1 bis LCAn) und an die betreffende zweite Kondensator-Kontaktfläche (RCA1 bis RCAn) angeschlossen ist,
   - wobei die ersten Laser-Kontaktflächen (LA1 bis LAn) der VCSEL-Laser (L1 bis Ln) des VCSEL-Laser-Array-Dies (VCSELA) sowie die ersten Kondensator-Kontaktflächen (LAC1 bis LACn) des Kondensator-Arrays (CAP) einerseits und die zweiten Laser-Kontaktflächen (RA1 bis RAn) der VCSEL-Laser (L1 bis Ln) des VCSEL-Laser-Array-Dies (VCSELA) sowie die zweiten Kondensator-Kontaktflächen (RAC1 bis RACn) des Kondensator-Arrays (CAP) andererseits jeweils untereinander im Wesentlichen die gleichen Mittenabstände aufweisen und gegebenenfalls zusätzlich, in Richtung ihrer jeweiligen Aufeinanderfolgen betrachtet, die gleichen Abmessungen aufweisen und
   - wobei das VCSEL-Laser-Array-Die (VCSELA) mit den Laser-Kontaktflächen (LA1 bis LAn, RA1 bis Ran) seiner VCSEL-Laser (L1 bis Ln) den Kondensator-Kontaktflächen (LAC1 bis LACn, RAC1 bis RACn) des Kondensator-Arrays (CAP) zugewandt ausgerichtet ist, und
   - Lötkugeln (SB) zur elektrischen Verbindung jeweils der ersten Laser-Kontaktfläche (LA1 bis LAn) eines jeden VCSEL-Lasers (L1 bis Ln) des VCSEL-Laser-Array-Dies (VCSELA) mit dem mit einer der oberen Kondensatorelektroden (te) verbundenen ersten Kondensator-Kontaktfläche (LAC1 bis LACn) des Kondensator-Arrays (CAP) und jeweils der zweiten Laser-Kontaktfläche (RAC1 bis RACn) des betreffenden VCSEL-Lasers (L1 bis Ln) des VCSEL-Laser-Array-Dies (VCSELA) mit dem mit der betreffenden oberen Kondensatorelektrode (te) verbundenen zweiten Kondensator-Kontaktfläche (RAC1 bis RACn) des Kondensator-Arrays (CAP).
11. Modul nach 10, dadurch gekennzeichnet, dass das VCSEL-Laser-Array-Die (VCSELA) eine unterseitige Kathodenkontaktfläche (KKF) aufweist, mit der die Kathoden der VCSEL-Laserdioden sämtlicher VCSEL-Laser (L1 bis Ln) elektrisch verbunden sind, dass das VCSEL-Laser-Array-Die (VCSELA) an der seiner Unterseite abgewandten Oberseite die Laser-Kontaktflächen (LA1 bis LAn, RA1 bis Ran) aufweist, dass das VCSEL-Laser-Array-Die (VCSELA) über seine Unterseite Strahlung emittiert und dass seine Kathodenkontaktfläche entweder nur in einem Bereich der Unterseite des VCSEL-Laser-Array-Dies (VCSELA) ausgebildet ist, in dem keine Strahlung austritt, und/oder für die elektromagnetische Strahlung transparent ist.
12. Modul nach 11, dadurch gekennzeichnet, dass die oberen Kondensatorelektroden (te) der Kondensatoren (C1 bis Cn) des Kondensator-Arrays (CAP) innerhalb einer ersten Metalllage (M1) des Substrats (SUB), die Anschlussleitungen (ICL) in einer oberhalb der ersten Metalllage (M1) angeordneten zweiten Metalllage (M2) des Substrats (SUB) und die ersten Kondensator-Kontaktflächen (LAC1 bis LACn) sowie die zweiten Kondensator-Kontaktflächen (RAC1 bis RACn) in einer oberhalb der zweiten Metalllage (M2) angeordneten dritten Metalllage (M3) des Substrats (SUB) ausgebildet sind.
13. Modul nach einem der 10 bis 12, dadurch gekennzeichnet, dass die sämtlichen Kondensatoren (C1 bis Cn) gemeinsame untere Kondensatorelektrode (be) in einer unterhalb der ersten Metalllage (M1) angeordneten weiteren Metalllage des Substrats (SUB) des Kondensator-Arrays (CAP) angeordnet ist.
14. Modul nach einem der 10 bis 13, gekennzeichnet durch eine Steuerschaltung (IC) und eine elektronische Entladestruktur (T_{DIS}) zum Entladen von in einem der Kondensatoren (C1 bis Cn) gespeicherten Ladung zur Abgabe eines Strahlungspulses durch den dem zu entladenden Kondensator (C1 bis Cn) zugeordneten VCSEL-Laser (L1 bis Ln), wobei die Entladestruktur (T_{DIS}) mit der Kathodenkontaktfläche (KKF) verbunden und nach Masse geschaltet sowie von der Steuerschaltung (IC) leitend oder sperrend schaltbar ist.
15. Modul nach 14, gekennzeichnet durch eine Ladeschaltung (SUPL) zum Aufladen der Kondensatoren (C1 bis Cn) des Kondensator-Arrays (CAP), die eine Anordnung von von der Steuerschaltung (IC) steuerbaren elektronischen Schaltern (S1 bis Sn) zum selektiven Aufladen eines einzelnen der oder einiger weniger der Kondensatoren (C1 bis Cn) des Kondensator-Arrays (CAP) aufweist.
16. Modul nach 14 oder 15, gekennzeichnet durch einen Träger, auf dem oder an dem das Kondensator-Array (CAP) mit auf diesem befindlichen VCSEL-Laser-Array-Die (VCSELA) und gegebenenfalls die Steuerschaltung (IC) sowie die Entladestruktur (T_{DIS}) und/oder die Ladeschaltung (SUPL) angeordnet ist bzw. sind.
17. Modul nach 16, dadurch gekennzeichnet, dass der Träger einen Kühlkörper (HS) oder eine Platine (PCB) mit oder ohne Kühlkörper (HS) aufweist.
18. Modul zur Abgabe elektromagnetischer Strahlung, insbesondere Laserlichtmodul, mit
   - einem VCSEL-Laser-Array-Die (VCSELA), das eine Vielzahl von streifenförmig und zueinander parallel verlaufenden VCSEL-Lasern (L1 bis Ln) mit jeweils in einer Reihe oder in mehreren parallelen Reihen angeordneten VCSEL-Laserdioden mit jeweils einer Anode und einer Kathode aufweist, wobei jede Reihe eine vorgegebene Breite quer zur Längserstreckung des VCSEL-Lasers (L1 bis Ln) aufweist,
   - wobei jeder VCSEL-Laser (L1 bis Ln) an einem seiner in Längserstreckung seines Streifens liegenden Streifenenden eine Laser-Kontaktfläche (VBP1 bis VBPn) aufweist, mit denen die Anoden sämtlicher VCSEL-Laserdioden des betreffenden VCSEL-Lasers (L1 bis Ln) elektrisch verbunden sind, und
   - wobei die Laser-Kontaktflächen (VBP1 bis VBPn) in Richtung der Aufeinanderfolge der VCSEL-Laser (L1 bis Ln) untereinander einen Mittenabstand aufweisen,
   - einem ersten Energiespeichermodul (C_{L}) mit einer Vielzahl von in Richtung der Aufeinanderfolge der VCSEL-Laser (L1 bis Ln) des VCSEL-Laser-Array-Dies (VCSELA) nebeneinander angeordneten Kondensatoren (C1 bis Cn), die untereinander einen Mittenabstand aufweisen, der gleich dem Mittenabstand der Laser-Kontaktfläche (VBP1 bis VBPn) ist und
   - Bonddrähten zur elektrischen Verbindung jeweils einer Laser-Kontaktfläche (VBP1 bis VBPn) und eines Kondensators (C1 bis Cn).
19. Modul nach 18, dadurch gekennzeichnet, dass die Anzahl der Reihen von VCSEL-Laserdioden, die durch dieselbe Laser-Kontaktfläche (VBP1 bis VBPn) kontaktiert sind, definiert ist als der ganzzahlige Teil des Ergebnisses der Division aus dem Mittenabstand der Laser-Kontaktflächen (VBP1 bis VBPn) und der Breite einer Reihe von VCSEL-Laserdioden oder definiert ist als der ganzzahlige Teil des Ergebnisses der Division aus der in Richtung der Aufeinanderfolge der Laser-Kontaktflächen (VBP1 bis VBPn) betrachteten Erstreckung einer Laser-Kontaktfläche (VBP1 bis VBPn) und der Breite einer Reihe von VCSEL-Laserdioden.
20. Modul nach 18 oder 19, dadurch gekennzeichnet, dass die Laser-Kontaktflächen (VBP1 bis VBPn) sämtlicher VCSEL-Laser (L1 bis Ln) nebeneinander und somit an dem gleichen Ende der Streifen der VCSEL-Laser (L1 bis Ln) liegen.
21. Modul nach 20, dadurch gekennzeichnet, dass die Kondensatoren (C1 bis Cn) in einer Reihe liegend aufeinanderfolgen.
22. Modul nach 20, dadurch gekennzeichnet, dass die Kondensatoren (C1 bis Cn) in zwei Reihen mit jeweils gleichen Mittenabständen angeordnet sind, wobei die Kondensatoren (C1 bis Cn) der einen Reihe um den halben Mittenabstand versetzt neben den Kondensatoren (C1 bis Cn) der anderen Reihe angeordnet sind, und dass die Mittenabstände der Kondensatoren gleich dem doppelten Mittenabstand der Laser-Kontaktflächen (VBP1 bis VBPn) ist.
23. Modul nach 18 oder 19, dadurch gekennzeichnet, dass die Laser-Kontaktflächen (VBP1 bis VBPn) benachbarter VCSEL-Laser (L1 bis Ln) wechselweise einander gegenüberliegen und dass dem ersten Energiespeichermodul (C_{L}) gegenüberliegend ein zweites Energiespeichermodul (C_{R}) mit ebenfalls einer Vielzahl von Kondensatoren (C1 bis Cn) angeordnet ist, wobei sich das VCSEL-Laser-Array-Die (VCSELA) zwischen den beiden Energiespeichermodulen befindet.
24. Modul nach 23, dadurch gekennzeichnet, dass die Kondensatoren (C1 bis Cn) beider Energiespeichermodule jeweils in einer Reihe aufeinanderfolgend angeordnet sind und dass der Mittenabstand der Kondensatoren (C1 bis Cn) gleich dem doppelten Mittenabstand der wechselweise aufeinanderfolgenden Laser-Kontaktflächen (VBP1 bis VBPn) ist.
25. Modul nach 23, dadurch gekennzeichnet, dass die Kondensatoren (C1 bis Cn) beider Energiespeichermodule (C_{L}, C_{R}) jeweils in zwei Reihen mit gleichem Mittenabstand angeordnet sind, wobei die Kondensatoren (C1 bis Cn) der einen Reihe um den halben Mittenabstand versetzt neben den Kondensatoren (C1 bis Cn) der anderen Reihe angeordnet sind, und dass der Mittenabstand der Kondensatoren (C1 bis Cn) gleich dem Vierfachen des Mittenabstands der wechselweise aufeinanderfolgenden Laser-Kontaktflächen (VBP1 bis VBPn) ist.
26. Modul nach einem der 18 bis 25, gekennzeichnet durch
   - einen IC-Die (IC) mit einer integrierten Schaltung zur Ansteuerung der VCSEL-Laser (L1 bis Ln) des VCSEL-Laser-Array-Dies (VCSELA) und zum Aufladen sowie Entladen der Kondensatoren (C1 bis Cn) des ersten Energiespeichermoduls (C_{L}),
   - wobei das erste Energiespeichermodul (C_{L}) als ein Kondensator-Modul ausgebildet ist und
   - wobei das VCSEL-Laser-Array-Die (VCSELA) und das Kondensator-Modul auf dem IC-Die (IC) angeordnet sind.
27. Modul nach 26, dadurch gekennzeichnet, dass das IC-Die (IC) eine integrierte Entladestruktur (Tdis) aufweist, wobei das VCSEL-Laser-Array-Die (VCSELA) eine unterseitige Kathodenkontaktfläche aufweist, mit der die Kathoden der VCSEL-Laserdioden sämtlicher VCSEL-Laser (L1 bis Ln) elektrisch verbunden sind und die die Entladestruktur (Tdis) des IC-Dies (IC) elektrisch kontaktiert.
28. Modul nach 26 oder 27, dadurch gekennzeichnet, dass bei Vorhandensein des zweiten Energiespeichermoduls (C_{R}) auch dieses auf dem IC-Die (IC) angeordnet ist.
29. Modul nach einem der 26 bis 28, dadurch gekennzeichnet, dass das IC-Die (IC) eine Ladeschaltung zum Aufladen der Kondensatoren des ersten Energiespeichermoduls (C_{L}) oder jedes Energiespeichermoduls (C_{L}, C_{R}) mit einem Verbindungsknoten zu dem ersten Energiespeichermodul (C_{L}) oder mit Verbindungsknoten zu jedem der Energiespeichermodule (C_{L}, C_{R}) aufweist, dass das erste Energiespeichermodul (C_{L}) oder jedes Energiespeichermodul (C_{L}, C_{R}) eine unterseitige, sämtlichen Kondensatoren (C1 bis Cn) des betreffenden Energiespeichermoduls (C_{L}, C_{R}) gemeinsame untere Kondensatorelektrode sowie einzelne voneinander getrennte obere Kondensatorelektroden aufweist und dass die unterseitige bzw. die unterseitigen gemeinsamen Kondensatorelektroden einen Knoten der Aufladeschaltung des IC-Dies (IC) kontaktiert bzw. kontaktieren.
30. Modul nach einem der 26 bis 29, dadurch gekennzeichnet, dass das IC-Die (IC) den Kondensatoren (C1 bis Cn) des ersten Energiespeichermoduls (C_{L}) oder jedes Energiespeichermoduls (C_{L}, C_{R}) zugeordnete Kontaktflächen aufweist, die mittels Bonddrähten elektrisch mit den oberen Elektroden der Kondensatoren (C1 bis Cn) des betreffenden Energiespeichermoduls (C_{L}, C_{R}) zugeordneten Kontaktflächen verbunden sind, und dass diese Kontaktflächen der Kondensatoren (C1 bis Cn) des betreffenden Energiespeichermoduls (C_{L}, C_{R}) ihrerseits mittels weiterer Bonddrähte mit den Laser-Kontaktflächen (VBP1 bis VBPn) der jeweiligen ihnen zugeordneten VCSEL-Laser (L1 bis Ln) des VCSEL-Laser-Array-Dies (VCSELA) verbunden sind.

### BEZUGSZEICHENLISTE der Fign. 1 bis 12

- A1 bis An: Kondensatoranschlussknoten. In einen Kondensatoranschlussknoten der n Kondensatoranschlussknoten A1 bis An speist die Ladeschaltung SUPK in der Ladephase den Ladestrom über den zugeordneten und in der Ladephase geschlossenen Ladeschalter S1 bis Sn ein, um den zugeordneten Kondensator C1 bis Cn in dieser Ladephase zu laden. Zur Entladung entnimmt der dem betreffenden Kondensatoranschlussknoten A1 bis An zugeordnete VCSEL-Laser L1 bis Ln bei geöffnetem Ladeschalter S1 bis Sn die elektrische Energie aus dem zugeordneten Kondensator C1 bis Cn über den Kondensatoranschlussknoten und entlädt so den Kondensator. In der Fig. 11 bildet jeweils eine Gruppe aus einer linken Kontaktfläche LCA1 bis LCAn und einer rechten Kontaktfläche RCA1 bis RCAn zusammen mit der diese verbindenden Anschlussleitung ICL den entsprechenden Kondensatoranschlussknoten A1 bis An der Fig. 2;
- BdCT: Bonddrähte zwischen dem zweiten Anschluss CT des Treibertransistor T_{DIS} der Treiberschaltung IC und der mit der Kathodenelektrode C;
- BdGND: Bonddrähte, die den ersten Anschluss GNDT des Entladetransistors T_{DIS} der Treiberschaltung IC mit der Massefläche GNDP verbinden.
- BdL1: erste linke Bond-Draht-Verbindung zwischen der ersten linken Kontaktfläche LCA1 des ersten linken Kondensators LC1 des Kondensator-Arrays CAP und der linken Laser-Kontaktfläche LA1 des ersten Lasers L1 des VCSEL-Laser-Dies VCSLEA;
- BdL2: zweite linke Bond-Draht-Verbindung zwischen der zweiten linken Kontaktfläche LCA2 des zweiten linken Kondensators LC2 des Kondensator-Arrays CAP und der zweiten linken Laser-Kontaktfläche LA2 des zweiten Lasers L2 des VCSEL-Laser-Dies VCSLEA;
- BdL3: dritte linke Bond-Draht-Verbindung zwischen der dritten linken Kontaktfläche LCA3 des dritten linken Kondensators LC3 des Kondensator-Arrays CAP und der dritten linken Laser-Kontaktfläche LA3 des dritten Lasers L3 des VCSEL-Laser-Dies VCSLEA;
- BdLn: n-te linke Bond-Draht-Verbindung zwischen der n-ten linken Kontaktfläche LCAn des n-ten linken Kondensators LCn des Kondensator- Arrays CAP und der n-ten linken Kontaktfläche LAn des n-ten Lasers Ln des VCSEL-Laser-Dies VCSLEA;
- BdR1: erste rechte Bond-Draht-Verbindung zwischen der ersten rechten Kontaktfläche RCA1 des ersten rechten Kondensators RC1 des Kondensator-Arrays CAP und der ersten rechten Laser-Kontaktfläche RA1 des ersten Lasers L1 des VCSEL-Laser-Dies VCSLEA;
- BdR2: zweite rechte Bond-Draht-Verbindung zwischen der zweiten rechten Kontaktfläche RCA2 des zweiten rechten Kondensators RC2 des Kondensator-Arrays CAP und der zweiten rechten Kontaktfläche RA2 des zweiten Lasers L2 des VCSEL-Laser-Dies VCSLEA;
- BdR3: dritte rechte Bond-Draht-Verbindung zwischen der dritten rechten Kontaktfläche RCA3 des dritten rechten Kondensators RC3 des Kondensator-Arrays CAP und der dritten rechten Kontaktfläche RA3 des dritten Lasers L3 des VCSEL-Laser-Dies VCSLEA;
- BdRn: n-te rechte Bond-Draht-Verbindung zwischen der n-ten rechten Kontaktfläche RCAn des n-ten rechten Kondensators RCn des Kondensator-Arrays CAP und der n-ten rechten Kontaktfläche RAn des n-ten Lasers Ln des VCSEL-Laser-Dies VCSLEA;
- be: untere Kondensatorelektrode
- BP0 bis BP3: Anschlusspads des Schaltungsträgers
- C: Kathodenelektrode. Die Kathodenelektrode ist der elektrische Anschluss des gemeinsamen Kathodenkontakts der Kathoden der VCSEL-Laser L1 bis Ln des VCSEL-Laser-Array Dies VCSELA;
- C1: erster Kondensator, der bei Entladung durch den Entladeschalter T_{DIS} den ersten VCSEL-Laser L1 mit elektrischer Energie versorgt. Es handelt sich bevorzugt um den ersten Kondensator des Kondensator-Arrays CAP;
- C2: zweiter Kondensator, der bei Entladung durch den Entladeschalter T_{DIS} den zweiten VCSEL-Laser L2 mit elektrischer Energie versorgt. Es handelt sich bevorzugt um den zweiten Kondensator des Kondensator-Arrays CAP;
- C3: dritter Kondensator, der bei Entladung durch den Entladeschalter T_{DIS} den dritten VCSEL-Laser L3 mit elektrischer Energie versorgt. Es handelt sich bevorzugt um den dritten Kondensator des Kondensator-Arrays CAP;
- C4: vierter Kondensator, der bei Entladung durch den Entladeschalter T_{DIS} den vierten VCSEL-Laser L4 mit elektrischer Energie versorgt. Es handelt sich bevorzugt um den vierten Kondensator des Kondensator-Arrays CAP;
- C5: fünfter Kondensator, der bei Entladung durch den Entladeschalter T_{DIS} den fünften VCSEL-Laser L5 mit elektrischer Energie versorgt. Es handelt sich bevorzugt um den fünften Kondensator des Kondensator-Arrays CAP;
- C6: sechster Kondensator, der bei Entladung durch den Entladeschalter T_{DIS} den sechsten VCSEL-Laser L6 mit elektrischer Energie versorgt. Es handelt sich bevorzugt um den sechsten Kondensator des Kondensator-Arrays CAP;
- C7: siebter Kondensator, der bei Entladung durch den Entladeschalter T_{DIS} den siebten VCSEL-Laser L7 mit elektrischer Energie versorgt. Es handelt sich bevorzugt um den siebten Kondensator des Kondensator-Arrays CAP;
- C8: achter Kondensator, der bei Entladung durch den Entladeschalter T_{DIS} den achten VCSEL-Laser L8 mit elektrischer Energie versorgt. Es handelt sich bevorzugt um den nullten Kondensator des Kondensator-Arrays CAP;
- C(n-3): (n-3)-ter Kondensator, der bei Entladung durch den Entladeschalter T_{DIS} den (n-3)-ten VCSEL-Laser L(n-3) mit elektrischer Energie versorgt. Es handelt sich bevorzugt um den (n-3)-ten Kondensator des Kondensator-Arrays CAP;
- C(n-2): (n-2)-ter Kondensator, der bei Entladung durch den Entladeschalter T_{DIS} den (n-2)-ten VCSEL-Laser L(n-2) mit elektrischer Energie versorgt. Es handelt sich bevorzugt um den (n-2)-ten Kondensator des Kondensator-Arrays CAP;
- C(n-1): (n-1)-ter Kondensator, der bei Entladung durch den Entladeschalter T_{DIS} den (n-1)-ten VCSEL-Laser L(n-1) mit elektrischer Energie versorgt. Es handelt sich bevorzugt um den (n-1)-ten Kondensator des Kondensator-Arrays CAP;
- Cn: n-ter Kondensator, der bei Entladung durch den Entladeschalter T_{DIS} den n-ten VCSEL-Laser Ln mit elektrischer Energie versorgt. Es handelt sich bevorzugt um den n-ten Kondensator des Kondensator-Arrays CAP;
- CAP: Kondensator-Array, das bevorzugt n Kondensatoren C1 bis Cn umfasst;
- CAPL: linkes Kondensator-Array, das bevorzugt die n Kondensatoren LC1 bis LCn umfasst;
- CAPR: rechtes Kondensator-Array, das bevorzugt die n Kondensatoren RC1 bis RCn umfasst;
- CT: (zweiter) Anschluss des Entladetransistors T_{DIS} der Treiberschaltung IC;
- DK: Durchkontaktierung;
- GND: Masseknoten;
- GNDT: (erster) Anschluss des Entladetransistors T_{DIS} der Treiberschaltung IC;
- GNDP: Massefläche;
- HS: Kühlkörper;
- IC: Treiberschaltung. Es handelt sich um ein Schaltungs-Die mit dem Entladetransistor T_{DIS} und ggf. weiteren integrierten Schaltungen zur Steuerung des Lichtmoduls LM;
- ICL: Anschlussleitung für die Kondensatorelektrode te der Kondensatoren C1 bis Cn;
- KKF: Kathodenkontaktfläche des VCSEL-Laser-Array Dies VCSEL;
- L1: erster Laser(streifen) aus einem oder mehreren Laserdioden auf dem VCSEL-Laser-Die VCSELA;
- L2: zweiter Streifen aus einem oder mehreren Lasern auf dem VCSEL-Laser-Die VCSELA;
- L3: dritter Streifen aus einem oder mehreren Lasern auf dem VCSEL-Laser-Die VCSELA;
- L4: vierter Streifen aus einem oder mehreren Lasern auf dem VCSEL-Laser-Die VCSELA;
- L5: fünfter Streifen aus einem oder mehreren Lasern auf dem VCSEL-Laser-Die VCSELA;
- L6: sechster Streifen aus einem oder mehreren Lasern auf dem VCSEL-Laser-Die VCSELA;
- L7: siebter Streifen aus einem oder mehreren Lasern auf dem VCSEL-Laser-Die VCSELA;
- L8: achter Streifen aus einem oder mehreren Lasern auf dem VCSEL-Laser-Die VCSELA;
- L(n-3): (n-3)-ter Streifen aus einem oder mehreren Lasern auf dem VCSEL-Laser-Die VCSELA;
- L(n-2): (n-2)-ter Streifen aus einem oder mehreren Lasern auf dem VCSEL-Laser-Die VCSELA;
- L(n-1): (n-1)-ter Streifen aus einem oder mehreren Lasern auf dem VCSEL-Laser-Die VCSELA;
- Ln: n-ter Streifen aus einem oder mehreren Lasern auf dem VCSEL-Laser-Die VCSELA;
- LA1: linke Laser-Kontaktfläche des ersten Lasers L1 des VCSEL-Laser-Dies VCSLEA;
- LA2: linke Laser-Kontaktfläche des zweiten Lasers L2 des VCSEL-Laser-Dies VCSLEA;
- LA3: linke Laser-Kontaktfläche des dritten Lasers L3 des VCSEL-Laser-Dies VCSLEA;
- LA4: linke Laser-Kontaktfläche des vierten Lasers L4 des VCSEL-Laser-Dies VCSLEA;
- LA5: linke Laser-Kontaktfläche des fünften Lasers L5 des VCSEL-Laser-Dies VCSLEA;
- LA6: linke Laser-Kontaktfläche des sechsten Lasers L6 des VCSEL-Laser-Dies VCSLEA;
- LA7: linke Laser-Kontaktfläche des siebten Lasers L7 des VCSEL-Laser-Dies VCSLEA;
- LA8: linke Laser-Kontaktfläche des achten Lasers L8 des VCSEL-Laser-Dies VCSLEA;
- LA(n-3): linke Laser-Kontaktfläche des (n-3)-ten Lasers L(n-3) des VCSEL-Laser-Dies VCSLEA;
- LA(n-2): linke Laser-Kontaktfläche des (n-2)-ten Lasers L(n-2) des VCSEL-Laser-Dies VCSLEA;
- LA(n-1): linke Laser-Kontaktfläche des (n-1)-ten Lasers L(n-1) des VCSEL-Laser-Dies VCSLEA;
- LAn: linke Laser-Kontaktfläche des n-ten Lasers Ln des VCSEL-Laser-Dies VCSLEA;
- L_{BD}1: gemeinsame Bonddrahtinduktivität der ersten Bonddrähte BdL1 und BdR1;
- L_{BD}2: gemeinsame Bonddrahtinduktivität der zweiten Bonddrähte BdL2 und BdR2;
- L_{BD}3: gemeinsame Bonddrahtinduktivität der dritten Bonddrähte BdL3 und BdR3;
- L_{BD}n: gemeinsame Bonddrahtinduktivität der n-ten Bonddrähte BdLn und BdRn;
- LC1: erster Kondensator LC1 des linken Kondensator-Arrays CAPL;
- LC2: zweiter Kondensator LC2 des linken Kondensator-Arrays CAPL;
- LC3: dritter Kondensator LC1 des dritten Kondensator-Arrays CAPL;
- LCn: n-ter Kondensator LCn des linken Kondensator-Arrays CAPL;
- LCA1: Kontaktfläche des ersten linken Kondensators LC1 des linken Kondensator-Arrays CAPL bzw. des ersten Kondensators C1 des Kondensator-Arrays CAP;
- LCA2: Kontaktfläche des zweiten linken Kondensators LC2 des linken Kondensator-Arrays CAPL bzw. des zweiten Kondensators C2 des Kondensator-Arrays CAP;
- LCA3: Kontaktfläche des dritten linken Kondensators LC3 des linken Kondensator-Arrays CAPL bzw. des dritten Kondensators C3 des Kondensator-Arrays CAP;
- LCA4: Kontaktfläche des vierten linken Kondensators LC4 des linken Kondensator-Arrays CAPL bzw. des vierten Kondensators C4 des Kondensator-Arrays CAP;
- LCA5: Kontaktfläche des fünften linken Kondensators LC5 des linken Kondensator-Arrays CAPL bzw. des fünften Kondensators C5 des Kondensator-Arrays CAP;
- LCA6: Kontaktfläche des sechsten linken Kondensators LC6 des linken Kondensator-Arrays CAPL bzw. des sechsten Kondensators C6 des Kondensator-Arrays CAP;
- LCA7: Kontaktfläche des siebten linken Kondensators LC7 des linken Kondensator-Arrays CAPL bzw. des siebten Kondensators C7 des Kondensator-Arrays CAP;
- LCA8: Kontaktfläche des achten linken Kondensators LC8 des linken Kondensator-Arrays CAPL bzw. des achten Kondensators C8 des Kondensator-Arrays CAP;
- LCA(n-3): Kontaktfläche des (n-3)-ten linken Kondensators LC(n-3) des linken Kondensator-Arrays CAPL bzw. des (n-3)-ten Kondensators C(n-3) des Kondensator-Arrays CAP;
- LCA(n-2): Kontaktfläche des (n-2)-ten linken Kondensators LC(n-2) des linken Kondensator-Arrays CAPL bzw. des (n-2)-ten Kondensators C(n-2) des Kondensator-Arrays CAP;
- LCA(n-1): Kontaktfläche des (n-1)-ten linken Kondensators LC(n-1) des linken Kondensator-Arrays CAPL bzw. des (n-1)-ten Kondensators C(n-1) des Kondensator-Arrays CAP;
- LCAn: Kontaktfläche des n-ten linken Kondensators LCn des linken Kondensator-Arrays CAPL bzw. des n-ten Kondensators Cn des Kondensator-Arrays CAP;
- LM: Lichtmodul. Das Lichtmodul ist bevorzugt ein Laser-Modul, das ein VCSEL-Laser-Array-Die VCSELA umfasst;
- M1: erste Metalllage;
- M2: zweite Metalllage;
- M3: dritte Metalllage;
- OS: Oberseite des Trägers. Der Träger kann beispielsweise eine gedruckte Schaltung PCB oder ein Kühlkörper HS sein;
- PCB: Schaltungsträger. Bei dem Schaltungsträger kann es sich beispielsweise um eine gedruckte Schaltung, beispielsweise eine FR4-Platine oder eine Epoxidharz-Platine, und/oder um einen Keramikträger etc. handeln.
- PTC: Minimalabstand der Kondensatoren C1 bis Cn des Kondensator-Arrays CAP. Die Fig. 11 gibt einen beispielhaften Minimalabstand der Kondensatoren C1 bis Cn des Kondensator-Arrays CAP von 300µm als Beispiel an;
- PTCC: minimaler (vierter) Abstand der Kontaktflächen LCA1 bis LCAn und RCA1 bis RCAn der Kondensatoren C1 bis Cn des Kondensator-Arrays CAP. Die Fig. 11 gibt einen beispielhaften Minimalabstand PTCC der Kontaktflächen LCA1 bis LCAn und RCA1 bis RCAn der Kondensatoren C1 bis Cn des Kondensator-Arrays CAP von 50µm als Beispiel an;
- PTCL: Minimalabstand der linken Kondensatoren LC1 bis LCn des linken Kondensator-Arrays CAPL. Die Fig. 1 gibt einen beispielhaften Minimalabstand der linken Kondensatoren LC1 bis LCn des linken Kondensator-Arrays CAPL und der entsprechenden linken Kontaktflächen LCA1 bis LCAn von 300µm als Beispiel an;
- PTCR: Minimalabstand der rechten Kondensatoren RC1 bis RCn des rechten Kondensator-Arrays CAPR. Die Fig. 1 gibt einen beispielhaften Minimalabstand der rechten Kondensatoren RC1 bis RCn des rechten Kondensator-Arrays CAPR und der entsprechenden rechten Kontaktflächen RCA1 bis RCAn von 300µm als Beispiel an;
- PTCX: Minimalabstand der Spalten Kondensatoren C1 bis Cn des Kondensator-Arrays CAP. Die Fig. 11 gibt einen beispielhaften Minimalabstand der Kondensatoren C1 bis Cn des Kondensator-Arrays CAP von 300µm als Beispiel an;
- PTCY: Minimalabstand der Zeilen der Kondensatoren C1 bis Cn des Kondensator-Arrays CAP. Die Fig. 11 gibt einen beispielhaften Minimalabstand der Kondensatoren C1 bis Cn des Kondensator-Arrays CAP von 300µm als Beispiel an;
- PTL: Abstand der linken Laser-Kontaktflächen LA1 bis LAn des VCSEL-Laser-Array-Dies VCSELA;
- PTLa: minimaler (fünfter) Abstand der VCSEL-Laser L1 bis Ln des VCSEL-Laser-Array-Dies VCSELA zueinander, auch als Laser-Die-Pitch bezeichnet. Die Fig. 1 gibt einen beispielhaften Laser-Die-Pitch von 50µm als Beispiel an. Bevorzugt ist der Minimalabstand PTLa der VCSEL-Laser L1 bis Ln des VCSEL-Laser-Array-Dies VCSELA zueinander gleich dem ersten Abstand PTL der linken Laser-Kontaktflächen LA1 bis LAn des VCSEL-Laser-Array-Dies VCSELA und gleich dem ersten Abstand PTR der rechten Laser-Kontaktflächen RA1 bis RAn des VCSEL-Laser-Array-Dies VCSELA;
- PTR: Abstand der rechten Laser-Kontaktflächen RA1 bis RAn des VCSEL-Laser-Array-Dies VCSELA;
- Q: Wärmestrom;
- RA1: rechte Laser-Kontaktfläche des Streifens des ersten VCSEL-Lasers L1 auf dem VCSEL-Laser-Die VCSELA;
- RA2: rechte Laser-Kontaktfläche des Streifens des zweiten VCSEL-Lasers L2 auf dem VCSEL-Laser-Die VCSELA;
- RA3: rechte Laser-Kontaktfläche des Streifens des dritten VCSEL-Lasers L3 auf dem VCSEL-Laser-Die VCSELA;
- RAn: rechte Laser-Kontaktfläche des Streifens des n-ten VCSEL-Lasers Ln auf dem VCSEL-Laser-Die VCSELA;
- RC1: erster Kondensator des rechten Kondensator-Arrays CAPR;
- RC2: zweiter Kondensator des rechten Kondensator-Arrays CAPR;
- RC3: dritter Kondensator des dritten Kondensator-Arrays CAPR;
- RCn: n-ter Kondensator des rechten Kondensator-Arrays CAPR;
- RCA1: Kontaktfläche RCA1 des ersten rechten Kondensators RC1 des rechten Kondensator-Arrays CAPR bzw. des ersten Kondensators C1 des Kondensator-Arrays CAP;
- RCA2: Kontaktfläche RCA2 des zweiten rechten Kondensators RC2 des rechten Kondensator-Arrays CAPR bzw. des zweiten Kondensators C2 des Kondensator-Arrays CAP;
- RCA3: Kontaktfläche RCA3 des dritten rechten Kondensators RC3 des rechten Kondensator-Arrays CAPR bzw. des dritten Kondensators C3 des Kondensator-Arrays CAP;
- RCAn: Kontaktfläche RCAn des n-ten rechten Kondensators RCn des rechten Kondensator-Arrays CAPR bzw. des n-ten Kondensators Cn des Kondensator-Arrays CAP;
- S1: Ladeschalter für die Ladung des ersten Kondensators C1 des Kondensator-Arrays CAP bzw. des ersten linken Kondensators LC1 des linken Kondensator-Arrays CAPL und des ersten rechten Kondensators RC1 des rechten Kondensator-Arrays CAPR mit dem Ladestrom der Ladeschaltung SUPL;
- S2: Ladeschalter für die Ladung des zweiten Kondensators C2 des Kondensator-Arrays CAP bzw. des zweiten linken Kondensators LC2 des linken Kondensator-Arrays CAPL und des zweiten rechten Kondensators RC2 des rechten Kondensator-Arrays CAPR mit dem Ladestrom der Ladeschaltung SUPL;
- S3: Ladeschalter für die Ladung des dritten Kondensators C3 des Kondensator-Arrays CAP bzw. des dritten linken Kondensators LC3 des linken Kondensator-Arrays CAPL und des nullten rechten Kondensators RC1 des rechten Kondensator-Arrays CAPR mit dem Ladestrom der Ladeschaltung SUPL;
- Sn: Ladeschalter für die Ladung des n-ten Kondensators Cn des Kondensator-Arrays CAP bzw. des n-ten linken Kondensators LCn0 des linken Kondensator-Arrays CAPL und des nullten rechten Kondensators RC1 des rechten Kondensator-Arrays CAPR mit dem Ladestrom der Ladeschaltung SUPL;
- SC: Schrauben als beispielhafte Befestigungsmittel für die gedruckte Schaltung PCB auf dem Kühlkörper HS;
- SUB: Substrat des Kondensator-Arrays CAP;
- SUBC: Substratkontakt. Der jeweilige Substratkontakt eines Kondensator-Arrays CAP, CAPL, CAPR bildet bevorzugt die untere Bottom-Elektrode des jeweiligen Kondensator-Arrays CAP, CAPL, CAPR. Die Kondensatoren C1 bis Cn des jeweiligen Kondensator-Arrays CAP, CAPL, CAPR sind in dem Dielektrikum des Substrats SUB zwischen den oberen Kondensatorelektroden te und der unteren (Buttom-) bzw. untere Kondensatorelektrode be bzw. dem unteren Substratkontakt ausgebildet;
- SUPL: Ladeschaltung;
- te: Kondensatorelektrode der Kondensatoren;
- T_{DIS}: Entladetransistor;
- TR: Träger;
- TRG: Steueranschluss (TRG) des Entladetransistor T_{DIS} zum leitend Schalten und sperrend Schalten des Leitungspfads des Entladetransistor T_{DIS} zwischen seinem ersten und seinem zweiten Anschluss;
- VCSELA: VCSEL-Laser-Array-Die mit einer Vielzahl von VCSEL-Laserdioden. Das VCSEL-Laser-Array-Die ist bevorzugt ein Halbleiterkristall, in dem die VCSEL-Laser L1 bis Ln ausgebildet sind.

### BEZUGSZEICHENLISTE der Fign. 13 bis 25

- 1300: Treiberschaltung IC;
- 1301: Block mit den r Treibern DRC1 bis DRCr;
- 1302: Monitoring-Block;
- 1303: Überwachung der Spannungswandlung;
- 1304: Temperaturüberwachung;
- 1305: Analogmultiplexer;
- 1306: Abtasteinheit (Sample&Hold-Schaltung);
- 1307: Analog-zu-Digitalwandler;
- 1308: Digitalteil der Treiberschaltung IC;
- 1309: Kontrollvorrichtung und Steuervorrichtung;
- 1310: Testlogik;
- 1311: Diagnoseeingang;
- 1312: SPI und JTAG-Datenschnittstellen oder andere Datenschnittstellen;
- 1313: Register;
- 1314: flüchtiger und/oder nicht-flüchtiger Speicher;
- 1315: Oszillator und Takterzeugung und Taktverteilung;
- 1316: Spannungswandler und Referenzerzeugung;
- 1317: Bandgap-Schaltung;
- 1318: Reset-Schaltung;
- 1319: Spannungserzeugung für ein virtuelles Massepotenzial für die Massepotenzialleitung GND;
- 1320: Low-Drop-Spannungswandler
- 1321: N-Kanal-FET-Transistor;
- 1322: Treiberschaltung für den N-Kanal-Fet 1321 des Low-Drop-Treibers 1320;
- 1323: Schaltung zur Schärfung des Pulses;
- 1324: DLL und Digital zu Analog-Wandler;
- α: Winkel um den die Energiespeichergruppen der Energiespeicher C1 bis Cn gedreht sind;
- ATEST: Testdatenbus für den Produktionstest der Treiberschaltung IC;
- BD: Bondverbindung;
- BD1: erste elektrische Bondverbindung zwischen dem ersten VCSEL-Bondpad VBP1 des ersten VCSEL-Lasers L1 und dem ersten Kondensator-Bondpad CBP1 des ersten Energiespeichers C1, der typischerweise ein erster Kondensator ist;
- BD2: zweite elektrische Bondverbindung zwischen dem zweiten VCSEL-Bondpad VBP2 des zweiten VCSEL-Lasers L2 und dem zweiten Kondensator-Bondpad CBP2 des zweiten Energiespeichers C2, der typischerweise ein zweiter Kondensator ist;
- BD3: dritte elektrische Bondverbindung zwischen dem dritten VCSEL-Bondpad VBP3 des dritten VCSEL-Lasers L3 und dem dritten Kondensator-Bondpad CBP3 des dritten Energiespeichers C3, der typischerweise ein dritter Kondensator ist;
- BD(n-1): (n-1)-te elektrische Bondverbindung zwischen dem (n-1)-ten VCSEL-Bondpad VBP(n-1) des (n-1)-ten VCSEL-Lasers L(n-1) und dem (n-1)-ten Kondensator-Bondpad CBP(n-1) des (n-1)-ten Energiespeichers C(n-1), der typischerweise ein n-ter Kondensator ist;
- BDn: n-te elektrische Bondverbindung zwischen dem n-ten VCSEL-Bondpad VBPn des n-ten VCSEL-Lasers Ln und dem n-ten Kondensator-Bondpad CBPn des n-ten Energiespeichers Cn, der typischerweise ein n-ter Kondensator ist;
- BDL1: Bondverbindung zwischen erstem Bondpadanschluss ICBP1 des ersten Ladeschalters S1 der ersten funktionalen Gruppe FG1 der Treiberschaltung IC und dem ersten Kondensator-Bondpad CBP1 des ersten Energiespeichers C1 der ersten funktionalen Gruppe FG1, wobei bevorzugt der erste Energiespeicher C1 bevorzugt Teil des zweiten Energiespeichersubstrats C_{R} ist;
- BDL2: Bondverbindung zwischen zweiten Bondpadanschluss ICBP2 des zweiten Ladeschalters S2 der zweiten funktionalen Gruppe FG2 der Treiberschaltung IC und dem zweiten Kondensator-Bondpad CBP2 des zweiten Energiespeichers C2 der zweiten funktionalen Gruppe FG2, wobei bevorzugt der zweite Energiespeicher C2 bevorzugt Teil des ersten Energiespeichersubstrats C_{L} ist;
- BDL(n-1): Bondverbindung zwischen (n-1)-tem Bondpadanschluss ICBP(n-1) des (n-1)-ten Ladeschalters S(n-1) der (n-1)-ten funktionalen Gruppe FG(n-1) der Treiberschaltung IC und dem (n-1)-ten Kondensator-Bondpad CBP(n-1) des (n-1)-ten Energiespeichers C(n-1) der (n-1)-ten funktionalen Gruppe FG(n-1), wobei bevorzugt der (n-1)-te Energiespeicher C(n-1) bevorzugt Teil des zweiten Energiespeichersubstrats C_{R} ist;
- BDLn: Bondverbindung zwischen n-ten Bondpadanschluss ICBPn des n-ten Ladeschalters Sn der n-ten funktionalen Gruppe FGn der Treiberschaltung IC und dem n-ten Kondensator-Bondpad CBPn des n-ten Energiespeichers Cn der n-ten funktionalen Gruppe FGn, wobei bevorzugt der n-te Energiespeicher Cn bevorzugt Teil des ersten Energiespeichersubstrats C_{L} ist;
- Buf: Buffer;
- C1: erster Energiespeicher;
- C2: zweiter Energiespeicher;
- C3: dritter Energiespeicher;
- C(n-1): (n-1)-ter Energiespeicher;
- Cn: n-ter Energiespeicher;
- Cav: Kavität des Gehäuses Ge;
- CBP: Kondensator-Bondpad
- CBP1: erstes Kondensator-Bondpad CBP1 des ersten Energiespeichers C1;
- CBP2: zweites Kondensator-Bondpad CBP2 des zweiten Energiespeichers C2;
- CBP3: drittes Kondensator-Bondpad CBP3 des dritten Energiespeichers C3;
- CBP(n-1): (n-1)-tes Kondensator-Bondpad CBP(n-1) des (n-1)-ten Energiespeichers C(n-1);
- CBPn: n-tes Kondensator-Bondpad CBPn des n-ten Energiespeichers Cn;
- Cs1: erste Stützkapazität des ersten Treibers DRC1;
- Cs2: zweite Stützkapazität des zweiten Treibers DRC2;
- CS_N: Chip-Select der SPI-Schnittstelle;
- Csr: r-te Stützkapazität des r-ten Treibers DRCr;
- C_{L}: erstes gemeinsames Energiespeichersubstrat;
- C_{R}: zweites gemeinsames Energiespeichersubstrat;
- Dis: Entladesternpunkt;
- DRC: Treiberteil, der Teil des Entladeschalters Tdis ist;
- DRC1: erster Treiberteil, der Teil des Entladeschalters Tdis ist;
- DRC2: zweiter Treiberteil, der Teil des Entladeschalters Tdis ist;
- DRC3: dritter Treiberteil, der Teil des Entladeschalters Tdis ist;
- DRC4: vierter Treiberteil, der Teil des Entladeschalters Tdis ist;
- DRC5: fünfter Treiberteil, der Teil des Entladeschalters Tdis ist;
- DRC6: sechster Treiberteil, der Teil des Entladeschalters Tdis ist;
- DRC7: siebter Treiberteil, der Teil des Entladeschalters Tdis ist;
- DRC8: achter Treiberteil, der Teil des Entladeschalters Tdis ist;
- DRC[r-7]: [r-7]-ter Treiberteil, der Teil des Entladeschalters Tdis ist;
- DRC[r-6]: [r-6]-ter Treiberteil, der Teil des Entladeschalters Tdis ist;
- DRC[r-5]: [r-5]-ter Treiberteil, der Teil des Entladeschalters Tdis ist;
- DRC[r-4]: [r-4]-ter Treiberteil, der Teil des Entladeschalters Tdis ist;
- DRC[r-3]: [r-3]-ter Treiberteil, der Teil des Entladeschalters Tdis ist;
- DRC[r-2]: [r-2]-ter Treiberteil, der Teil des Entladeschalters Tdis ist;
- DRC[r-1]: [r-1]-ter Treiberteil, der Teil des Entladeschalters Tdis ist;
- DRCr: r-ter Treiberteil, der Teil des Entladeschalters Tdis ist;
- DRP: Bondpad-Anschluss des Treiberteils DRC, der Teil des Entladeschalters Tdis ist;
- DRP1: erster Bondpad-Anschluss des ersten Treiberteils DRC1, der Teil des Entladeschalters Tdis ist;
- DRP2: zweiter Bondpad-Anschluss des zweiten Treiberteils DRC2, der Teil des Entladeschalters Tdis ist;
- DRP3: dritter Bondpad-Anschluss des dritten Treiberteils DRC3, der Teil des Entladeschalters Tdis ist;
- DRP4: vierter Bondpad-Anschluss des vierten Treiberteils DRC4, der Teil des Entladeschalters Tdis ist;
- DRP5: fünfter Bondpad-Anschluss des fünften Treiberteils DRC5, der Teil des Entladeschalters Tdis ist;
- DRP6: sechster Bondpad-Anschluss des sechsten Treiberteils DRC6, der Teil des Entladeschalters Tdis ist;
- DRP7: siebter Bondpad-Anschluss des siebten Treiberteils DRC7, der Teil des Entladeschalters Tdis ist;
- DRP8: achter Bondpad-Anschluss des achten Treiberteils DRC8, der Teil des Entladeschalters Tdis ist;
- DRP[r-7]: [r-7]-ter Bondpad-Anschluss des [r-7]-ten Treiberteils DRC[r-7], der Teil des Entladeschalters Tdis ist;
- DRP[r-6]: [r-6]-ter Bondpad-Anschluss des [r-6]-ten Treiberteils DRC[r-6], der Teil des Entladeschalters Tdis ist;
- DRP[r-5]: [r-5]-ter Bondpad-Anschluss des [r-5]-ten Treiberteils DRC[r-5], der Teil des Entladeschalters Tdis ist;
- DRP[r-4]: [r-4]-ter Bondpad-Anschluss des [r-4]-ten Treiberteils DRC[r-4], der Teil des Entladeschalters Tdis ist;
- DRP[r-3]: [r-3]-ter Bondpad-Anschluss des [r-3]-ten Treiberteils DRC[r-3], der Teil des Entladeschalters Tdis ist;
- DRP[r-2]: [r-2]-ter Bondpad-Anschluss des [r-2]-ten Treiberteils DRC[r-2], der Teil des Entladeschalters Tdis ist;
- DRP[r-1]: [r-1]-ter Bondpad-Anschluss des [r-1]-ten Treiberteils DRC[r-1], der Teil des Entladeschalters Tdis ist;
- DRPr: r-ter Bondpad-Anschluss des r-ten Treiberteils DRCr, der Teil des Entladeschalters Tdis ist;
- DRV1: erster Gate-Treiber für den ersten Teiltransistor Tdis1 des ersten Teiltreibers DRC1;
- DRV2: zweiter Gate-Treiber für den zweiten Teiltransistor Tdis2 des zweiten Teiltreibers DRC2;
- DRVr: r-ter Gate-Treiber für den r-ten Teiltransistor Tdisr des r-ten Teiltreibers DRCr;
- FG1: erste funktionale Gruppe der erfindungsgemäßen Vorrichtung VGV;
- FG2: zweite funktionale Gruppe der erfindungsgemäßen Vorrichtung VGV;
- FG3: dritte funktionale Gruppe der erfindungsgemäßen Vorrichtung VGV;
- FG4: vierte funktionale Gruppe der erfindungsgemäßen Vorrichtung VGV;
- FG5: fünfte funktionale Gruppe der erfindungsgemäßen Vorrichtung VGV;
- FG6: sechste funktionale Gruppe der erfindungsgemäßen Vorrichtung VGV;
- FG(n-1): (n-1)-te funktionale Gruppe der erfindungsgemäßen Vorrichtung VGV;
- FGn: n-te funktionale Gruppe der erfindungsgemäßen Vorrichtung VGV;
- GATE: Steuersignal aller r Gate-Treiber DRV1 bis DRVr;
- GATE_IN_1: Steuersignal der Steuervorrichtung zum Schließen oder Öffnen des Entladeschalters Tdis.
- GATE_IN_2: verstärktes Steuersignal der Steuervorrichtung zum Schleißen oder öffnen des Entladeschalters Tdis.
- Ge: Gehäuse;
- GND: Bezugspotenzialleitung auf Bezugspotenzial;
- GNDA: Anschluss der Treiberschaltung IC für die analoge Masseleitung;
- GNDD: Anschluss der Treiberschaltung IC für die digitale Masseleitung;
- GNDH: Anschluss der Treiberschaltung IC für die Bezugspotenzialleitung GND;
- GNDP: Anschlüsse für die Bezugspotenzialleitung;
- IC: Treiberschaltung;
- ICBP1: erster Bondpadanschluss des ersten Ladeschalters S1 der ersten funktionalen Gruppe FG1 der Treiberschaltung IC, die Teil der erfindungsgemäßen Vorrichtung VGV ist;
- ICBP2: zweiter Bondpadanschluss des zweiten Ladeschalters S2 der zweiten funktionalen Gruppe FG2 der erfindungsgemäßen Vorrichtung VGV und der Treiberschaltung IC, die Teil der erfindungsgemäßen Vorrichtung VGV ist;
- ICBP(n-1): (n-1)-ter Bondpadanschluss des (n-1)-ten Ladeschalters S(n-1) der (n-1)-ten funktionalen Gruppe FG(n-1) der Treiberschaltung IC, die Teil der erfindungsgemäßen Vorrichtung VGV ist;
- ICBPn: n-ter Bondpadanschluss des n-ten Ladeschalters Sn der n-ten funktionalen Gruppe FGn der Treiberschaltung IC, die Teil der erfindungsgemäßen Vorrichtung VGV ist;
- K1: erster Zwischenknoten;
- K2: zweiter Zwischenknoten;
- K3: dritter Zwischenknoten;
- K(n-1): (n-1)-ter Zwischenknoten;
- Kn: n-ter Zwischenknoten;
- L1: erster VCSEL-Laser mit mehreren parallel geschalteten VCSEL-Laserdioden;
- L2: zweiter VCSEL-Laser mit mehreren parallel geschalteten VCSEL-Laserdioden;
- L3: dritter VCSEL-Laser mit mehreren parallel geschalteten VCSEL-Laserdioden;
- L4: vierter VCSEL-Laser mit mehreren parallel geschalteten VCSEL-Laserdioden;
- L5: fünfter VCSEL-Laser mit mehreren parallel geschalteten VCSEL-Laserdioden;
- L6: sechster VCSEL-Laser mit mehreren parallel geschalteten VCSEL-Laserdioden;
- L(n-1): (n-1)-ter VCSEL-Laser mit mehreren parallel geschalteten VCSEL-Laserdioden;
- Ln: n-ter VCSEL-Laser mit mehreren parallel geschalteten VCSEL-Laserdioden;
- Lp1: erste parasitäre Induktivität der ersten Bondverbindung BD1 zwischen dem ersten VCSEL-Bondpad VBP1 und dem ersten Kondensator-Bondpad CBP1 des ersten Energiespeichers C1, der typischerweise ein erster Kondensator ist;
- Lp2: zweite parasitäre Induktivität der zweiten Bondverbindung BD2 zwischen dem zweiten VCSEL-Bondpad VBP2 und dem zweiten Kondensator-Bondpad CBP2 des zweiten Energiespeichers C2, der typischerweise ein zweiter Kondensator ist;
- Lp3: dritte parasitäre Induktivität der dritten Bondverbindung BD3 zwischen dem dritten VCSEL-Bondpad VBP3 und dem dritten Kondensator-Bondpad CBP3 des dritten Energiespeichers C3, der typischerweise ein dritter Kondensator ist;
- Lp(n-1): (n-1)-te parasitäre Induktivität der (n-1)-ten Bondverbindung BD(n-1) zwischen dem (n-1)-ten VCSEL-Bondpad VBP(n-1) und dem (n-1)-ten Kondensator-Bondpad CBP(n-1) des (n-1)-ten Energiespeichers C(n-1), der typischerweise ein n-ter Kondensator ist;
- Lpn: n-te parasitäre Induktivität der n-ten Bondverbindung BDn zwischen dem n-ten VCSEL-Bondpad VBPn und dem n-ten Kondensator-Bondpad CBPn des n-ten Energiespeichers Cn, der typischerweise ein n-ter Kondensator ist;
- MISO: Ausgang der SPI-Schnittstelle (Englisch: Master Input, Slave Output);
- MOSI: Eingang der SPI-Schnittstelle (Englisch: Master Output, Slave Input)
- NIRQ: Interrupt-Request-Ausgang;
- pc: Pitch der Energiespeicher C1 bis Cn;
- pc': Pitch der gedrehten Energiespeichergruppen der Energiespeicher C1 bis Cn;
- S1: erster Ladeschalter;
- S2: zweiter Ladeschalter;
- S3: dritter Ladeschalter;
- S(n-1): (n-1)-ter Ladeschalter;
- Sn: n-ter Ladeschalter;
- SCK: SPI Takt;
- Tdis Tdis1: Entladeschalter;
- bis Tdisr: Entladeteilschalter
- TRIGGER: externes Startsignal zur Erzeugung des GATE_IN_1-Signals;
- VBP: VCSEL-Bondpad;
- VBP1: erstes VCSEL-Bondpad des ersten VCSEL-Laser L1;
- VBP2: zweites VCSEL-Bondpad des zweiten VCSEL-Lasers L2;
- VBP3: drittes VCSEL-Bondpad des dritten VCSEL-Lasers L3;
- VBP(n-1): (n-1)-tes VCSEL-Bondpad des (n-1)-ten VCSEL-Lasers L(n-1);
- VBPn: n-tes VCSEL-Bondpad des n-ten VCSEL-Lasers Ln;
- VCSELA: Array der n VCSEL-Laser L1 bis Ln;
- VDD: Versorgungsspannungsleitung auf typischerweise positivem Versorgungspotenzial gegenüber dem Bezugspotenzial;
- VDDA: Anschluss der analogen Versorgungsspannung;
- VDDD: Anschluss der digitalen Versorgungsspannung;
- VDDH: Anschluss der Treiberschaltung IC für die Zuführung der Versorgungsspannung der Versorgungsspannungsleitung VDD;
- VDDP: Anschluss der digitalen Versorgungsspannung;
- VGV: Vorrichtung

## Patentansprüche

1. Modul zur Abgabe elektromagnetischer Strahlung, insbesondere Laserlichtmodul, mit
- einem VCSEL-Laser-Array-Die (VCSELA), das eine Vielzahl von streifenförmig und zueinander parallel verlaufenden VCSEL-Lasern (L1 bis Ln) mit jeweils in einer Reihe oder in mehreren parallelen Reihen angeordneten VCSEL-Laserdioden mit jeweils einer Anode und einer Kathode aufweist, wobei jede Reihe eine vorgegebene Breite quer zur Längserstreckung des VCSEL-Lasers (L1 bis Ln) aufweist,
- wobei jeder VCSEL-Laser (L1 bis Ln) an einem seiner in Längserstreckung seines Streifens liegenden Streifenenden eine Laser-Kontaktfläche (VBP1 bis VBPn) aufweist, mit denen die Anoden sämtlicher VCSEL-Laserdioden des betreffenden VCSEL-Lasers (L1 bis Ln) elektrisch verbunden sind, und
- wobei die Laser-Kontaktflächen (VBP1 bis VBPn) in Richtung der Aufeinanderfolge der VCSEL-Laser (L1 bis Ln) untereinander einen Mittenabstand aufweisen,
- einem ersten Energiespeichermodul (C_{L}) mit einer Vielzahl von in Richtung der Aufeinanderfolge der VCSEL-Laser (L1 bis Ln) des VCSEL-Laser-Array-Dies (VCSELA) nebeneinander angeordneten Kondensatoren (C1 bis Cn), die untereinander einen Mittenabstand aufweisen, der gleich dem Mittenabstand der Laser-Kontaktfläche (VBP1 bis VBPn) ist und
- Bonddrähten zur elektrischen Verbindung jeweils einer Laser-Kontaktfläche (VBP1 bis VBPn) und eines Kondensators (C1 bis Cn).

2. Modul nach Anspruch 1, **dadurch gekennzeichnet, dass** die Anzahl der Reihen von VCSEL-Laserdioden, die durch dieselbe Laser-Kontaktfläche (VBP1 bis VBPn) kontaktiert sind, definiert ist als der ganzzahlige Teil des Ergebnisses der Division aus dem Mittenabstand der Laser-Kontaktflächen (VBP1 bis VBPn) und der Breite einer Reihe von VCSEL-Laserdioden oder definiert ist als der ganzzahlige Teil des Ergebnisses der Division aus der in Richtung der Aufeinanderfolge der Laser-Kontaktflächen (VBP1 bis VBPn) betrachteten Erstreckung einer Laser-Kontaktfläche (VBP1 bis VBPn) und der Breite einer Reihe von VCSEL-Laserdioden.

3. Modul nach Anspruch 1 oder 2, **dadurch gekennzeichnet, dass** die Laser-Kontaktflächen (VBP1 bis VBPn) sämtlicher VCSEL-Laser (L1 bis Ln) nebeneinander und somit an dem gleichen Ende der Streifen der VCSEL-Laser (L1 bis Ln) liegen.

4. Modul nach Anspruch 3, **dadurch gekennzeichnet, dass** die Kondensatoren (C1 bis Cn) in einer Reihe liegend aufeinanderfolgen.

5. Modul nach Anspruch 3, **dadurch gekennzeichnet, dass** die Kondensatoren (C1 bis Cn) in zwei Reihen mit jeweils gleichen Mittenabständen angeordnet sind, wobei die Kondensatoren (C1 bis Cn) der einen Reihe um den halben Mittenabstand versetzt neben den Kondensatoren (C1 bis Cn) der anderen Reihe angeordnet sind, und dass die Mittenabstände der Kondensatoren gleich dem doppelten Mittenabstand der Laser-Kontaktflächen (VBP1 bis VBPn) ist.

6. Modul nach Anspruch 1 oder 2, **dadurch gekennzeichnet, dass** die Laser-Kontaktflächen (VBP1 bis VBPn) benachbarter VCSEL-Laser (L1 bis Ln) wechselweise einander gegenüberliegen und dass dem ersten Energiespeichermodul (C_{L}) gegenüberliegend ein zweites Energiespeichermodul (C_{R}) mit ebenfalls einer Vielzahl von Kondensatoren (C1 bis Cn) angeordnet ist, wobei sich das VCSEL-Laser-Array-Die (VCSELA) zwischen den beiden Energiespeichermodulen befindet.

7. Modul nach Anspruch 6, **dadurch gekennzeichnet, dass** die Kondensatoren (C1 bis Cn) beider Energiespeichermodule jeweils in einer Reihe aufeinanderfolgend angeordnet sind und dass der Mittenabstand der Kondensatoren (C1 bis Cn) gleich dem doppelten Mittenabstand der wechselweise aufeinanderfolgenden Laser-Kontaktflächen (VBP1 bis VBPn) ist.

8. Modul nach Anspruch 6, **dadurch gekennzeichnet, dass** die Kondensatoren (C1 bis Cn) beider Energiespeichermodule (C_{L}, C_{R}) jeweils in zwei Reihen mit gleichem Mittenabstand angeordnet sind, wobei die Kondensatoren (C1 bis Cn) der einen Reihe um den halben Mittenabstand versetzt neben den Kondensatoren (C1 bis Cn) der anderen Reihe angeordnet sind, und dass der Mittenabstand der Kondensatoren (C1 bis Cn) gleich dem Vierfachen des Mittenabstands der wechselweise aufeinanderfolgenden Laser-Kontaktflächen (VBP1 bis VBPn) ist.

9. Modul nach einem der Ansprüche 1 bis 8, **gekennzeichnet durch**
- einen IC-Die (IC) mit einer integrierten Schaltung zur Ansteuerung der VCSEL-Laser (L1 bis Ln) des VCSEL-Laser-Array-Dies (VCSELA) und zum Aufladen sowie Entladen der Kondensatoren (C1 bis Cn) des ersten Energiespeichermoduls (C_{L}),
- wobei das erste Energiespeichermodul (C_{L}) als ein Kondensator-Modul ausgebildet ist und
- wobei das VCSEL-Laser-Array-Die (VCSELA) und das Kondensator-Modul auf dem IC-Die (IC) angeordnet sind.

10. Modul nach Anspruch 9, **dadurch gekennzeichnet, dass** das IC-Die (IC) eine integrierte Entladestruktur (Tdis) aufweist, wobei das VCSEL-Laser-Array-Die (VCSELA) eine unterseitige Kathodenkontaktfläche aufweist, mit der die Kathoden der VCSEL-Laserdioden sämtlicher VCSEL-Laser (L1 bis Ln) elektrisch verbunden sind und die die Entladestruktur (Tdis) des IC-Dies (IC) elektrisch kontaktiert.

11. Modul nach Anspruch 9 oder 10, **dadurch gekennzeichnet, dass** bei Vorhandensein des zweiten Energiespeichermoduls (C_{R}) auch dieses auf dem IC-Die (IC) angeordnet ist.

12. Modul nach einem der Ansprüche 9 bis 11, **dadurch gekennzeichnet, dass** das IC-Die (IC) eine Ladeschaltung zum Aufladen der Kondensatoren des ersten Energiespeichermoduls (C_{L}) oder jedes Energiespeichermoduls (C_{L}, C_{R}) mit einem Verbindungsknoten zu dem ersten Energiespeichermodul (C_{L}) oder mit Verbindungsknoten zu jedem der Energiespeichermodule (C_{L}, C_{R}) aufweist, dass das erste Energiespeichermodul (C_{L}) oder jedes Energiespeichermodul (C_{L}, C_{R}) eine unterseitige, sämtlichen Kondensatoren (C1 bis Cn) des betreffenden Energiespeichermoduls (C_{L}, C_{R}) gemeinsame untere Kondensatorelektrode sowie einzelne voneinander getrennte obere Kondensatorelektroden aufweist und dass die unterseitige bzw. die unterseitigen gemeinsamen Kondensatorelektroden einen Knoten der Aufladeschaltung des IC-Dies (IC) kontaktiert bzw. kontaktieren.

13. Modul nach einem der Ansprüche 9 bis 12, **dadurch gekennzeichnet, dass** das IC-Die (IC) den Kondensatoren (C1 bis Cn) des ersten Energiespeichermoduls (C_{L}) oder jedes Energiespeichermoduls (C_{L}, C_{R}) zugeordnete Kontaktflächen aufweist, die mittels Bonddrähten elektrisch mit den oberen Elektroden der Kondensatoren (C1 bis Cn) des betreffenden Energiespeichermoduls (C_{L}, C_{R}) zugeordneten Kontaktflächen verbunden sind, und dass diese Kontaktflächen der Kondensatoren (C1 bis Cn) des betreffenden Energiespeichermoduls (C_{L}, C_{R}) ihrerseits mittels weiterer Bonddrähte mit den Laser-Kontaktflächen (VBP1 bis VBPn) der jeweiligen ihnen zugeordneten VCSEL-Laser (L1 bis Ln) des VCSEL-Laser-Array-Dies (VCSELA) verbunden sind.
